(19) Europäisches Patentamt
European Patent Office
Office européen des brevets

(11) EP 3 191 823 B1

(12) **EUROPEAN PATENT SPECIFICATION**

(45) Date of publication and mention of the grant of the patent:
**20.11.2019 Bulletin 2019/47**

(21) Application number: **15760442.2**

(22) Date of filing: **08.09.2015**

(51) Int Cl.:
***G01N 24/08** (2006.01)* ***G01R 33/46** (2006.01)*
***G01R 33/465** (2006.01)* ***G01R 33/28** (2006.01)*

(86) International application number:
**PCT/EP2015/070457**

(87) International publication number:
**WO 2016/038013 (17.03.2016 Gazette 2016/11)**

(54) **SABRE NMR ANALYSIS METHOD**

SABRE-NMR-ANALYSEVERFAHREN

PROCÉDÉ D'ANALYSE RMN SABRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.09.2014 NL 2013436**
**24.09.2014 EP 14186272**
**31.08.2015 NL 2015380**

(43) Date of publication of application:
**19.07.2017 Bulletin 2017/29**

(73) Proprietor: **Stichting Katholieke Universiteit Nijmegen**
**6525 EZ Nijmegen (NL)**

(72) Inventors:
- **RUTJES, Floris Petrus Johannes Theodorus**
**NL-6500 HC Nijmegen (NL)**
- **FEITERS, Martinus Christiaan**
**NL-6500 HC Nijmegen (NL)**
- **VAN WEERDENBURG, Bram Johannes Arnoldus**
**NL-6500 HC Nijmegen (NL)**
- **ESHUIS, Nan**
**NL-6500 HC Nijmegen (NL)**
- **HERMKENS, Niels Koen Jan**
**NL-6500 HC Nijmegen (NL)**
- **TESSARI, Marco**
**NL-6500 HC Nijmegen (NL)**

(74) Representative: **EDP Patent Attorneys B.V.**
**Bronland 12-E**
**6708 WH Wageningen (NL)**

(56) References cited:
- **WEVERS RON A ET AL: "1H-NMR spectroscopy of body fluids: Inborn errors of purine and pyrimidine metabolism", CLINICAL CHEMISTRY, vol. 45, no. 4, April 1999 (1999-04), pages 539-548, XP055227883, ISSN: 0009-9147**
- **NAN ESHUIS ET AL: "Toward Nanomolar Detection by NMR Through SABRE Hyperpolarization", JOURNAL OF THE AMERICAN CHEMICAL SOCIETY, vol. 136, no. 7, 29 January 2014 (2014-01-29), pages 2695-2698, XP055167860, ISSN: 0002-7863, DOI: 10.1021/ja412994k cited in the application**
- **SANTOSH KUMAR BHARTI ET AL: "Quantitative 1H NMR spectroscopy", TRAC TRENDS IN ANALYTICAL CHEMISTRY, vol. 35, 1 May 2012 (2012-05-01), pages 5-26, XP055167863, ISSN: 0165-9936, DOI: 10.1016/j.trac.2012.02.007**
- **MARCONE M F ET AL: "Diverse food-based applications of nuclear magnetic resonance (NMR) technology", FOOD RESEARCH INTERNATIONAL MAY 2013 ELSEVIER LTD GBR, vol. 51, no. 2, May 2013 (2013-05), pages 729-747, XP055227884, DOI: 10.1016/J.FOODRES.2012.12.046**
- **GLÖGGLER STEFAN ET AL: "Para-hydrogen perspectives in hyperpolarized NMR", JOURNAL OF MAGNETIC RESONANCE, vol. 235, 24 July 2013 (2013-07-24), pages 130-142, XP028713301, ISSN: 1090-7807, DOI: 10.1016/J.JMR.2013.07.010**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

FIELD OF THE INVENTION

The invention relates to a method for the detection with Signal Amplification By Reversible Exchange (SABRE) magnetic resonance.

BACKGROUND OF THE INVENTION

SABRE is a nuclear spin hyperpolarization technique based on the reversible association of a substrate molecule and parahydrogen ($p$-$H_2$ or *para*-$H_2$) to a metal complex. During the lifetime of such a complex, generally fractions of a second, the spin order of $p$-$H_2$ is transferred to the nuclear spins of the substrate molecule via a transient scalar coupling network, resulting in strongly enhanced NMR signals. This technique is generally applied at relatively high concentrations (mM), in large excess of substrate with respect to metal complex. Dilution of substrate ligands below stoichiometry results in progressive decrease of signal enhancement, which precludes the direct application of SABRE to the NMR analysis of low concentration (μM) solutions. SABRE NMR is known in the art and is e.g. described in US 20130267036A1 and Ralph W. Adams et al., Science, vol. 323, 27 March 2009, pages 1708-1711 etc.

However, the large signal enhancement obtained with SABRE has never been combined with quantitative NMR applications as the efficiency of SABRE can strongly vary between different substrates or even between nuclear spins in the same molecule. The last decade has witnessed a widespread interest in hyperpolarization methods as a tool to overcome the intrinsic low sensitivity of NMR spectroscopy. These include dynamic nuclear polarization (DNP), spin exchange optical pumping (SEOP), *para*-hydrogen induced polarization (PHIP), and, more recently, SABRE. However, the large signal increase resulting from nuclear spin hyperpolarization comes unavoidably with some costs: particularly, the assumption of a linear dependence of nuclear magnetization on concentration, as stated by Curie's Law for samples at thermal equilibrium, is no longer necessarily correct. As a consequence, quantification of analytes in solution from NMR spectra of hyperpolarized samples is generally not straightforward.

In the article "Towards Nanomolar Detection by NMR Through SABRE Hyperpolarization" (JACS 2014, vol. 36, pp 2695-2698) Eshuis et al. propose a method allowing NMR detection below 1 μM in a single scan. It is described that the efficiency of SABRE at low substrate concentrations can be restored by addition of a suitable coordinating ligand to the solution. The authors have found a linear dependence of the signal intensity on the concentration of a substrate in diluted mixtures containing that substrate, a solvent, a SABRE complex (precursor) and a co-substrate. The authors conclude that the results indicate that hyperpolarization does not *a priori* preclude quantitative NMR applications.

Mewis et al. (2014) "Probing signal amplification by reversible exchange using an NMR flow system" MRC vol. 52, pp 358-369, describe that hyperpolarization methods are used in NMR to overcome its inherent sensitivity problem. In the article, the biologically relevant target nicotinamide is polarized by the hyperpolarization technique signal amplification by reversible exchange. It is described how the polarization transfer field, and the concentrations of $p$-$H_2$, the polarization-transfer-catalyst and substrate can be used to maximize signal amplification by reversible exchange effectiveness by reference to the first-order spin system of this target. The catalyst is shown to be crucial in this process, first by facilitating the transfer of hyperpolarization from $p$-$H_2$ to nicotinamide and then by depleting the resulting polarized states through further interaction. The 15 longitudinal one, two, three and four spin order terms produced are rigorously identified and quantified using an automated flow apparatus in conjunction with NMR pulse sequences based on the only $p$-$H_2$ spectroscopy protocol. The rates of build-up of these terms were shown to follow the order four~three>two>single spin; this order parallels their rates of relaxation. The result of these competing effects is that the less-efficiently formed single-spin order terms dominate at the point of measurement with the two-spin terms having amplitudes that are an order of magnitude lower. They also complete further measurements to demonstrate that 13C NMR spectra can be readily collected where the long-lived quaternary 13C signals appear with significant intensity. These are improved upon using INEPT. In summary, the authors dissect the complexity of this method, highlighting its benefits to the NMR community and its applicability for high-sensitivity magnetic resonance imaging detection in the future.

In a review article, Bharti and Roy (2012) (Trends in Analytical Chemistry vol. 35, pp 5-26) illustrate the need to use nuclear magnetic resonance (NMR) spectroscopy for the quantitative analysis of small molecules in their crude forms and in mixtures. They describe the basic concepts of quantitative NMR (qNMR), a brief description of important acquisition and processing parameters responsible for obtaining high-quality, reproducible NMR spectra in order to maximize accuracy, and the latest referencing techniques used for quantitative analysis. They also describe methods that are used for quantitative analysis including calibration-curve and standard-addition methods. Further, they briefly address validation of qNMR spectroscopy and its major applications in various scientific disciplines.

In Clinical Chemistry 45 (4), pp 539-548, Wevers et al. describe that the diagnosis of inborn errors of purine and pyrimidine metabolism is often difficult. They have examined the potential of 1H-NMR as a tool in evaluation of patients with these disorders, and performed 1H-NMR spectroscopy on 500 and 600 MHz instruments with a standardized

sample volume of 500 μL. They further describe that some metabolites have no contributing proton in their chemical structure. Therefore they suggest to modify experimental conditions, e.g., the pH.

SUMMARY OF THE INVENTION

SABRE is an emerging nuclear spin hyperpolarization technique based on the reversible association of substrate molecules and *para*-hydrogen (*p*-$H_2$, or para-$H_2$) to a metal center. A transient scalar coupling network within this complex allows transfer of the spin-order from *p*-$H_2$ to the nuclear spins of the substrate molecules, resulting in strongly enhanced NMR signals. When both *p*-$H_2$ (bound *p*-$H_2$ in form of hydrides) and a substrate molecule are bound to, e.g. the iridium, the *J*-coupling between the *p*-$H_2$ derived hydrides and the substrate nuclei allow the transfer of spin order (i.e. polarization) of *p*-$H_2$ to the substrate, see Fig. 1. Polarization transfer may be provided at a low magnetic field or at a high magnetic field. At low magnetic field polarization transfer may occur rather spontaneously. At high magnetic field, especially inside an MR apparatus, polarization may be induced by providing a suitable radiofrequency-excitation scheme (see also further below). In Fig. 1 a schematic representation of SABRE applied to pyridine as substrate and [Ir(IMes)$(H)_2$$(py)_3$]Cl (**2**[Cl]) [IMes = 1,3-bis(2,4,6-trimethylphenyl)imidazole-2-ylidene; *py* = pyridine] as metal complex (herein also indicated as "catalyst" or as "SABRE catalyst") is shown (note that IMES refers to the entire ligand (heterocycle plus two MES substituents)). Metal complex **2**$^+$ is formed by a reaction of the complex precursor [Ir(COD)(IMes)Cl] (**1**) [COD = 1,5-cyclooctadiene] with *p*-$H_2$ and *py* (e.g. **2**$^+$ indicates **2** without counter ion; hence, **2**[Cl]) may also be indicated as **2**$^+$[Cl]$^-$ ). The star structures around H atoms indicate the hyperpolarization of such atoms (or protons).

The spontaneous transfer is substantially only possible when the *J*-coupling (around 1 Hz for the ortho protons of pyridine) match the chemical shift difference between the hydrides and these protons (typically -22 to 8 ppm = 18,000 Hz at the high magnetic field of a 600 MHz spectrometer). At low magnetic field (e.g. at several mT) the *J*-coupling substantially matches the chemical shift difference (in other words: a strong coupling regime is obtained) which allows transfer of polarization. This is the reason why *p*-$H_2$ may be dissolved (shaking) in a mixture in the fringe field of the NMR magnet, and then rapidly inserted for acquisition (see further also below). When polarization is provided at high magnetic field, such as in a high magnetic field in the spectrometer, *p*-$H_2$ may also be dissolved in the sample after inserting the sample in the spectrometer. Although hyperpolarization has proven effective in significantly lowering NMR detection limits, its application to quantitative NMR analysis has so far been rather modest. Yet, in a recent investigation on the feasibility of SABRE for dilute solutions, we have found that an excess of a so-called co-substrate allows the hyperpolarized signals of one diluted analyte to depend linearly on its concentration, an essential requirement for quantitative NMR applications. It is indeed possible to detect and quantify analytes at low μM concentration in complex mixtures using SABRE hyperpolarization in single scan NMR experiments. Here, we show that the efficiency of SABRE at low substrate concentrations can be restored by addition of a suitable coordinating ligand (herein also indicated as co-substrate) to the solution. The proposed method allowed NMR detection below 1 μM in a single scan. Herein the term "SABRE" (Signal Amplification By Reversible Exchange) may also be indicated by other terms, such "SABRE polarization", "Para-Hydrogen polarization", "Non-Hydrogenative PHIP" (Para-Hydrogen Induced Polarization) or "NH-PHIP".

The concentration ratio between the free and metal-bound form of the substrate is one of the main parameters that influences the efficiency of SABRE. Optimal SABRE hyperpolarization is obtained when the substrate is in (large, ≥ 10x) excess with respect to the metal complex, while the metal complex concentration (herein indicated as $C_m$ or $C_M$) is at least in the high micromolar range. Conversely, a progressive loss of hyperpolarization is observed at low substrate concentrations (i.e. $\leq C_M$), presumably due to the formation of unstable complexes in which the solvent serves as a ligand to the metal center. By adding a second ligand, the so-called "co-substrate", to the solution (with $C_{co\text{-}sub} >> C_M$), it is possible to restore hyperpolarization and detect substrates at sub micromolar concentration (Fig. 2). Furthermore, as long as the conditions $C_{sub} << C_M < C_{co\text{-}sub}$ hold, the concentration ratio between the free and metal-bound form of substrate is constant, irrespective of its concentration. As a result, a linear dependence of hyperpolarized signal integral on substrate concentration is observed. SABRE results from the combined effect of different processes: polarization transfer via scalar couplings, metal complex dissociation and longitudinal relaxation. These processes are sketched in Fig. 1.

Long lifetimes of the metal complex may not be favorable because of the much faster longitudinal relaxation of the substrate in the metal-bound form ($R_1^{py\text{-}b}$ ~ 10-20 $R_1^{py\text{-}f}$) and the inefficient transfer of hyperpolarized substrate molecules to the solution. On the other hand, SABRE efficiency of fast exchanging complexes is limited by a reduced contact time within the transient scalar coupling network. Therefore, an optimal dissociation rate ($k_{off}^{py}$) of the mediating complex appears to exist, depending on the polarization transfer rate and on the longitudinal relaxation rates ($R_1^{py\text{-}b}$, $R_1^{py\text{-}f}$). Up to now, **2**$^+$ was found to be the most efficient mediating complex for *py,* with a *py* dissociation rate constant ($k_{off}^{py}$) of ca. 10 $s^{-1}$. For the (pulse-based) transfer at high magnetic field the substrate exchange rate ideally is as slow as possible, because the bound form of the substrate is of interest and the complex has to stay intact during the polarization transfer. However, *p*-$H_2$ exchange has to be sufficiently fast to refresh the hydrides on a time scale that is shorter than

the relaxation of the hydride spin order (~1 $s^{-1}$). As substrate and $p$-$H_2$ dissociation are connected, there is an optimal temperature at which the exchange processes result in an optimal substrate signal enhancement. Especially e.g. for a complex comprising IMes and the co-substrate *mtz* the temperature is selected in the range 20-45 °C, such as especially 25-40 °C, even more especially in the range 25-35 °C. Especially for other catalyst/co-sub combinations the optimal temperature may be in a different range. Especially then a maximum substrate proton signal integral may be obtained. Further, with control of the temperature (in this range) the lifetime of the complex may be controlled and the sensitivity of the experiment can be maximized.

So far, optimization of metal complexes, pre-polarization field strength and substrate-to-complex precursor ratio have been major concerns in SABRE research in an attempt to maximize nuclear spin hyperpolarization. These studies, however, have mostly been performed at concentrations in the millimolar range and in large excess (usually ≥ 10:1 concentration ratio) of substrate (i.e. "analyte", especially "substrate" and "analyte" may be used interchangeable herein) with respect to the complex precursor. In an attempt to perform SABRE experiments on dilute solutions, we have found that at sub-millimolar concentrations of substrate and complex precursor, hyperpolarization is strongly attenuated and eventually disappears at low micromolar concentrations. This is illustrated in Table 1 for a series of samples at constant (12.5:1) *py*-to-**1** concentration ratio, dissolved in methanol in the presence of $p$-$H_2$ (4 bar, 51% enrichment):

**Table 1.** Signal enhancement following SABRE hyperpolarization in the stray field of an NMR apparatus for ortho protons of *py* and percentage of free *py* as function of *py* concentration. Note that in methanol the enhancement factors are reduced by ca. 50% compared to methanol-$d_4$ due to less favorable relaxation times.

| [*py*] (μM) | signal enhancement | free *py* |
|---|---|---|
| 25 | 0.7 | 98% |
| 50 | 2.1 | 97% |
| 100 | 3.0 | 91% |
| 250 | 4.1 | 85% |
| 1000 | 5.8 | 81% |
| 2500 | 26.5 | 79% |
| 5000 | 42.0 | 78% |
| 10000 | 45.7 | 76% |

This table 1 reflects the data on signals for ortho protons of free *py* at thermal equilibrium (reference data) or following SABRE hyperpolarization as a function of *py* concentration (indicated). In all samples a concentration ratio of 12.5:1 of *py* with respect to complex precursor was used. The observed increase in free *py* in solution indicates dissociation of complex **2**$^+$, for which a dissociation constant of 1.7 (concentrations expressed in mM) was estimated. Because of its short lifetime, all attempts to characterize the complex resulting from this dissociation process have been unsuccessful. Presumably, as a result of the dissociation one or more *py* ligands are replaced by solvent molecules (MeOH):

$$[Ir(IMes)(H)_2(py)_3]Cl + MeOH \rightleftarrows [Ir(IMes)(H)_2(py)_2MeOH]Cl + py$$

**2**[Cl] **3**[Cl]

$$[Ir(IMes)(H)_2(py)_2MeOH]Cl + MeOH \rightleftarrows [Ir(IMes)(H)_2(py)(MeOH)_2]Cl + py$$

**3**[Cl] **3'**[Cl]

(equations 1 and 2, respectively)

It should be mentioned that DFT calculations also indicate the possibility of other stable complexes, e.g. $[Ir(IMes)(H)_2(py)_2]Cl$, following the loss of a *py* ligand from complex **2**$^+$. Nevertheless, here it will be assumed that the structure of complex **3**$^+$ is obtained by replacing a *py* ligand with a methanol molecule, although the exact nature of **3**$^+$ is not relevant for the following discussion (see also Fig. 10 for possible relevant metal complexes formed upon hydrogenation of the cyclooctadiene ligand of complex precursor **1**).

Not surprisingly, the dissociation process described above has a strong impact on the hyperpolarization by SABRE. This is evidenced by the data in Table 1. At concentrations close to 25 μM all *py* is virtually free in solution and no SABRE effect is observable. The rapid decrease of SABRE hyperpolarization between 2.5 mM and 1 mM is concomitant with the dissociation of mediating complex **2**$^+$. Note that in this concentration range, almost 20% *of py* in solution is still bound to the metal center. The drop in SABRE efficiency suggests therefore that metal center **3**$^+$ resulting from the dissociation of complex **2**$^+$ is not effective in polarizing the nuclear spins of bound *py*. This is probably related to its short lifetime, as indicated by the line width of the proton NMR signals (not shown).

Loss of SABRE hyperpolarization was also observed at higher (mM) concentrations, for *py*-to-**1** concentration ratios (i.e. concentration ratio of *py* to metal complex) below stoichiometry (3:1). This is summarized in Table 2, where the SABRE enhancement factor is provided as a function of *py* concentration for a series of samples containing 2 mM **1** dissolved in methanol-$d_4$ together with p-$H_2$ (4 bar, 51% enrichment). At large excess of *py* (*py*-to-**1** ratio (or herein also indicated as *py* : **1** ratio) of 9:1) the signal enhancement factor for the ortho protons of free *py* is 101 (0.48% polarization). As the ratio is lowered, a progressive decrease in signal enhancement is observed. Again, this negative trend follows the decrease in concentration of mediating complex **2**$^+$ and the concomitant formation of metal complex **3**$^+$ that is ineffective in polarizing the nuclear spins of *py,* as noted above. Complete loss of hyperpolarization is observed below the stoichiometric ratio, due to the disappearance of the active complex **2**$^+$.

The reported behavior at low substrate-to-complex precursor ratios appears to be general, as we have observed the formation of such SABRE-inactive complexes parallel to hyperpolarization loss for all substrates and complex precursors tested so far.

**Table 2.** Signal integrals for IMes protons in complex **2**$^+$ (gradually rising) and complex **3**$^+$ (having a maximum value at *py*-to-1 ratio ~3), and signal enhancements for the ortho protons of free *py,* as a function of *py*-to-1 ratio. The SABRE enhancements are determined with respect to NMR signals measured at thermal equilibrium at 600 MHz after hyperpolarization at a magnetic field strength between 8 and 13 mT.

| *py* : **1** ratio | complex **2**$^+$ (a.u.) | complex **3**$^+$ (a.u.) | signal enhancement |
|---|---|---|---|
| 0.9 | 4 | 90 | 0 |
| 1.6 | 43 | 254 | 0 |
| 2.2 | 119 | 377 | 0 |
| 2.8 | 221 | 399 | 4.5 |
| 3.4 | 330 | 323 | 7.7 |
| 4.0 | 474 | 254 | 33.3 |
| 5.8 | 593 | 114 | 67.8 |
| 6.7 | 657 | 80 | 81.3 |
| 8.7 | 720 | 37 | 100.6 |
| 11.5 | 745 | 14 | 90.7 |

These results indicate that formation of inactive complex **3**$^+$ must be prevented in order to obtain SABRE hyperpolarization. The approach we present here shows that this can be achieved even at low substrate concentration, provided a second ligand, referred to as *co-substrate,* is added to the solution. The co-substrate should especially fulfill one or more, especially all of, the following requirements: (a) it especially should bind to the metal complex with much higher affinity than the solvent. Especially such that no solvent binding occurs while the co-substrate concentration is in the order of high micromolar to high millimolar. Its binding affinity, however, should especially be lower or comparable to the affinity of the substrate under investigation, such that substrate binding occurs, especially >5% of the substrate has to be bound to the metal complex; (b) it should especially be present in excess with respect to the concentration of the complex precursor, at least 3-fold; (c) the complex formed, such as the asymmetric complex [Ir(IMes)$(H)_2$(co-substrate)$_2$(substrate)]Cl (**4**[Cl]), should especially display a lifetime that is favorable. For low field hyperpolarization this may especially depend on the longitudinal relaxation rates of the substrate, and the rate of polarization transfer. Experimentally, the optimal pyridine exchange rate appears to be around 10 $s^{-1}$, but rates between 0.1 and 100 $s^{-1}$ are possible. For high field hyperpolarization, the complex lifetime should especially be comparable or longer than the time between the first selective 90° pulse and the end of the acquisition, which is approximately 0.5 second for pyridine-like substrates. However, the hydride exchange rate should be comparable or faster than the relaxation rate of the hydride spin order (approximately 1 $s^{-1}$). Especially, the lifetime that is favorable for low field hyperpolarization may be substantially different

from the lifetime favorable for the high field hyperpolarization method; (d) its $^1$H signals should especially not substantially overlap with the resonances of the substrate of interest. Especially, the co-substrate signals should not overlap with substrate signals applying low magnetic field *para*-$H_2$. Especially, the co-substrate signals should also not overlap with substrate signals applying high magnetic field *para*-$H_2$. However in the spectra obtained with the high field hyperpolarization this is far less likely to be a problem due to the dispersion of the hydride signals. This generally allows selective excitation of hydrides that are trans with respect to the substrate molecule, thereby excluding polarization transfer to the co-substrate protons (that are cis with respect to this hydride) resulting in 1D or 2D spectra without co-substrate signals. Especially when a triazole-like co-substrate is used in combination with pyridine-like molecules a nice separation of co-substrate and substrate hydrides is observed.

If the concentrations of substrate (*sub*), co-substrate (*co-sub*) and complex precursor (*metal*) satisfy the condition [*sub*] << [*metal*] < [*co-sub*], the distribution of substrate between free and bound forms is determined by the chemical equilibrium:

$$[\mathrm{Ir(IMes)(H)_2(sub)(co\text{-}sub)_2}]\mathrm{Cl} + \mathrm{co\text{-}sub} \underset{}{\overset{K_{eq}}{\rightleftarrows}} [\mathrm{Ir(IMes)(H)_2(co\text{-}sub)_3}]\mathrm{Cl} + \mathrm{sub} \quad (3)$$

from which Equation 4 can be derived:

$$\frac{[sub]_{free}}{[sub]_{bound}} = 3\times K_{eq}\frac{[co\text{-}sub]_{free}}{[co\text{-}sub]_{bound}} \approx 3\times K_{eq}\frac{C_{co-sub}-3\times C_{metal}}{3\times C_{metal}} \quad (4)$$

Here, $K_{eq}$ indicates the relative affinity of substrate and co-substrate for the metal center. The symbols $C_{co\text{-}sub}$ and $C_{metal}$ denote the analytical concentrations in solution of co-substrate and complex precursor, respectively. The numerical factor 3 in Equation 4 derives from the number of co-substrate molecules bound to the metal center. Equation 4 indicates that the distribution between the free and bound forms of a dilute substrate is independent on its total concentration and is essentially determined by the amount of co-substrate and complex precursor present in solution.

It was found that e.g. 1-methyl-1,2,3-triazole *(mtz)* satisfies the requirements (a)-(d) above and therefore can be used as a co-substrate for several substrates that are suitable for SABRE. The binding affinity of *mtz* for the metal center is sufficiently high to prevent solvent binding at an *mtz*-to-**1** ratio of at least 5:1, for millimolar complex precursor concentrations. Furthermore, the value of $K_{eq}$ in the case of *py* as (dilute) substrate and *mtz* as co-substrate is approximately 0.09; this corresponds to a fraction of bound *py* up to 80% (*mtz*-to-**1** ratio of 5:1). As previously mentioned, the fraction of bound py can be reduced by increasing the total concentration of *mtz* (see Equation 4). Other suitable co-substrates are mentioned below.

The effect of co-substrate (*mtz*) addition is shown in Table 3 for a series of samples containing 2 mM **1** dissolved in methanol-$d_4$ together with *p*-$H_2$ (4 bar, 51% enrichment) and a fixed *py*-to-**1** ratio of 2:1 (see also Fig. 10 for possible reactions and products). At this *py*-to-**1** ratio most of the bound *py* is found in the inactive **3**$^+$ complex and no hyperpolarization is observed. However, by titrating *mtz* to the solution, a progressive intensity decrease for signals from metal complex **3**$^+$ is observed, while new signals for the complexes **4**$^+$ ($[\mathrm{Ir(IMes)(H)_2(co\text{-}substrate)_2(substrate)}]^+$) and **5**$^+$ ($[\mathrm{Ir(IMes)(H)_2(co\text{-}substrate)\text{-}(substrate)_2}]^+$) appear in the $^1$H NMR spectrum. Concomitantly, restoration *of py* hyperpolarization is observed in the SABRE spectrum, as shown in Table 3. A maximal signal enhancement factor of 87 (0.42% polarization) on the ortho protons of free *py* was found, which is comparable to what is shown in Table 2. However, the dissociation of mediating complexes **4**$^+$ and **5**$^+$ is a much slower process than for **2**$^+$, as reflected in the low free-to-bound *py* ratio (60% bound *py*, from Table 2) for which maximum signal enhancement is observed. Note that the free-to-bound ratio of *py* in this series is not correctly described by Equation 4 since the complex precursor is not present in large excess (*py*:**1** = 2:1). In Table 3, the signals of ortho protons of free *py* at thermal equilibrium and the corresponding enhancements at different *mtz*-to-**1** ratio are shown:

**Table 3.** Signal integrals and SABRE enhancement factors for the ortho protons of *py* as a function of *mtz*-to-**1** ratio (*py*:**1** = 2:1). All signals are normalized with respect to the cumulative ortho *py* integral: free *py* (continuously rising), complex $\mathbf{3}^+$ (starting at about 0.56 and declining to almost 0 at *mtz*-to-**1** ratio of 1.2), complex $\mathbf{2}^+$ (starting at about 0.18 and declining to almost 0 at *mtz*-to-**1** ratio of 1.2), combined co-substrate complexes $\mathbf{4}^+$ and $\mathbf{5}^+$ (maximum of ~0.8 at *mtz*-to-**1** ratio of 1.2).

| *mtz* : **1** ratio | free *py* | complex $\mathbf{2}^+$ | complex $\mathbf{3}^+$ | complex $\mathbf{4}^+$ + $\mathbf{5}^+$ | *py* enhancement |
|---|---|---|---|---|---|
| 0.0 | 14% | 18% | 56% | 4% | 0.0 |
| 0.2 | 15% | 16% | 42% | 18% | 0.7 |
| 0.4 | 16% | 13% | 32% | 33% | 0.9 |
| 0.6 | 16% | 10% | 21% | 48% | 8.1 |
| 0.8 | 15% | 6% | 16% | 60% | 9.1 |
| 1.2 | 19% | 1% | 0% | 79% | 48.5 |
| 2.0 | 41% | 0% | 1% | 59% | 87.2 |
| 2.8 | 54% | 0% | 0% | 45% | 80.7 |
| 3.7 | 65% | 0% | 0% | 35% | 51.7 |

As summarized in Table 3, addition of co-substrate allows preserving SABRE hyperpolarization by preventing the formation of inactive complex $\mathbf{3}^+$. We have tested the validity of this method by acquiring SABRE spectra on samples containing trace amounts of substrate. The detection of 2 μM *py* (S/N ratio = 8:1) was achieved with 2 mM complex precursor **1** and 13 mM co-substrate *mtz* (data not shown). In an attempt to further improve SABRE efficiency, we have employed a different mediating complex than the slow exchanging $\mathbf{4}^+$ ($k_{off}^{py}$ = 0.23 $s^{-1}$). For substrate concentrations down to 0.5 μM, complex precursor [Ir(SIMes)(COD)Cl] (SIMes = 1,3-bis(2,4,6-trimethylphenyl)imidazolin-2-ylidene) (**6**) was used (see Fig. 10). The *p*-$H_2$ and *py* exchange processes in co-substrate complex [Ir(SIMes)$(H)_2$(*mtz*)$_2$(*py*)]Cl (**7**[Cl]) were approximately three times faster than for $\mathbf{4}^+$. Accordingly, a ca. 3-fold increase in signal intensity was observed in the SABRE spectra obtained with $\mathbf{7}^+$.

The SABRE spectra of *py* at micromolar concentrations in samples containing 1 mM **6** dissolved in methanol-$d_4$ together with *p*-$H_2$ (4 bar, 51% enrichment) and 18 mM *mtz* as co-substrate are shown in Fig. 3A. The thermal equilibrium spectrum (top trace) was acquired with 512 scans for the 5 μM sample. The SABRE spectra (bottom traces) were acquired at concentrations between 0.5 and 5 μM with a single scan following SABRE hyperpolarization. By comparing the signal integrals at thermal equilibrium and after SABRE, an enhancement factor of 121 is obtained for the 5 μM *py* sample.

A detection limit lower than 1 μM can be estimated based on the series of SABRE spectra in Fig. 3A. The plot in Fig. 3B clearly shows a linear dependence of the signal intensity on *py* concentration. This stems from the fact that at such low concentrations the free-to-bound substrate ratio is essentially determined by the concentration of co-substrate and it is, therefore, constant for all the spectra of Fig. 3A (see Equation 4). This linear dependence suggests a possible use of the proposed approach for quantitative applications of SABRE at low substrate concentration. A further reduction down to ca. 100 nM should already be feasible in a single scan via the proposed co-substrate approach, by using an automated polarization setup (gain: 7×), and fully enriched *p*-$H_2$ (gain: 3×).

The approach here presented to extend SABRE applicability is obviously not restricted to the model substrate *py*: comparable detection limits were found for other substrates using co-substrate complex $\mathbf{7}^+$.

Because of the linear behavior, low (unknown) substrate concentrations may be determined by means of standard-addition experiments. We applied SABRE to different types of complex mixtures (mixtures comprising a plurality of different organic molecules): (1) artificial mixtures of up to seventeen known metal ligands, (2) natural mixtures in the form of coffee extracts, and (3) urine samples, which are shortly discussed below and also further discussed in the experimental part. The artificial mixtures (1) consist of up to seventeen substrates that are known metal ligands. The total substrate content ($sub_T$) in these mixtures is in excess with respect to the metal complex. Because all substrates are ligands for the metal, their combined action is comparable to that of a co-substrate: the free-to-bound ratio of dilute analytes is constant as long as their analytical concentration ($C_x$) is well below that of the metal complex ($C_M$) and the substrate mixture ($C_x << C_M < sub_T$). Under these conditions a linear dependency of signal integral on analyte concentration holds. Since the total concentration of suitable metal ligands in coffee extracts (2) is not sufficient to prevent loss of hyperpolarization as a result of insufficient ligand association, we added a co-substrate to these mixtures. Using a fixed amount of metal complex (typically 1 mM) and co-substrate (typically 15 mM), hyperpolarization of several dilute

(low and sub micromolar) aromatic compounds is observed. The presence of an excess of co-substrate provides a linear dependency of the SABRE signals of these diluted compounds on their concentration. The urine samples (3) were hyperpolarized in the high field and a single co-substrate (*mtz*) was applied (in also mM concentration).

The linear dependence of signal integral on analyte concentration in complex mixtures obtained under the conditions described in the above, allows quantification by standard-addition. Signal enhancement factors up to 100x allow the detection quantification of analytes that are below the limit of detection in conventional NMR experiments.

Hence, in a first aspect the invention provides a method in accordance with claim 1 for the detection with Signal Amplification By Reversible Exchange (SABRE) magnetic resonance of an analyte at an unknown concentration $C_{sub}$ in a complex sample comprising a solvent, wherein the complex sample is further defined in the accompanying claims. The method comprises: (a) providing a series of mixtures M1, M2, ..., Mn, wherein each mixture comprises a predefined part of the complex sample comprising the analyte, a SABRE catalyst at a concentration $C_m$, and a co-substrate at a concentration $C_{co\text{-}sub}$, wherein $C_{sub} << C_m < C_{co\text{-}sub}$; and wherein two or more of the mixtures are provided with a known concentration of added analyte for standard addition determination of the unknown concentration of said analyte; and (b) applying *para* $H_2$ to the (respective) mixtures inside an MR apparatus at a magnetic field flux density in the range of 1-50 T, and measuring (respectively) with nuclear magnetic resonance (herein also indicated as "magnetic resonance") the magnetic resonance response of the mixtures; and determining (such as calculating) from the magnetic resonance response of the series of mixtures the unknown concentration $C_{sub}$ of the analyte, and is further defined in the in the accompanying claims.

This method allows detection at extremely low concentrations, such as even below 1 μM, such as even analytes in nanomolar concentrations. Here, the term "co-substrate" may also refer to a plurality of different co-substrates. Likewise, the term "SABRE catalyst" may also refer to a plurality of different SABRE catalysts. Hence, especially based on the Signal Amplification By Reversible Exchange (SABRE) magnetic resonance technology the magnetic resonance response of the mixture(s) is measured. Especially, n is at least 3, such as more especially at least 4, such as at least 5, like in the range of 3-10, such as 5-10, and especially (only) one of the mixtures does not include added analyte. Applying hyperpolarizing *p*-$H_2$ (*para* $H_2$) especially refers to admixing *p*-$H_2$ to the mixture, especially within a magnetic field. Especially a *para*-$H_2$ mixing unit, such as a shaking unit for mixing (such as by shaking and/or a bubbling unit for bubbling $H_2$ in the sample) may be applied. According to the invention applying (hyperpolarizing) *p*-$H_2$ is provided inside an MR apparatus, especially inside a bore of the MR apparatus, especially at a high magnetic field strength or magnetic field flux density e.g. in the range of 1-50 T, such as 4-30 T, especially 10-24.0 T. Especially measuring with nuclear magnetic resonance the magnetic resonance response may comprise measuring with nuclear magnetic resonance the magnetic resonance response at a high magnetic field strength, especially at a magnetic field flux density e.g. in the range of 1-50 T, such as 4-30 T, especially 10-24 T. Proton resonance frequencies in the range of 100-1000 MHz, or even larger, may be applied for measuring with NMR the magnetic resonance of the mixtures.

Especially, the method may be used to generate a calibration curve for a specific analyte based on the NMR data (i.e. "nuclear magnetic resonance data" or herein also indicated as "magnetic resonance data").

In yet a further aspect, the invention provides a method in accordance with claim 12 for the detection with SABRE magnetic resonance of an analyte at an unknown concentration $C_{sub}$ in a complex sample, as further defined in the accompanying claims. The method comprises: providing a mixture comprising a predefined part of the complex sample comprising the analyte, a SABRE catalyst at a concentration $C_m$, and especially also a co-substrate at a concentration $C_{co\text{-}sub}$, wherein $C_{sub} << C_m < C_{co\text{-}sub}$, applying *p*-$H_2$ *(para* $H_2$), to the mixture and measuring with nuclear magnetic resonance the magnetic resonance response of the mixture, wherein *para*-$H_2$ is applied to the mixture inside an MR apparatus in a magnetic field at a magnetic field flux density in the range of 1-50 T, and determining from the magnetic resonance response and a calibration curve the unknown concentration of the analyte. As a calibration curve for a specific analyte may also be used for other complex samples, a once defined calibration curve may also be used for the (quantitative) analysis of the same analyte in another complex sample. Hence, for other complex samples it may not be necessary to use the standard addition method to quantify the amount, once the calibration curve is available. Of course, standard measurement conditions like magnetic field, etc., should especially be the same as was used for measuring the calibration curve. Further, also especially the same SABRE catalyst and especially also the same co-substrate should be used (especially also in the same concentrations). Especially also the same hyperpolarization, i.e. at low magnetic field strength or high magnetic field strength is applied. The other complex samples may e.g. comprise similar samples, such as biopts or bodily fluids of other humans, or extracts of same type of food products. Hence, especially such calibration curve is based on similar complex samples. Examples of similar complex samples are different coffees, biopts from the same piece of tissue of different humans, etc. Examples of bodily fluids are urine, blood, saliva, etc.. Especially, the complex sample comprises a biological sample, such as selected from the group consisting of human tissue, blood, urine, and saliva. In another further embodiment the complex sample comprises one or more materials selected from the group consisting of a fresh food material, a processed food material, a fresh feed material, and a processed feed material.

In an embodiment the method further comprise using specific conditions selected from (i) using the same

catalyst as used for the calibration curve, (ii) using the same co-substrate as used for the calibration curve, and (iii) applying *para*-$H_2$ similarly as applied for the calibration curve, especially by applying *para*-$H_2$ (hyperpolarization) either at low magnetic field or by applying *para*-$H_2$ (hyperpolarization) at high magnetic field.

The solvent used is especially a solvent suitable for SABRE measurements, such as a solvent comprising one or more of methanol, ethanol, chloroform, dimethyl sulfoxide (DMSO), and one or more of these solvents in deuterated variants. Further, the solvent may comprise a mixture of two or more solvents. Further the solvent may further comprise water, like e.g. methanol with water or ethanol with water. When water is applied, especially a deuterated variant is applied, such as especially $D_2O$.

Especially, the solvent is able to dissolve the catalyst precursor in reasonable concentration (e.g. >100 μM). Further, especially the solvent is able to dissolve a co-substrate in reasonable concentration (i.e. ~5 x [catalyst]: e.g. >500 μM). Yet further, especially the solvent is able to dissolve hydrogen. SABRE works better in pure methanol/ethanol compared to mixtures with $D_2O$, presumably due to the much higher solubility of hydrogen in these solvents (-10 times higher solubility than in water). Yet further, especially the solvent is able to dissolve the substrate(s) of interest, for trace analysis this will in general be low concentrations (below -10 μM). Yet especially, there should not be formation of non-/slowly disappearing bubbles or (excessive) foam after dissolving hydrogen in the solvent, by shaking or bubbling, since this might impede the recording of a decent spectrum. The latter is especially important in the high-field hyperpolarization method, since this method relies on multiple-scan experiments, and to obtain usefull 2D spectra, the acquisition of multiple scans should be highly reproducible. Further, if the solubility of the catalyst precursor is insufficient in a certain solvent (e.g. $D_2O$), this precursor might be dissolved in another solvent (e.g. methanol), and then activated by dissolving hydrogen. The activated complex can than be dried, after which it can be dissolved in $D_2O$ and hyperpolarization is possible.

In yet another aspect, an MR apparatus is described, especially an NMR apparatus, especially configured to measure proton NMR, wherein the NMR apparatus comprises an NMR detection unit and one or more of the following units: a mixing chamber for providing one or more of the above mixtures, a *p*-$H_2$ unit for generation and/or storage of *p*-$H_2$ and for providing *p*-$H_2$ to the sample, a probe (transport) system, such as a flow-probe system, for transporting a probe comprising the mixture between different positions within the apparatus, a unit for providing the co-substrate, a unit for providing one or more analytes in predetermined amounts to the one or more mixtures, a *para*-$H_2$ mixing unit, such as a shaking unit for mixing (such as by shaking and/or a bubbling unit for bubbling $H_2$ in the sample) one or more samples (mixtures) within the magnetic field, especially substantially parallel to the magnetic field (lines). Especially, the apparatus may (also) comprise a *p*-$H_2$ mixing unit for mixing the mixture, such as bubbling *p*-$H_2$ in the mixture within in the magnetic field inside (the bore of) the MR apparatus.

In yet another, more specific, aspect, a proton NMR apparatus is described, comprising: an NMR detection unit; a mixing chamber for providing one or more mixtures; a *p*-$H_2$ unit for providing *p*-$H_2$ to the sample (in the mixing chamber); (optionally) a probe system for transporting a probe comprising the mixture between different positions within the apparatus; optionally a unit for providing one or more analytes in predetermined amounts to the one or more mixtures; and a *para*-$H_2$ mixing unit, such as a shaking unit, for mixing (such as by shaking) one or more samples within a magnetic field. Such apparatus may easily provide the probes or samples for measurement in the MR apparatus, and may due to the presence of the automatic mixing unit, efficiently mix the *para*-$H_2$ with the sample or probe and lead to a reliable hyperpolarization of the analyte(s). The unit for providing one or more analytes in predetermined amounts to the one or more mixtures is especially useful for standard addition methods. This unit may herein also be indicated as analyte dosage system.

The mixing unit is especially configured to apply *para*-$H_2$ to the sample. This may e.g. be done by bubbling the *para*-$H_2$ through the sample. Optionally, also the sample may be shaken to facilitate mixing. Further, the mixing unit may comprise a magnetization unit with an adjustable magnetic field. This may be used to tune the magnetic field at the position(s) of the mixture within the mixing unit. Alternatively or additionally, also the magnetic field of the MR apparatus may be used by the mixing unit. The phrase "mixing unit for mixing one or more samples within a magnetic field" and similar phrases indicate that the sample and *para*-$H_2$ are mixed. Hence, the *para*-$H_2$ is (thoroughly) mixed with the sample (within a (adjustable) magnetic field) (to provide hyperpolarization). Of course, more than one mixture may be mixed at the same time within such unit, though in various embodiments as described here, such mixing may also be done consecutively (though still parallel a plurality of mixtures may be mixed at the same time in the mixing unit). Especially, the sample is comprised by the mixture.

The probe system or probe transport system is especially configured to transport the probe (comprising the mixture) between one or more of the MR detection unit, the *p*-$H_2$ unit, the mixing chamber, the (optional) unit for providing one or more analytes (to provide the added analyte to the mixture) and the *p*-$H_2$ mixing unit. Note that while different units are indicated with the different functionalities, two or more units may also be comprised by a single unit having the two or more different functionalities.

Herein, the invention is especially explained with respect to NMR, though optionally the invention may also be extended to MR in general. However, the invention is not limited to proton NMR; the invention may also be used for e.g.

carbon ($^{13}C$) and fluor ($^{19}F$) NMR. Hence, an NMR apparatus, especially configured to measure one or more of proton NMR, carbon NMR and fluor NMR may be applied. The invention is however, explained in relation to proton NMR.

BRIEF DESCRIPTION OF THE DRAWINGS

Embodiments of the invention will now be described, by way of example only, with reference to the accompanying schematic drawings in which corresponding reference symbols indicate corresponding parts, and in which:

**Fig. 1.** Schematic representation of spin order transfer from *p*-$H_2$ to pyridine at the metal complex **2**$^+$ and the resulting proton hyperpolarization *of py* both bound and free in solution (especially upper part of the graph);

**Fig. 2.** Co-substrate (CoS) approach restores hyperpolarization of diluted (sub micromolar) pyridine (PY or *py*). Solvent (as ligand) is indicated as SL. The cross in the middle molecule indicates loss of polarization transfer;

**Fig. 3. (A)** $^1H$ NMR signals acquired at 600 MHz, at thermal equilibrium (black) or following SABRE hyperpolarization (grey curves) at a magnetic field strength between 8 and 13 mT, of samples containing trace amounts of *py* together with **6** (1 mM), *mtz* (18 mM) and 4 bar *p*-$H_2$ in methanol-$d_4$. The displayed signals originate from the ortho protons *of py* in the free (8.54 ppm) and bound (8.67 ppm) form. **(B)** Plot displaying the signal-to-noise ratio (SNR) of the free *py* signals in (A) as a function of *py* concentration ($\mu$M);

**Fig. 4.** Formation of SABRE-active metal complexes **2** upon hydrogenation of the COD ligand of complex precursor **1** in the presence of N substrates, with total concentration $sub_T$, that reversibly associate to **2.** COD = 1,5-cyclooctadiene: a bidentate ligand of the planar complex precursor **1,** associated through its two double bonds. In the presence of $H_2$ it will hydrogenate in two steps, first to cyclooctene (still attached to the iridium), and finally cyclooctane (COA), which is not a ligand for the metal. Hydrogenation of COD results in the SABRE active, octahedral, metal complex **2;**

**Fig. 5.** Standard addition curve (bottom right) obtained by integration of hyperpolarized nicotinamide signal in an artificial mixture spiked with standard solutions of nicotinamide;

**Fig. 6.** $^1H$ NMR spectra acquired at 600 MHz, at thermal equilibrium (top) or after polarization transfer at 6.5 mT (bottom), of a sample containing 333 $\mu$M **1** together with a mixture of 17 substrates, each at ca. 400 $\mu$M concentration and 5 bar *p*-$H_2$ in methanol-$d_4$. Signal enhancement factors are determined for peaks indicated with different labels. In this example, no additional (surplus) co-substrate was added. This example is added for reference purposes; substrates and abbreviations used are pyridine (*py*), nicotine (*ni*), pyrazole (*pz*), isoxazole (*ix*), 1-methyl-1,2,3-triazole (*mtz*), pyrazine (*pn*), 1-methyladenine (*ad*), 2-aminopyridine (*ap*), quinoxaline (*qx*), quinazoline (qz), acetonitrile (*mecn*), quinine (*qi*), quinoline (*qu*) and dimethyl sulfoxide (*dmso*) 3-methylpyrazole (*mp*) and 3-fluoropyridine (*fp*);

**Fig. 7.** Superposition of hyperpolarized $^1H$ NMR spectra acquired at 600 MHz on a sample with nicotinamide as analyte ($C_x$ = 8.5 $\mu$M) in the presence of sixteen high micromolar substrates (**1** = 333 $\mu$M, $sub_T$ = 6.5 mM) (lowest, black trace). The spectra of samples after standard addition, with $C_{add}$ between 8 and 75 $\mu$M (other grey to light grey traces), show increasing *na* signals, while the signals of other substrates remain constant. See also Fig.11;

**Figs. 8A-D**. Standard-addition curves for proton resonances after hyperpolarization at 6.5 mT (see for annotations also Fig. 9) of *na* (A), *pn* (B), *ix* (C), and *qz* (D), with nominal substrate concentrations: 8.5 $\mu$M (*na*), 5 $\mu$M *(pn),* 8 $\mu$M *(ix),* and 10 $\mu$M (*qz*). Concentrations estimated by standard-addition are given together with their uncertainties derived by propagation of uncertainty. X-axis concentrations are in $\mu$M; the y-axis indicates the signal (s) in arbitrary units (a.u.). The injection needle indicates measurements wherein via the standard addition method a known amount of analyte is added. The indication "lf' indicates linear fit; Fig. 8D shows two lines for two different *qz* proton resonances (*qz*-a, *qz*-b);

**Fig. 9.** Structures of IMes, SIMes, pyridine (py), nicotine (*ni*), pyrazole (*pz*), isoxazole (*ix*), 1-methyl-1,2,3-triazole (*mtz*), pyrazine (*pn*), nicotinamide (*na*) and quinozaline (*qz*). Relevant protons are annotated;

**Fig. 10.** Reaction schemes of the formation of metal complexes **2**$^+$, **3**$^+$, **4**$^+$, **5**$^+$ and **7**$^+$ through the hydrogenation of complex precursors **1** (Ir(IMes)(COD)Cl) and **6** (Ir(SIMes)(COD)Cl) (COD=cyclooctadiene, COA=cyclooctane);

**Fig. 11.** Single scan $^1H$ NMR spectra of 1 mM *py* together with 2 mM **1,** 13 mM *mtz* and 4 bar *p*-$H_2$ in methanol-$d_4$, following SABRE hyperpolarization at a magnetic field strength between 8 and 13 mT (bottom line) and at thermal equilibrium (top line);

**Fig. 12 (A and B)** $^1H$ NMR reference spectra acquired 3 minutes after SABRE experiments for samples containing 2 mM **1** with 4 bar *p*-$H_2$ and increasing *py* concentrations in methanol-$d_4$ (grey scales). (**C**) $^1H$ 2D NOESY spectrum acquired with a mixing time of 500 ms for a sample containing 2 mM **1**, 6 mM *py*, and 4 bar *p*-$H_2$ in methanol-$d_4$;

**Fig. 13.** Experimentally measured (**A**) and simulated (**B**) $^1H$ NMR signals of c-IMes for samples containing 2 mM **1** together with 4 bar *p*-$H_2$ and increasing *py* concentrations (indicated) in methanol-$d_4$;

**Figs. 14 (A and B).** $^1H$ NMR reference spectra acquired 3 minutes after SABRE, for samples containing 2 mM **1**, 4 mM *py* and 4 bar *p*-$H_2$ together with increasing *mtz* concentrations in methanol-$d_4$ (grey scale);

**Fig. 15.** Single scan $^1H$ NMR spectra acquired at 600 MHz, at thermal equilibrium (black) or following SABRE hyperpolarization at a magnetic field strength between 8 and 13 mT (grey scale) of samples containing trace amounts

of; (**A**) *ni* together with **6** (1 mM), *mtz* (15 mM) and 4 bar *p*-$H_2$ in methanol-$d_4$, (**B**) *pz* together with **6** (1 mM), *mtz* (13 mM) and 4 bar *p*-$H_2$ in methanol-$d_4$, and (**C**) *ix* together with **6** (1 mM), *mtz* (10 mM) and 4 bar *p*-$H_2$ in methanol-$d_4$. **D-F** plots displaying the signal-to-noise ratio of free *ni-b* (**A**), *pz-b* (**B**), and *ix-a* (**C**) as a function of total substrate concentration;

**Fig. 16.** $^1$H NMR signals acquired at 600 MHz, at thermal equilibrium (black, top) or following SABRE hyperpolarization at 6.5 mT (grey, bottom) of a coffee extract containing metal complex IPr (1.2 mM), *mtz* (18 mM) and 5 bar *p*-$H_2$ in methanol-$d_4$.;

**Figs. 17 & 18.** Standard addition experiments for pyrazine (*pn*); **Figs. 19 & 20.** Standard addition experiments for 2-methylpyrazine (*mpn*); **Figs. 22 & 22.** Standard addition experiments for 2,6-dimethylpyrazine (*dmpn*);

**Figs. 23a-23c** Schematically depict in more detail procedures to make the samples;

**Fig. 24** Schematically depicts an embodiment of an MR apparatus that can be used for methods described herein;

**Fig. 25** (**A**) Concentrations of substrates in the original mixture. (**B**) Concentrations of substrates in the spiking samples;

**Fig. 26** (**A**) Formation of metal complexes **4⁺**, **8⁺** and **9⁺** through the hydrogenation of complex precursor **1** in the presence of an excess of *mtz* and trace amounts of a substrate (*sub* << 1 < mtz).(**B**) Diastereomeric **4⁺** complexes (*sub* = (-)-cotinine);

**Fig. 27** Schematically depicts an embodiment of the set-up (**A**) and sample cell (**B**) for applying *p*-$H_2$ inside the MR apparatus, wherein (a) *p*-$H_2$ supply cylinder; (b) variable pressure relief valve; (c) solenoid valves in the embodiment controlled via TTL-lines; (d) check valve; (e/f) tubing; (g/h) tube fittings; (i) bored-through connection; (j) thread; (k) sealing such as a silicon disc; (1) 5 mm quick pressure valve NMR tube, especially 7"; (m) area of detection;

**Fig. 28** 2D $^1$H-$^1$H correlation spectrum between enhanced hydrides and aromatic protons of a mixture of thirteen SABRE substrates with concentrations between 250 nM and 2 μM. The spectrum was recorded in 23 minutes at 25 °C in the presence of 2 mM metal complex, 30 mM *mtz,* 5 bar 51% enriched *p*-$H_2$. Specific substrates indicated are: quinazoline (350 nM) at the bottom left, methyl nicotinate (530 nM) at the top and pyridine (350 nM) at the (middle) right hand side. Arrows indicating the peaks concerned of the respective substrates;

**Fig. 29** Schematically depicts a pulse scheme used for the hyperpolarization transfer from the hydrides to the protons of the substrate at high magnetic field in the NMR apparatus. Shaped pulses are *eburp-1* for excitation and *reburp* for refocusing/inversion. The delay $\tau_{IS}$ must be tuned to an odd multiple of $1/(2\times J_{AX})$; the duration here employed (185 ms) allows for an efficient coherence transfer to the substrate protons in *ortho.* Bubbling *p*-$H_2$ in the sample (1 s) occurs under spectrometer control, at the beginning of each transient. Phase cycling is implemented as follows: $\phi_1$ = x,-x; $\phi_2$ = x,x,-x,-x; $\phi_3$= X,X,X,X,-X,-X,-X,-X; $\phi_{receiver}$ = x,-x,-x,x,-x,x,x,-x;

**Fig. 30 (A)** Schematically depicts the asymmetric $[Ir(IMes)(H)_2(mtz)_2(sub)]Cl$ complex for a pyridine-like substrate (*sub*) in the presence of a large excess of 1-methyl-1,2,3-triazole *(mtz)* as co-substrate. The gray arrows indicate the largest couplings between hydride and substrate. Note that only the trans-hydride ($H_A$) displays an appreciable scalar coupling interaction with the substrate. (**B**) Enhanced in-phase hydride signals acquired with 32 scans by bubbling 51% enriched *p*-$H_2$ through a sample (bubbling in the NMR bore using the sample cell given in Fig. 27B) containing 2 mM metal complex, 30 mM mtz, and thirteen SABRE substrates with concentrations between 250 nM and 2 μM. The spectrum was obtained at 500 MHz $^1$H resonance frequency, by selective excitation of $H_A$ followed by refocusing of the hydride-hydride coupling (T = 25 °C);

**Fig. 31** Standard addition curves (linear plots of the 2D signal integrals versus added substrate concentration) for 1.81 μM (-)-cotinine (**A**), 0.53 μM methyl nicotinate (**B**), 0.77 μM nicotinic acid (**C**), and 0.35 μM quinazoline (**D**). Concentrations estimated from the average of the abscissa intercepts are given in the lower right corner of each graph and are in good agreement with the nominal values, being 1.81 μM, 0.53 μM, 0.77 μM, and 0.35 μM respectively for (-)-cotinine, methyl nicotinate, nicotinic acid, and quinazoline. Experimental uncertainties were derived by error propagation. Constant integration limits were used to obtain the same level of truncation for all magnitude-mode peaks. Note that each (-)-cotinine proton results in two resonances when bound to the iridium due to formation of diastereomeric complexes;

**Fig. 32** Selective excitation in the hydride region of unspiked urine and urine spiked tot 12 μM of Nikethamide and its metabolite, the carrier frequency marked by the central line and the excitation bandwidth of the *eburp*-2 pulse with the rectangle; and

**Fig. 33** Depicts a comparison of spiked and unspiked urines for a concentration of nicotinamide, drug, and metabolite in the sample approximately 12 μM after SPE and is a typical spectrum of unspiked (light) and spiked (dark) urine extract, wherein *na* = Nicotinamide (endogenic), *nik* = Nikethamide, and *met* = metobolite.

The schematic drawings are not necessarily on scale.

***Sample preparation***

*Hyperpolarization outside the NMR apparatus at low magnetic field (no embodiment of the invention)*

Artificial mixtures: Amongst others, it is referred to Figs. 23a-23c and 24.

An artificial mixture 900 is prepared from standardized substrate solutions in methanol-$d_4$, with a total substrate concentration ($sub_T$) of 10 mM. The concentration of the substrate that is subjected to quantification (referred to as the analyte) has an unknown concentration in the low micromolar range. With 6 mL of this solution 900, 2.0 mg of complex precursor 904 [Ir(COD)(IMes)Cl] (i.e. complex 1 from Fig. 4) is dissolved ($C_M$ = 500 μM). The concentrations of metal precursor, substrates and analyte in the resulting artificial mixture stock 901 thus satisfy the condition $C_x << C_M < sub_T$. The exact analytical concentrations are not critical, as long as an identical mixture is used to prepare all samples in one standard addition series.

Standard-addition is performed in a gravimetrical approach. This involves adding fixed amounts ($m_{add}$) of methanol-$d_4$ solutions with known analyte mass fractions ($w_{add}$) 905, to fixed amounts ($m_x$) of the mixture 901 which contains an 'unknown' analyte mass fraction ($w_x$). For the quantification of one analyte, about five standard-addition samples are prepared with $w_{add}$ linearly distributed between 0 and 5 times $w_x$, see Table 4. In Fig. 23a the procedure is schematically given for 4 samples 905 respectively indicated with references 906, 907, 908, 909, and 4 samples 910, respectively indicated with references 911, 912, 913, 914. Note that one sample (# 7 (see table 4 below) and 911 in fig. 23a) is diluted with methanol-$d_4$ only ($w_{add}$ = 0), representing the original mixture. The standard-addition samples 910 (911, 912, 913, 914) are then transferred (in volumes of 600 μL) to Wilmad quick pressure valve NMR tubes and degassed in three 'cool'-pump-thaw cycles (the samples are cooled to 195 K in a acetone/dry ice bath, rather than frozen with liquid $N_2$, to prevent cracking of the NMR tube upon thawing) (915).

**Table 4.** Masses and mass fractions in a standard addition series of nicotinamide in an artificial complex mixture.

| sample # | $m_x$ (mg) | $m_{add}$ (mg) | $m_T$ (mg) | $w_{add}$ (fraction) | $C_{add}$ (μM) |
|---|---|---|---|---|---|
| **1** | 383.2 | 174 | 557.2 | 1.02E-05 | 74.52 |
| **2** | 382.1 | 169.2 | 551.3 | 7.54E-06 | 54.80 |
| **3** | 385.1 | 170.5 | 555.6 | 5.36E-06 | 38.96 |
| **4** | 385.8 | 178.9 | 564.7 | 3.75E-06 | 27.30 |
| **5** | 385.8 | 180.3 | 566.1 | 2.30E-06 | 16.69 |
| **6** | 389 | 191.1 | 580.1 | 1.13E-06 | 8.19 |
| **7** | 388.2 | 174 | 560.2 | 0 | 0.00 |

Coffee extracts: For the preparation of standard-addition samples using coffee extract as a complex mixture, a similar gravimetric standard-addition protocol was followed. However, the coffee extract and metal complex solutions are prepared separately (see below). This prevents variations between the different samples in a series. These variations are due to uncompleted activation of the metal complex when coffee extract is present.

A solution of co-substrate (1-methyl-1,2,3-triazole) in methanol-$d_4$ 920 was used to dissolve the complex precursor 904 to a typical concentration of 4 mM. The co-substrate to metal complex ratio in the resulting stock solution 921 is 15 to 1, ensuring hyperpolarization of diluted coffee components in the SABRE experiments. This stock solution 921 is either degassed as described in the above giving degassed complex/co-substrate stock 924, or prepared under argon/nitrogen atmosphere in a Glovebox.

Coffee extracts were prepared by mixing 4 grams of ground coffee beans 922 in 10 grams of methanol-$d_4$ 902. After 30 minutes of stirring, extraction is performed using a 0.45 μm syringe filter giving the coffee extract 923. Coffee extract solution standards 925 (926, 927, 928, 929) are obtained by adding predetermined amounts of analyte in methanol-$d_4$ solution 903 to predetermined amounts of coffee extracts 923 in a similar manner as described in the above for artificial mixtures. Equal amounts from a single metal complex/co-substrate stock solution are then transferred to several NMR tubes 924, after which molecular hydrogen (5 bar) is introduced for metal complex activation (described below), giving the activated co-substrate/complex stock 930. To these activated metal complex solutions, the coffee extracts 925 (926, 927, 928, 929) are added, resulting in a series of standard-addition samples 910 (911, 912, 913, 914) subsequently used in the NMR experiments.

*Hyperpolarization inside the NMR apparatus at high magnetic field*

Sample preparation may be applied as described above. If hyperpolarization is applied inside the NMR apparatus 1D experiments as well as 2D experiments may be performed. Especially in 2D experiments a plurality of substrates may be analyzed simultaneously in the same experiment and standard addition of a plurality of substrates may be applied simultaneously using the same set of samples and dilutions, especially, because overlapping substrate resonances may be resolved in the 2D correlation spectrum thanks to the high dispersion of the hydride signals. Hence (sample preparation of) samples comprising addition samples of different substrates may be combined.

Present invention provides methods for 1D and 2D experiments providing hyperpolarization inside an MR apparatus. Because of the above given advantage herein especially the 2D experiments are further illustrated. One dimensional experiments (and the information regarding these experiments) especially may be derived from the information described regarding 2D experiments.

Especially here the method is explained by an embodiment of an example wherein complex precursor **1** (see figure 10) may be dissolved in a methanol-$d_4$ solution containing a 15-fold excess of co-substrate *mtz* (1-methyl-1,2,3-triazole) and thirteen substrates (solution X). Neat methanol-$d_4$ may be added in a 1:1 ratio with solution X to obtain the original mixture with 2 and 30 mM of **1** and *mtz* respectively, while the final concentrations of the thirteen substrates may be between 250 nM and 2 $\mu$M (Fig. 25A). To obtain the spiking samples (sample 1 to 4, Fig. 25B) methanol-$d_4$ solutions containing the four spiking substrates in increasing concentrations may be added in a 1:1 ratio with solution X. All substrate concentrations may be determined gravimetrically.

Samples may be transferred to 5 mm Wilmad quick pressure valve (QPV) NMR tubes and degassed in three 'cool'-pump-thaw cycles (cooled to 195 K in an acetone/dry ice bath). Molecular hydrogen may be dissolved in the samples to form asymmetric metal complexes of the formula $[Ir(IMes)(H)_2(mtz)_2(sub)]Cl$, (see **4⁺** in figure 10, where for *sub* = *py*). Complete catalyst activation may require typically a period of 45 minutes. Chemical shifts of relevant bound substrate protons and corresponding hydrides are listed in Table 5:

| substrate | proton | $\delta$ ($^1$H) |
|---|---|---|
| PY | a | 8.74 |
| | $H_A$ | -22.79 |
| | $H_X$ | -22.11 |
| NI-2 | d | 8.72 |
| | a | 8.66 |
| | $H_A$ | -22.62 |
| | $H_X$ | -22.15 |
| CT-1 | d | 9.05 |
| | a | 8.31 |
| | $H_A$ | -22.81 |
| | $H_X$ | -22.10 |
| CT-2 | d | 8.89 |
| | a | 8.44 |
| | $H_A$ | -22.73 |
| | $H_X$ | -22.14 |
| NA | d | 9.18 |
| | a | 9.02 |
| | $H_A$ | -22.99 |
| | $H_X$ | -21.85 |
| PN | a | 8.77 |
| | $H_A$ | -22.72 |
| | $H_X$ | -21.69 |
| FP | d | 8.75 |
| | a | 8.49 |
| | $H_A$ | -23.29 |
| | $H_X$ | -21.89 |
| QZ | a | 9.65 |
| | b | 9.45 |
| | $H_A$ | -22.61 |
| | $H_X$ | -21.50 |
| mPN | a | 8.78 |
| | c | 8.55 |
| mPN | $H_A$ | -22.64 |
| | $H_X$ | -21.77 |
| pPPY | a | 8.77 |
| | $H_A$ | -22.59 |
| | $H_X$ | -21.97 |
| mNA | d | 9.36 |
| | a | 8.98 |
| | $H_A$ | -23.08 |
| | $H_X$ | -21.74 |
| mOP | d | 8.43 |
| | a | 8.43 |
| | $H_A$ | -22.92 |
| | $H_X$ | -22.16 |
| mAPY | d | 9.44 |
| | a | 8.92 |
| | $H_A$ | -22.99 |
| | $H_X$ | -21.85 |
| NIA | d | 9.39 |
| | a | 8.63 |
| | $H_A$ | -22.87 |
| | $H_X$ | -21.90 |

**Table 5** $^1$H chemical shifts of substrate protons in metal complexes **$4^+$** and the corresponding hydrides. Annotation and abbreviations given in Fig. 25. Note that both (-)-nicotine and (-) -cotinine have a chiral center resulting in diastereomeric **$4^+$** complexes, annotated by NI-1/NI-2, and CT-1/CT-2 respectively, see Fig. 26B.

Upon hydrogenation of the solutions mentioned above also the symmetric complexes **8+** and **9+** are formed (Fig. 26A). However, as these do not contain substrate molecules bound trans to the hydrides, they do not provide any substrate signal enhancement.

***NMR experiments***

With a *p*-$H_2$ generator, 51% enriched *p*-$H_2$ is produced (thermal molecular hydrogen has a *p*-$H_2$ content of 25%). The signal enhancement factors obtained with 51% enriched *p*-$H_2$ are approximately one third of those when using fully enriched *p*-$H_2$ (produced at 20K). The enriched *p*-$H_2$ is transferred to an aluminum cylinder in which it is stable for several weeks. The *p*-$H_2$ cylinder is connected to a portable suitcase. A quick pressure valve NMR tube is connected and a vacuum pump is connected. After opening one or more valves, including a vacuum valve, the space above the solution in the NMR tube is evacuated by opening the valve of the NMR tube. The vacuum valve and the NMR tube valve are then closed, and the *p*-$H_2$ cylinder is opened. The pressure in the cylinder is now displayed at a display, while through a valve the *p*-$H_2$ output pressure to the NMR tube can be adjusted (and monitored digitally). Finally the NMR tube valve is opened for a few seconds to introduce the *p*-$H_2$ above the sample volume in the NMR tube. Hence, herein especially quick pressure valve NMR tubes are used for measurement in an NMR comprising apparatus. Suitable NMR tubes are available at Sigma Aldrich, such as Wilmad® quick pressure valve 5 mm NMR tubes.

*Hyperpolarization outside the NMR apparatus at low magnetic field (no embodiment of the invention)*

Metal complex activation: Hydrogen gas (optionally *para*-$H_2$) at 5 bar is introduced above the solution in the NMR tubes, after which the sample is vigorously shaken for several seconds to saturate the solution. It is noted that the *p*-$H_2$ may decay back to normal $H_2$ because of interactions with the metal complex (and with the glass of the NMR tube, though this is a slower process). Depending on the metal complex concentration in solution, this decay of *p*-$H_2$ only allows a few measurements before the *p*-$H_2$ needs to be replenished. To ensure maximum enhancements (and a constant *p*-$H_2$ content of ~51% for all samples in a series), the metal complex is activated by dissolving *p*-$H_2$, then, after full activation *p*-$H_2$ is replenished directly prior to a SABRE experiment.

The dissolution of molecular hydrogen allows the formation of SABRE-active metal complexes [Ir(IMes)$(H)_2$($sub_i$)($sub_j$)($sub_k$)]Cl via hydrogenation of the COD ligand of complex precursor [Ir(COD)(IMes)Cl] (Fig. 4). The invention is not limited to iridium based catalysts. Also other type of SABRE catalysts may be used.

Prior to performing the SABRE experiments, a substantially full activation of the metal complex in each sample is ensured. The rate of activation is dependent on the type of metal complex used and the substrates present in solution, and is typically in the order of several minutes. Activation is monitored by the increasing cyclooctane (COA) signal intensity in the thermal NMR spectrum of one sample. The resulting activation time is then used as a minimum interval between activation and SABRE experiment for all samples. In stable mixtures it is possible to activate all samples at once, which reduces the time between subsequent measurements.

SABRE: After full activation, the volume above the solution is evacuated and *p*-$H_2$ is introduced at a pressure of 5 bar. Samples 940 are e.g. shaken (indicated with the double arrow in fig. 23c) for 10 seconds in the stray field of the spectrometer, at a fixed position with a magnetic field strength of approximately 6.5 mT, and rapidly inserted into the bore 950 after which a 90° rf pulse was applied 960 to obtain a SABRE spectrum 970. Manually shaking the sample restricts the type of NMR experiments to single scan experiments because the sample has to be shaken again outside the NMR spectrometer for a new scan to re-hyperpolarize the substrate molecules. However, when using an automated polarizer with a flow-probe the sample can be rapidly hyperpolarized between scans with a good reproducibility, allowing multidimensional experiments. The experimental time is determined by the sample handling (introduction of *p*-$H_2$), shaking and transfer period, and is approximately 45 seconds per sample. Repeated SABRE experiments for the same sample are easily obtained after evacuation of the volume above the solution and replenishing p-$H_2$.The variation in polarization transfer field (PTF) experienced by the sample during the shaking period, affects the degree of hyperpolarization and, as a consequence, increases the uncertainty of the quantification. This variation is minimized by carefully shaking the sample along the magnetic field lines, at a fixed position with respect to the magnet. The timing of the rf pulse and the air flow within the bore are coupled to the shaking period by an automation program. This ensures a constant transfer time (approximately 8 seconds) from the low magnetic PTF (6.5 mT) 940 to the high magnetic field of the spectrometer 950. The reproducibility of SABRE performed by manually shaking the sample in the stray field of the magnet is hardly better than 10%-20%, with the main source of error being the variations in PTF and sample transfer time. Using an automated polarization setup would greatly reduce this uncertainty and, in addition, would enable multidimensional experiments.

In Fig. 5 results of the artificial mixture standard-addition experiments are given, showing the linear behavior of the method.

*Hyperpolarization inside the NMR apparatus at high magnetic field*

Metal complex activation and SABRE: A specific embodiment of a sample cell, especially a *para*-$H_2$ mixing unit, even more especially a bubbling unit for mixing *p*-$H_2$ inside the MR apparatus is illustrated in Fig. 27B. The embodiment comprises a 18 cm (7 inch) QPV NMR tube fitted into a PEEK (polyether ether ketone) headpiece. Three parallel holes were drilled of which the center one was bored-through, all connected via PEEK tubing to solenoid valves located outside the 5 Gauss line of the NMR magnet. The valves are controlled via TTL-pulses generated by the pulse program. A low-pressure adjustable relief valve is connected to valve 1 and calibrated to a pressure of 4 bar to increase the solubility of hydrogen in solution.4. Line 2 and 3 are connected via PEEK tubing from the solenoid valves to an aluminum cylinder 3 supplying *p*-$H_2$ at 5 bar. Line 2 runs through the headpiece down to the bottom of the NMR tube, while line 3 acts above the liquid level. An inline check valve is mounted in the supply line 2, to prevent back flow of the solution. Especially since shaking is not performed manually and outside the apparatus, it does not restricts the type of NMR experiments to single scan experiments.

Optionally, the tube may be pressurized outside the magnet to check that no leakages are present. A regular spinner turbine may serve as a sample holder and the sample cell may be lowered into the probe head by hand. Next, regular sample handling may be performed such as tuning and matching, shimming and pulse calibration.

The first step of the sequence of supplying *p*-$H_2$ is to relieve the pressure in the sample cell against a variable pressure valve. Next, the reactant gas is supplied via the PEEK tubing into the solution. The one bar difference between the supply pressure and the pressure in the sample cell may result in moderate mixing of *p*-$H_2$ and the solution. The supply valve may be closed after a defined period (typically 1 s) and a backpressure is applied thereafter. The final step is the closure of the backpressure valve prior to acquisition. The duration of supplying p-$H_2$, the duration of the applied backpressure as well as the time needed for stabilization before starting the NMR experiment may easily be screened to establish the optimal combination of signal intensity and linewidth.

The solenoid valves (Valcor Scientific Springfield, NJ, USA) are connected via 1/16" outer diameter (O.D.) PEEK tubing with 0.030" inner diameter (I.D.) to the aluminum cylinder and the outlet/vent of the PEEK headpiece. PEEK tubing with 0.010" I.D. is connected to the center inlet of the headpiece. A low-pressure adjustable relief valve (Swagelok, The Netherlands) is connected via 0.030" I.D. PEEK tubing to the solenoid valve. The solenoid valves are connected to TTL outputs of the Agilent Unity INOVA console.

The pulse scheme sketched in Fig. 29 may e.g. be used to acquire the 2D NMR correlation spectrum between hydrides and substrate protons. Bubbling *p*-$H_2$ at high field results in longitudinal spin order on the hydrides that is converted into antiphase coherence by the first selective 90° pulse. Offset and bandwidth of this pulse are optimized to selectively excite the hydrides $H_A$ that are trans with respect to the substrates of interest (Fig. 30a). In an embodiment comprising *mtz* as co-substrate, these correspond to the hydrides that resonate at higher field. The Constant-Time period $\tau_{IS}$ serves the double purpose of refocusing the antiphase between the two hydrides while dephasing the coherence via long-range couplings to the substrate protons. A pair of 90° selective pulses, transfers the coherence to the substrate protons for detection. Antiphase with respect to the hydrides is refocused during the acquisition period. Because of the sine-modulation of the acquired signal, these correlation spectra should be processed in magnitude-mode for a quantitative analysis.

The pulse sequence displayed in the figure is especially used to transfer the polarization from para-hydrogen derived hydrides to bound substrate protons. When a *p*-$H_2$ molecule binds to the co-substrate complex, the resulting hydrides have different chemical shifts as a result of the asymmetry of the complex. The first 90° pulse selectively excites one of the hydrides (the one with a significant scalar coupling with the substrate protons, i.e. the hydride trans to the substrate). Then, by a pair of 180° refocusing pulses (one on both hydrides, one on the substrate protons) during period $\tau_{IS}$, followed by selective 90° excitation pulses on the same regions, polarization is transferred from the hydrides to the substrate protons. Thus, polarization transfer from *p*-$H_2$ derived hydrides to substrate protons takes place during period $\tau_{IS}$ by application of the 180° refocusing pulses and the following excitation pulses (those with phase $\Phi_2$ and $\Phi_3$). The last 180° refocusing pulse is not essential.

To acquire a 2D spectrum, $t_1$ is incremented (for each increment an FID is recorded). This results in chemical shift evolution in the indirect dimension (in this experiment the hydride region). *p*-$H_2$ is bubbled through the sample before each scan, e.g. when a 2D is recorded with 64 increments averaged over 8 transients, the pulse sequence is passed 512 times, and *p*-$H_2$ is bubbled as often.

A 2D NMR spectrum like depicted in Fig. 28 may be recorded in approximately 25 minutes for a mixture of thirteen SABRE substrates at concentrations between 250 nM and 2 $\mu$M. All overlapping substrate resonances may nicely be resolved in the 2D correlation spectrum thanks to the high dispersion of the hydride signals.

The robustness of the method is reflected in the accuracy of the concentrations obtained via standard addition method for four substrates in the dilute mixture. Examples of linear plots of the 2D signal integrals versus added substrate concentration are shown in Figs. 31.

Below some SABRE active metal complexes are schematically described in Table 6:

**Table 6.** Phosphine ($PR_3$) ligands for complex precursor [Ir(COD)($PR_3$)(py)][$BF_4$] for SABRE-active metal complexes [Ir($PR_3$)$(H)_2$$(py)_3$][$BF_4$], K.D. Atkinson et al., J. Am. Chem. Soc. 2009, 131, 13362-13368.

| abbreviation | name | formula | CAS | structure |
|---|---|---|---|---|
| $P(Cy)_3$ | Tricyclohexylphosphine | $(C_6H_{11})_3P$ | 2622-14-2 | 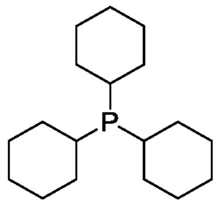 |
| $PPhCy_2$ | Dicyclohexylphenyl-phosphine | $(C_6H_{11})_2PC_6H_5$ | 6476-37-5 | 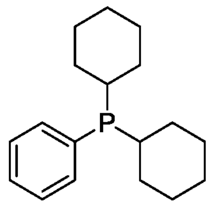 |
| $PPh_2Cy$ | Cyclohexyldiphenyl-phosphine | $C_6H_{11}P(C_6H_5)_2$ | 6372-42-5 | 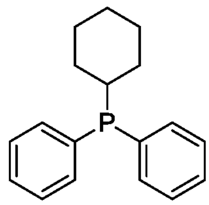 |
| $PEt_3$ | Triethylphosphine | $(C_2H_5)_3P$ | 554-70-1 | 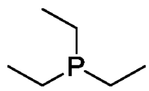 |
| $P^iPr_3$ | Triisopropylphosphine | $[(CH_3)_2CH]_3P$ | 6476-36-4 | 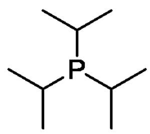 |
| P(*n*-Bu)$_3$ | Tributylphosphine | $[CH_3(CH_2)_3]_3P$ | 998-40-3 | 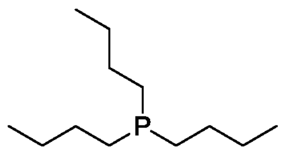 |
| P(*t*-Bu)$_3$ | Tri-*tert*-butylphosphine | $[(CH_3)_3C]_3P$ | 13716-12-6 | 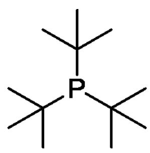 |
| P(1-naphtyl)$_3$ | Tri-1-naphthylphosphine | $(C_{10}H_7)_3P$ | 3411-48-1 | 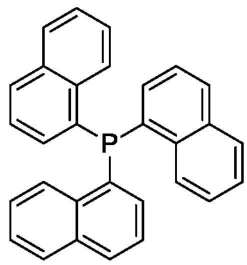 |

In Tables 7a & 7b below a non-limiting number of ligands for SABRE active metal complexes are provided:

**Table 7A.** N-Heterocyclic Carbene (NHC) ligands before coordination to $[IrCODCl]_2$ to form complex precursor [Ir(COD)(NHC)Cl] for SABRE-active metal complexes $[Ir(NHC)(H)_2(py)_3][Cl]$, B.J.A. van Weerdenburg et al., Dalton Trans. 2015, DOI: 10.1039/C5DT02340H.

| abbreviation | name | formula | CAS | structure |
|---|---|---|---|---|
| IMesCl | 1,3-Bis(2,4,6-trimethylphenyl)imida zolium chloride | $C_{21}H_{25}ClN_2$ | 141556-45-8 | 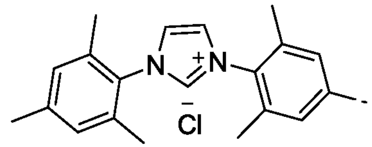 |
| SIMesCl | 1,3-Bis(2,4,6-trimethylphenyl)-imidazolinium chloride | $C_{21}H_{27}ClN_2$ | 173035-10-4 | 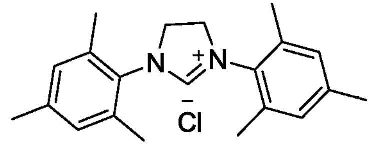 |
| IPrCl | 1,3-Bis(2,6-diisopropylphenyl)imi dazolium chloride | $C_{27}H_{37}ClN_2$ | 250285-32-6 | 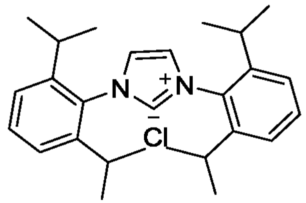 |
| SIPrCl | 1,3-Bis-(2,6-diisopropylphenyl)imi dazolinium chloride | $C_{27}H_{39}ClN_2$ | 258278-25-0 | 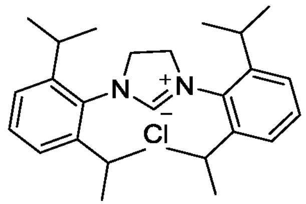 |
| ICyCl | 1,3-Dicyclohexyl-imidazolium chloride | $C_{15}H_{25}ClN_2$ | 181422-72-0 | 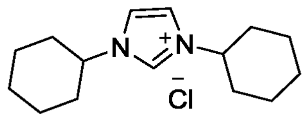 |
| IiPrCl, Im$N^i$Pr$_2$Cl | 1,3-Diisopropyl-imidazolium chloride | $C_9H_{17}ClN_2$ | 139143-09-2 | 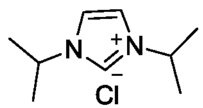 |

(continued)

| abbreviation | name | formula | CAS | structure |
|---|---|---|---|---|
| SIiPrCl, SIm$N^{i}Pr_2$Cl | 1,3-diisopropyl-4,5-dihydroimidazolium chloride | $C_9H_{19}N_2Cl$ | 871126-32-8 | 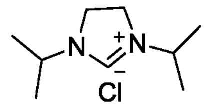 |
| ItBuCl | 1,3-Di-t-butylimidazolium chloride | $C_{11}H_{21}N_2Cl$ | 157197-54-1 | 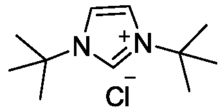 |
| IPentCl | 1,3-Bis(2,6-di(pentan-3-yl)phenyl)-1H-imidazol-3-ium chloride | $C_{35}H_{55}N_2Cl$ | 1157867-61-2 | 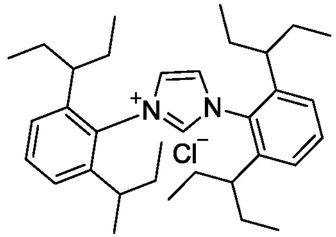 |

**Table 7B.** N-Heterocyclic Carbene (NHC) ligands after coordination to complex precursor Ir(COD)(NHC)Cl for SABRE-active metal complexes [Ir(NHC)(H)$_2$(py)$_3$][Cl], B.J.A. van Weerdenburg, Chem. Comm. 213, 49, 7388-7390.

| abbreviation | name | formula | CAS | structure |
|---|---|---|---|---|
| IMes | 1,3-Bis(2,4,6-trimethylphenyl)-1,3-dihydro-2*H*-imidazol-2-ylidene | $C_{21}H_{24}N_2$ | 141556-42-5 | 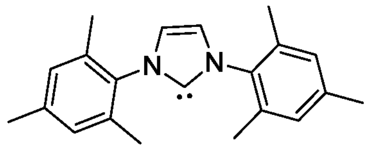 |
| SIMes | 1,3-Bis(2,4,6-trimethylphenyl)-4,5-dihydroimidazol- 2-ylidene | $C_{21}H_{26}N_2$ | 173035-11-5 | 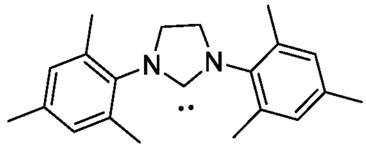 |
| IPr | 1,3-Bis(2,6-diisopropylphenyl)-1,3-dihydro-2*H*-imidazol-2-ylidene | $C_{27}H_{36}N_2$ | 244187-81-3 | 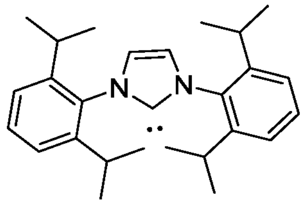 |
| SIPr | 1,3-Bis(2,6-di-*i*-propylphenyl)imidazolidin-2-ylidene | $C_{27}H_{38}N_2$ | 258278-28-3 | 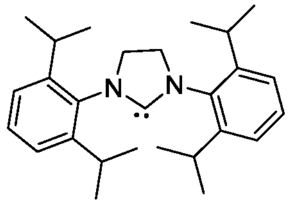 |
| ICy | 1,3-dicyclohexylimidazol-2-ylidene | $C_{15}H_{24}N_2$ | | 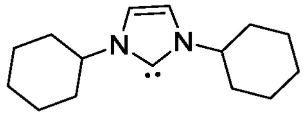 |
| IiPr, Im*N*$^i$Pr$_2$ | 1,3-diisopropylimidazol-2-ylidene | $C_9H_{16}N_2$ | | 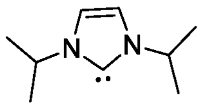 |
| SIiPr, SIm*N*$^i$Pr$_2$ | 1,3-diisopropylimidazolidin-2-ylidene | $C_9H_{18}N_2$ | | 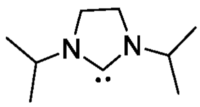 |
| IAD | 1,3-di(1-adamantyl) imidazol-2-ylidene | $C_{11}H_{20}N_2$ | | 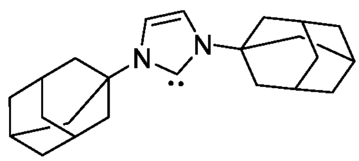 |
| ItBu | 1,3-di-tert-butylimidazol-2-ylidene | $C_{23}H_{32}N_2$ | | 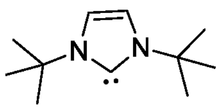 |

(continued)

| abbreviation | name | formula | CAS | structure |
|---|---|---|---|---|
| IPent | 1,3-bis(2,6-di(3-pentyl) phenyl)imidazol -2-ylidene | $C_{35}H_{52}N_2$ | | 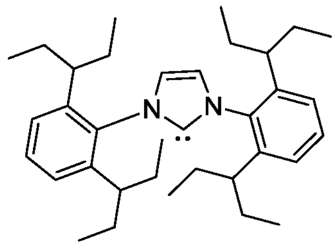 |

Below, some specific ligands for complex precursors are provided:

**Table 8:** Phosphine ($PR_3$) ligands for SABRE-active metal complexes [Ir(IMes)($PR_3$)$(py)_2$][Cl], Referring to Fig. 10, would the ligands of table 8 be added to the solution, then upon hydrogenation the phosphine coordinates irreversibly trans to the NHC ligand, such as IMES, and thus *py* or *mtz* is displaced in that case in Fig. 10.

| abbreviation | name | formula | CAS | structure |
|---|---|---|---|---|
| $PPh_3$ | Triphenylphosphine | $(C_6H_5)_3P$ | 603-35-0 | 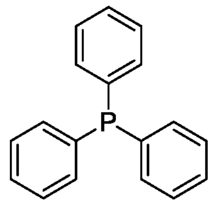 |
| P(*p*-tol)$_3$ | Tri(*p*-tolyl)phosphine | $(CH_3C_6H_4)_3P$ | 1038-95-5 | 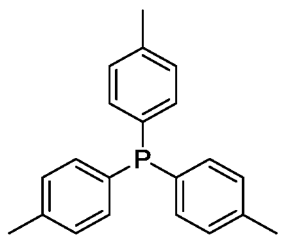 |
| P(*m*-tol)$_3$ | Tri(*m*-tolyl) phosphine | $(CH_3C_6H_4)_3P$ | 6224-63-1 | 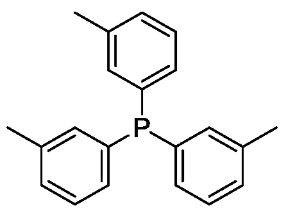 |

Hence, a method is described for the detection with SABRE magnetic resonance of an analyte at an unknown concentration in a complex sample, the method comprising: providing a series of mixtures M1, M2, ..., Mn, wherein each mixture comprises a predefined part of the complex sample comprising the analyte, a SABRE catalyst at a concentration $C_m$, and especially also a co-substrate at a concentration $C_{co\text{-}sub}$, wherein $C_m < C_{co\text{-}sub}$; and wherein two or more of the mixtures are provided with a known concentration of added analyte for standard addition determination of the unknown concentration of said analyte; applying hyperpolarizing material, especially *p*-$H_2$ *(para* $H_2$), to the mixtures and measuring with magnetic resonance the magnetic resonance response of the mixtures; and determining from the magnetic resonance response of the series of mixtures the unknown concentration of the analyte.

Further, a method for the detection with Signal Amplification By Reversible Exchange (SABRE) magnetic resonance of an analyte at an unknown concentration $C_{sub}$ in a complex sample is described, especially comprising a solvent, wherein the complex sample especially comprises at least 5 different organic molecules, the method comprising: providing a series of mixtures M1, M2, ..., Mn, wherein each mixture comprises a predefined part of the complex sample comprising the analyte, a SABRE catalyst at a concentration $C_m$, and a co-substrate at a concentration $C_{co\text{-}sub}$, wherein $C_{sub} << C_m < C_{co\text{-}sub}$,; and wherein two or more of the mixtures are provided with a known concentration of added analyte

for standard addition determination of the unknown concentration $C_{sub}$ of said analyte; applying *para*-$H_2$ to the mixtures and measuring with nuclear magnetic resonance the magnetic resonance response of the mixtures, and determining from the magnetic resonance response of the series of mixtures the unknown concentration $C_{sub}$ of the analyte. In an example not forming an embodiment of the invention, *para*-$H_2$ is applied to the mixture in a magnetic field, especially outside an MR apparatus, especially in the stray field of an MR apparatus, comprising a magnetic field flux density selected in the range of 0-30 mT, such as 0-20 mT, especially in the range of 0.2-15 mT, such as in the range of 0.5-6.5 mT. Especially the magnetic field strength may be selected in the range of 0.2-25 mT, especially in the range of 8-13mT. In a further embodiment, *para*-$H_2$ is applied to the mixture, especially an MR apparatus, in a magnetic field comprising a magnetic field flux density selected in the range of 1-30 T. Especially n is at least 5 and one of the mixtures does not include added analyte.

M1 may be *e.g.* a mixture without added analyte, M2 may be with added analyte, M3 may be with twice the amount added analyte as M2, etc. Especially, n is at least 4, such as at least 5 (and wherein one of the mixtures does not include added analyte). This may provide more reliable standard addition curve, and thus more reliable values. Herein analyte may refer to a single analyte. Analyte may also refer to a plurality of analytes (to determine). According to the invention the SABRE technology comprises hyperpolarization inside the MR apparatus, especially in the bore of the apparatus, at high magnetic field (such as e.g. in the range of 1-24 T or even higher), and especially if the magnetic resonance response is provided in multiple dimensions (such as a 2D spectra), the unknown concentration of a plurality of analytes may be determined from the series of mixtures.

Especially said *para*-$H_2$ is applied in a *para*-$H_2$ applications stage. In an embodiment the stage of applying *para*-$H_2$ to the mixtures and measuring with nuclear (1D or 2D) magnetic resonance, especially 2 dimensional, the magnetic resonance response of the mixtures is repeated, and the unknown concentration $C_{sub}$ of the analyte is determined from the 1 dimensional or 2 dimensional, especially the 2 dimensional magnetic resonance response of the series of mixtures.

In a specific embodiment, the unknown concentration $C_{sub}$ of a plurality of analytes is determined, especially simultaneously determined, especially by adding known concentrations of the plurality of analytes, especially simultaneously In an aspect of the invention the method may comprises estimating the concentration of the analyte in the complex sample at $C_e$, and providing said series of mixtures M1, M2, ..., Mn, wherein each mixture comprises said predefined part of the complex sample comprising the analyte, said SABRE catalyst at said concentration $C_m$, and a co-substrate at a concentration $C_{co\text{-}sub}$, wherein $C_m < C_{co\text{-}sub}$, wherein $C_e << C_m$. This may be a rough estimation. In general, the order of the concentration can be estimated. Based thereon the standard addition series may be optimized. This is known to the person skilled in the art, and may optionally comprise an iterative process until approximately the desired concentration ratios may be obtained.

Especially good results of the method may be obtained wherein $C_m / C_e \geq 5$, such as $C_m / C_e \geq 10$, especially wherein $C_m / C_e \geq 20$, even more especially $C_m / C_e \geq 30$, like at least 50, even more at least 100, and/or wherein $C_{co\text{-}sub} / C_m \geq 1.1$, especially wherein $C_{co\text{-}sub} / C_m \geq 1.5$, even more especially wherein $C_{co\text{-}sub} / C_m > 2$, like at least 3, such as especially least 5, even more especially at least 6, such as at least 9, such as especially at least 10, even more especially at least 12, such as at least 15.

The series may be made before the MR measurement. However, the series may also be made with each new mixture made after an MR measurement. In a specific embodiment, the method comprises providing a first mixture M1, applying hyperpolarizing *p*-$H_2$ to the mixture and measuring with magnetic resonance the magnetic resonance response of the mixture, (subsequently) adding analyte to the first mixture M1 to generate a next mixture and applying *p*-$H_2$ to the mixture and measuring (again) with magnetic resonance the magnetic resonance response of the mixture, and repeating one or more times the stages of adding analyte to the previously measured mixture and applying *p*-$H_2$ (*para* $H_2$) to the mixture and measuring with magnetic resonance the magnetic resonance response of the mixture, followed by determining from the magnetic resonance response of the series of mixtures the unknown concentration of the analyte. Applying hyperpolarizing *p*-$H_2$ (para $H_2$) especially refers to admixing *p*-$H_2$ to the mixture. In general, the stages of adding analyte to the previously measured mixture and applying *p*-$H_2$ (*para* $H_2$) to the mixtures will be executed outside the magnetic bore of the MR apparatus. In a further embodiment, the method comprises providing a first mixture M1, applying hyperpolarizing *p*-$H_2$ (*para*-$H_2$) to the mixture and measuring with magnetic resonance the magnetic resonance response of the mixture, adding analyte to the first mixture M1 to generate a next mixture and applying *p*-$H_2$ to the mixture and measuring with magnetic resonance the magnetic resonance response of the mixture, and repeating one or more times the stages of adding analyte to the previously measured mixture and applying *p*-$H_2$ to the mixture and measuring with magnetic resonance the magnetic resonance response of the mixture, followed by determining from the magnetic resonance response of the series of mixtures the unknown concentration of the analyte.

Applying *para*-$H_2$ is executed inside the magnetic bore of the MR apparatus, at a high magnetic field in the range of 1-50 T. Especially the stage of adding analyte will be executed outside the magnetic bore of the MR apparatus. Hence, such method may include a transport of the mixture(s) within the apparatus (to the respective stages). To this end a probe (transport) system such as "flow-probe system" may be applied. Especially such flow-probe system may

be applied if the hyperpolarization is provided outside the bore of the MR apparatus, especially at a low magnetic field, especially in the stray field of the MR apparatus.

Herein low magnetic field especially refers to a magnetic field comprising magnetic field flux densities in the mT range. A high magnetic field especially may refer to a magnetic field comprising magnetic field flux densities being about 1000 times higher, especially in the Tesla range.

Good results can be obtained with the co-substrate provided to the mixture, and wherein the co-substrate comprises (1-methyl-1,2,3-triazole or *"mtz"*) or a similar compound, such as with other substituents, like e.g. substituted with PEG, etc.. However, also one or more other co-substrates may be applied. Suitable co-substrates may e.g. be 1,2,3 triazoles with substituents on the 1 and 4,5 position. Examples of substituents on 1 position are alkyl groups (methyl, ethyl) or polyethylene glycol (PEG). The 4,5 positions can be occupied by protons, deuterium or other elements (e.g. bromide) or are part of a ring system (e.g. benzotriazole). However, one or more other heterocycles may also be used. The (above) examples are not limiting. In an embodiment the co-substrate comprises one or more co-substrates selected form the group consisting of 1,2,3 triazoles consisting of 1-methyl-1,2,3-triazole *(mtz),* 1-ethyl-1,2,3-triazole (*etz*)*,* dideuterium-1-methyl-1,2,3-triazole (*mtz-d*$_2$), dibromo-1-methyl-1,2,3-triazole (*brmtz*), 1-methyl-1,2,3-benzotriazole (*mbtz*), 1-((1,3-dioxolan-2-yl)methyl)-4,5-dideuterium-1,2,3-triazole (*diox-tz*), and 4,5-dideuterium-1-(2-(2-methoxyethoxy)ethyl)-1,2,3-triazole (*PEG-tz*). In a further embodiment the co-substrate comprises one or more co-substrates selected form the group consisting of 1,2,3 triazoles and tetrazoles consisting of 1-methyl-1,2,3-triazole *(mtz),* 1-ethyl-1,2,3-triazole (*etz*), dideuterium-1-methyl-1,2,3-triazole (*mtz-d*$_2$), dibromo-1-methyl-1,2,3-triazole (*brmtz*), 1-methyl-1,2,3-benzotriazole (*mbtz*), 1-((1,3-dioxolan-2-yl)methyl)-4,5-dideuterium-1,2,3-triazole (*diox-tz*), 1H-1,2,3-triazole (*tz*), 4,5-dideuterium-1-(2-(2-methoxyethoxy)ethyl)-1,2,3-triazole (*PEG-tz*), 5-methyl-1H-tetrazole (*mttz*), 1,5-dimethyltetrazole (*1,5-dmttz*), 1-(4-methoxybenzyl)-4,5-deuterium-1,2,3-triazole (*pmb-tz*), 1,5-dimethyl-1,2,3-triazole (1,5-*dmtz*), 1,4-dimethyl-1,2,3-triazole (*1,4-dmtz*), and 4,5-deuterium-1-((perfluorzophenyl)methyl)-1,2,3-triazole (*fmb-tz*). Alternatively or additionally, especially every SABRE substrate can also function as a co-substrate, if it fulfills the requirements listed herein.

Examples of suitable co-substrate are given below:

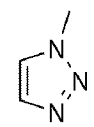

1-methyl-1,2,3-triazole

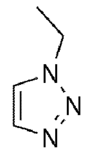

1-ethyl-1,2,3-triazole

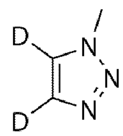

dideuterium-1-methyl-1,2,3-triazole

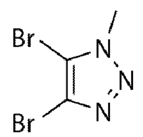

dibromo-1-methyl-1,2,3-triazole

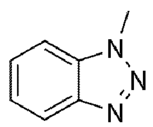

1-methyl-1,2,3-benzotriazole

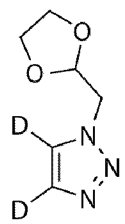

1-((1,3-dioxolan-2-yl)methyl)-4,5-dideuterium-1,2,3-triazole

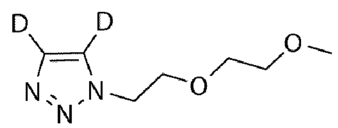

4,5-dideuterium-1-(2-(2-methoxyethoxy)ethyl)-1,2,3-triazole

In an embodiment, the complex sample comprises a biological sample, for instance extracted from a human or an animal, or wherein the complex sample comprises a food material or feed material, wherein the food product may for instance include a fresh food product or a processed food product. The complex sample will in general include a plurality of organic molecules, optionally including metal-organic molecules. For instance, the complex sample may comprise 5 or more, or 10 or more, or 15 or more different organic molecules, even more than 20. The term "organic molecule" may also refer to bioorganic molecules, such as vitamines, proteins, fatty acids, etc. The concentration of the analyte (to be measured) will in general be lower than about 10 μM, especially below 1 μM, such as even below 0.1 μM; higher concentrations can be measured with other techniques. The SABRE technique described herein is especially relevant for low concentrated analytes because of its sensitivity. The complex sample may especially comprise a liquid

wherein the analyte is solved. For instance, a biological sample can be extracted from a biological system and can be combined with a solvent, such as methanol, or deuterated methanol, to provide the complex sample. The complex sample may be combined with the co-substrate before or after combination or at the same time when providing the solvent. Likewise, the complex sample will be combined with the catalyst or metal complex before or after combination or at the same time when providing the solvent. The SABRE catalyst may be provided as catalyst precursor (herein also indicated as "complex precursor"). Further, the co-substrate may also be added after the complex sample is solved and the SABRE catalyst has been added. The mixture that is measured comprises the complex sample, the SABRE catalyst and especially added co-substrate.

Especially, the method may include using an NMR apparatus, especially configured to measure proton NMR, wherein the NMR apparatus comprises an NMR detection unit and one or more of the following units: a mixing chamber for providing one or more of the above mixtures, a *p*-$H_2$ unit for generation and/or storage of *p*-$H_2$ and for providing *p*-$H_2$ to the sample, a flow-probe system for transporting a probe comprising the mixture between different positions within the apparatus, a unit for providing the co-substrate, a unit for providing one or more analytes in predetermined amounts to the one or more mixtures, a *para*-$H_2$ mixing unit, such as a shaking unit and/or a bubbling unit for mixing (such as by shaking and/or bubbling) one or more samples within a magnetic field, especially substantially parallel to the magnetic field (lines) of such field.

This magnetic field used by the *para*-$H_2$ mixing unit, such as a shaking unit and/or a bubbling unit, may be the magnetic field of the MR detection unit but may alternatively or additionally also include an additional magnetic field, independent of the magnetic field of the MR detection unit. However, according to the invention the magnetic field inside the MR detection unit is applied. The probe system for transporting a probe, herein also indicated as "probe transporting system" may be a system wherein the probe is transported through a capillary. To that end, *e.g.* an inert gas, like one or more of $N_2$ and He, may be applied, though other gasses may also be used. However, the probe system may also be a system including a rail or including other means configured to move a probe to different positions with the apparatus. The probe (transporting) system is especially configured to transport the probe from a first stage, such as the mixture generation stage (generation of "sample", herein also indicated as "mixture" or "probe"), to the unit for providing *p*-$H_2$ to the sample *para*-$H_2$ mixing unit, such as a shaking unit, therefrom to the MR detection unit, and after detection to a position external from the magnetic bore, or more in general, the entire detection unit. Alternatively, the probe (transporting) system may especially be configured to transport the probe from a first stage, such as the mixture generation stage (generation of "sample", herein also indicated as "mixture" or "probe") to the MR detection unit, and after hyperpolarization and scanning of a spectrum to a position external from the magnetic bore, or more in general, the entire detection unit. Optionally, the probe system is further configured to transport the sample or probe to the mixing chamber (again), for *e.g.* for addition of a predetermined amount of (added) analyte. This may be used for the standard addition analysis method as mentioned herein. The transporting system is configured to transport the mixtures from one position to another position within the system. Herein, the complex sample will in general be comprised by a mixture, including e.g. one a solvent and/or co-substrate. This mixture, optionally in a small container, is measured in the MR apparatus and is therefore also indicated as probe. The mixture can also be transported with a flow system. Such system is herein indicated as flow-probe system. Hence, the mixture under investigation in the NMR apparatus may also be indicated as "probe" or "sample"

Hence, also an NMR apparatus is described, especially configured to measure proton NMR, wherein the NMR apparatus comprises an NMR detection unit and one or more of the following units: a mixing chamber for providing one or more of the above mixtures, a *p*-$H_2$ unit for generation and/or storage of *p*-$H_2$ and for providing *p*-$H_2$ to the sample, a flow-probe system for transporting a probe comprising the mixture between different positions within the apparatus, a unit for providing the co-substrate, a unit for providing one or more analytes in predetermined amounts to the one or more mixtures, a *para*-$H_2$ mixing unit, such as a shaking and/or bubbling unit for mixing (such as by shaking and/or bubbling) one or more sample within the magnetic field, especially substantially parallel to the magnetic field (lines), especially inside the bore of the NMR apparatus..

Hence, in a specific embodiment, an NMR apparatus, especially a proton NMR apparatus, is provided, the (proton) NMR apparatus comprising an NMR detection unit; a mixing chamber for providing one or more mixtures; a *p*-$H_2$ unit for providing *p*-$H_2$ to the sample; a probe system for transporting a probe with the mixture between different positions within the apparatus; a unit for providing one or more analytes in predetermined amounts to the one or more mixtures; and a *para*-$H_2$ mixing unit, such as a shaking and/or bubbling unit for mixing (such as by shaking and/or bubbling) one or more samples within a magnetic field. The *p*-$H_2$ unit can for instance provide the *p*-$H_2$ into the mixture in the mixing unit. In a another embodiment, the (proton) NMR apparatus comprising an NMR detection unit; a mixing chamber for providing one or more mixtures; a *p*-$H_2$ unit for providing *p*-$H_2$ to the sample; a unit for providing one or more analytes, especially a plurality of analytes, in predetermined amounts to the a mixtures; and a *para*-$H_2$ mixing unit, such as a shaking and/or bubbling unit for mixing (such as by shaking and/or bubbling) the samples (mixture comprising a sample) within a magnetic field, especially inside the NMR apparatus.

The apparatus may comprise further one of more of a *p*-$H_2$ generation unit, a control unit, an analysis unit, etc.

Further the apparatus, especially the analysis unit, may have access to an external database, such as with one or more calibration curves (see also below). The invention also describes a *para*-$H_2$ generation unit *per se,* comprising an outlet for coupling with a *p*-$H_2$ cylinder, either directly or via a connector element, such as a tube. The invention also describes an NMR apparatus, such as defined in above, or elsewhere above, wherein the *p*-$H_2$ cylinder as defined above can be functionally coupled to the NMR apparatus, especially to the para-$H_2$ mixing unit inside the NMR apparatus. Hence, the invention also provides the method, unit, cylinder or apparatus as defined above, wherein the *p*-$H_2$ is provided or can be provided under increased pressure to the mixture.

In an embodiment, based on the (N)MR data a calibration curve is generated for the specific analyte.

Hence, the invention also provides a method for the detection with SABRE magnetic resonance of an analyte at an unknown concentration in a complex sample, the method comprising: providing a mixture comprising a predefined part of the complex sample comprising the analyte, a SABRE catalyst at a concentration $C_m$, and especially also a co-substrate at a concentration $C_{co\text{-}sub}$, wherein $C_m < C_{co\text{-}sub}$; and applying hyperpolarizing material, especially *p*-$H_2$ *(para* $H_2$), to the mixture and measuring with magnetic resonance the magnetic resonance response of the mixture; and determining from the magnetic resonance response and a calibration curve the unknown concentration of the analyte, especially wherein the concentration of the analyte << $C_m$, wherein the method is further defined in the accompanying claims.

Especially, such method may further comprise further using specific conditions such as selected from (i) using the same catalyst (as used for the calibration curve), (ii) using the same co-substrate (as used for the calibration curve) and (iii) applying *para* $H_2$ similarly (as applied for the calibration curve) . Hence, the invention further provides an (N)MR apparatus as defined herein, configured to have access to a database with analyte calibration curves for SABRE magnetic resonance. For instance, such database can be a remote database (such as "in the cloud") with calibration curves for a plurality of analytes.

In yet a further aspect, also a method for analyzing a plurality (n) of different complex samples with Signal Amplification By Reversible Exchange (SABRE) magnetic resonance is described, the method comprising: providing a plurality (n) of mixtures M1, M2, ..., Mn, wherein each mixture comprises a predefined part of one of the complex samples, a SABRE catalyst at a concentration $C_m$, and a co-substrate at a concentration $C_{co\text{-}sub}$, wherein $C_m < C_{co\text{-}sub}$; and applying *para* $H_2$ to the mixtures and measuring with magnetic resonance the magnetic resonance response of the mixtures; and comparing the magnetic resonance responses of the pluralities of mixtures for analysis.

It further surprisingly appears that in the presence of the co-substrate a given ligand should produce a SABRE signal that should be reproducible also in other mixtures, assuming all experimental parameters are kept constant. In other words, to a good approximation it should be possible to claim that the SABRE signal is no longer dependent on the sample composition, on the presence of other competitors, because the co-substrate dominates the interaction with the iridium complex (or other complex). Hence, the consequences can be important: 1) the comparison of the SABRE signals in two different mixtures (*e.g.* two different coffee samples), becomes meaningful. The stronger signal corresponds to a higher concentration. The ratio of the integrals corresponds to the ratio of the concentrations; 2) it should be possible to use only one calibration curve to quantitate one substrate (*e.g.* pyrazine) in all different samples of a similar type (*e.g.* different types of coffee); 3) it should be possible to use the SABRE spectra (of coffee for instance) to do chemometrics to classify different samples. In other words: when using a co-substrate, the SABRE integral of a given ligand is something we can use for absolute comparisons, not just for relative comparison within a standard addition series using almost identical mixtures. This is vital for several applications and allows to directly comparing SABRE spectra of different origin.

In an embodiment, the magnetic resonance (MR) measurement includes a nuclear magnetic resonance experiment. However, optionally the method may also be applied in imaging techniques. Further, multidimensional MR may also be included. Especially, the magnetic resonance measurement includes proton NMR.

The term "substantially" herein, such as in "substantially consists", will be understood by the person skilled in the art. The term "substantially" may also include embodiments with "entirely", "completely", "all", etc. Hence, in embodiments the adjective substantially may also be removed. Where applicable, the term "substantially" may also relate to 90% or higher, such as 95% or higher, especially 99% or higher, even more especially 99.5% or higher, including 100%. The term "comprise" includes also embodiments wherein the term "comprises" means "consists of'. The term "and/or" especially relates to one or more of the items mentioned before and after "and/or". For instance, a phrase "item 1 and/or item 2" and similar phrases may relate to one or more of item 1 and item 2. The term "comprising" may in an embodiment refer to "consisting of" but may in another embodiment also refer to "containing at least the defined species and optionally one or more other species".

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein. The devices herein are amongst others described during operation. As will be clear to the person skilled in the art, the invention is not limited to methods of operation or devices in operation. It should be noted that the above-mentioned

embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "to comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer.

EXPERIMENTAL

*Hyperpolarization outside the bore of the NMR apparatus*

SABRE was applied to a more complex mixture containing up to seventeen metal ligands at sub-millimolar concentrations. Further aspects are given below. Samples were prepared as follows. Complex precursor [Ir(COD)(IMes)Cl] (**1**) [IMes = 1,3-bis(2,4,6-trimethylphenyl)imidazole-2-ylidene; COD = cyclooctadiene] was dissolved in methanol-$d_4$ solutions containing seventeen substrates. The analytical concentrations of complex precursor ($C_M$) and total substrate ($sub_T$) were maintained constant at a **1**-to-$sub_T$ ratio of 1:20. This large excess of ligands with respect to the complex precursor **1** is important for the efficiency of SABRE. Similar **1**-$sub_T$ solutions, with one of the analytes at low micromolar concentration (obtained by gravimetric dilution), were used for the standard-addition experiments. Equal amounts of these were diluted with standard solutions with varying analyte concentrations to obtain samples for the standard-addition series.

Activation of complex precursor **1** by molecular hydrogen (5 bar) in the presence of this substrate mixture (N=17) leads to the formation of up to 2601 possible metal complexes of the formula $[Ir(IMes)(H)_2(sub_i)(sub_j)(sub_k)]Cl$ (**2**) (Fig. 4).

Enhanced NMR signals are detected when a 90° read-out pulse is applied shortly after dissolution of $p$-$H_2$ (5 bar) at a polarization transfer field (PTF) of ~ 6.5 mT. Increased signal intensity is observed in the aromatic region, as well as for the methyl groups of acetonitrile (*mecn*), dimethyl sulfoxide (*dmso*) and 1-methyl-1,2,3-triazole (*mtz*).

Note that only the signals of the ligands free in solution are observed in the NMR spectra, as the bound form is distributed over the thousands of different complexes, each with concentrations in the sub-micromolar range. Despite a comparable concentration in solution, large variation of signal integrals is found for different substrates. This is in contrast with the requirement of a standard quantitative NMR analysis, i.e. the linear dependence of signal integral ($I_x$) on concentration of corresponding nuclear spins ($N_x$):

$$I_x = k \cdot N_x \tag{5}$$

where the proportionality constant $k$ is assumed identical for all signals. Application of Equation (5) allows the determination of relative concentrations by comparison of the signal integrals from conventional NMR spectra. While the linear dependence of SABRE signals on concentration can be satisfied under suitable conditions, the efficiency of the hyperpolarization process (and, as a consequence, the value of $k$) is generally different for different spins, as clearly apparent in Fig. 6. This precludes a quantitative analysis of SABRE spectra based on signal comparison with an internal or external reference. Nevertheless, we will show here that this problem can be successfully circumvented using the so-called standard-addition method. By applying this technique we were able to determine the concentration of dilute components from SABRE spectra of a complex mixture. This method involves adding standard solutions of known analyte concentration to the mixture under investigation. A SABRE spectrum is acquired for the original mixture and for each solution obtained after standard addition. As long as all experimental parameters are kept constant during the establishment of the standard-addition curve, the signal integral of the analyte shows a linear dependence with respect to the amount of added analyte. The analyte concentration in the original mixture can then be estimated from the abscissa intercept of the standard-addition curve. By following this empirical approach it is therefore possible to neglect the exact form of the complex functional dependence of signal integrals in hyperpolarized spectra versus concentrations in solution.

In the case of SABRE it is important that the composition of the mixture is minimally perturbed by the standard-addition procedure, since signal enhancement factors are highly sensitive to the equilibrium between bound and free forms of the substrate. A constant free-to-bound ratio is necessary to obtain a linear dependence of SABRE signal on substrate concentration. In the present case, this condition limits the substrate concentration range that can be employed for the standard-addition curve (i.e. $C_{add} << sub_T$). We have tested the validity of the proposed approach on a dilute solution of nicotinamide (*na*) in the presence of 333 μM **1** and a sixteen component mixture giving a total substrate concentration of ~6.5 mM. The SABRE spectra for the original mixture and after additions of *na* ($C_{add}$ < 100 μM) are displayed in Fig. 7.

The corresponding linear plot is shown in Fig. 8A; the extrapolated value of the concentration of *na* is in good

agreement with its nominal concentration (8.5 μM). Similar results are obtained for the diluted substrates pyrazine *(pn),* isoxazole *(ix)* and quinazoline (*qz*) (Figs. 8B-D). Note the converging trend lines for the two *qz* resonances in Fig. 8D. This nicely confirms the validity of the standard-addition technique in combination with SABRE: two different slopes are obtained because the enhancement factors for these signals are different. Nevertheless, extrapolation of the two curves leads to the same concentration within experimental error.

Further aspects of experimental nanomolar detection by NMR through SABRE hyperpolarization is given below.

Unless stated otherwise, all experimental procedures were performed under an atmosphere of either nitrogen or argon using standard Schlenk line techniques or an MBraun Unilab glovebox. General solvents for synthetic chemistry were dried using an mBraun SPS 800 solvent purification system and were degassed prior to use. Pyridine (*py*), nicotine (*ni*), pyrazole (*pz*), and methanol-$d_4$ were obtained from Sigma-Aldrich, isoxazole *(ix)* was obtained from Janssen Pharmaceutica. All chemicals were used as supplied. $[Ir(COD)Cl]_2$ (COD = cyclooctadiene) was obtained from Strem Chemicals or Sigma-Aldrich. *p*-$H_2$ was produced by storing 4 bar of hydrogen gas at 77 K in the presence of activated charcoal for approximately 2 hours. The resulting 51% *p*-$H_2$ was transferred to a glass bulb with an output-pressure gauge. All [Ir(NHC)(COD)Cl] and 1-methyl-1,2,3-triazole *(mtz)* were prepared according to Kelly III, R. A. et al. Organometallics 2007, 27, 202 and Seefelf, M. A. et al. WO2008/098104 A1, August 14, 2008.

Metal complexes **2**$^+$, **3**$^+$, **4**$^+$ and **5**$^+$ are formed upon hydrogenation of the cyclooctadiene ligand of complex precursor **1.** Hydrogenation of **1** in the presence of an excess (≥ 10 fold) of substrate results in complex **2**$^+$. Lowering the substrate concentration leads to a decrease of complex **2**$^+$ and the concomitant formation of complex **3**$^+$, where presumably one substrate ligands is replaced by a solvent molecule. In the presence of an excess of co-substrate, complexes **4**$^+$ and **5**$^+$ are formed. At low substrate concentrations only complex **4**$^+$ will be present. Hydrogenation of complex precursor **6** in the presence of an excess of co-substrate and a trace amount of substrate results in complex **7**$^+$.

Note that Fig. 10 only displays the complexes that are responsible for the hyperpolarization of substrate molecules, i.e. where the substrate (here: *py*) is bound trans to the hydrides. Cis-bound substrate (here: *py*) is observed (e. g. complex **8**$^+$ in Fig. 26a), but does not contribute to substrate hyperpolarization

All NMR spectra were acquired at 298 K on a Bruker AVANCEIII Spectrometer operating at 600 MHz, proton resonance frequency, equipped with a cryo-cooled TCI probe. NMR samples with a total volume of 600 μL were prepared in 5 mm Wilmad quick pressure valve NMR tubes under an atmosphere of nitrogen. Complex precursor concentrations were typically 1 (**6**) or 2 (**1**) mM, while co-substrate and substrate concentrations varied dependent on the experiment. Previous to a SABRE experiment the volume above the solution was evacuated, after which *p*-$H_2$ was introduced at a pressure of 4 bar. Nuclear spin hyperpolarization was then obtained by shaking the sample for 10 seconds at a magnetic field strength between 80 and 130 Gauss in the stray field of the spectrometer, and rapidly inserting it into the bore. A 90° rf pulse was applied immediately after the sample rested in the spectrometer, which was approximately 8 seconds after insertion. A SABRE and a reference spectrum of a sample containing 2 mM **1,** 13 mM *mtz* and 1 mM *py* are shown in Fig. 11. SABRE spectra have poor line widths since a fraction of the solution is sinking along the interior of the NMR tube at the moment of data acquisition. The spectra were processed using an exponential window function with a line broadening of 2.5 Hz prior to zero-filling to 262144 data points.

Exchange rates were obtained by 1D EXSY experiments. A selective Gaussian inversion pulse (60 Hz bandwidth for a duration of 36 ms) was applied on the ortho (8.54 ppm) or meta proton signal (7.45 ppm) of free *py,* followed by a mixing period ranging from 10 milliseconds to 150 seconds, and a hard 90° read-out pulse. The integrals of free and bound *py* (ortho *py* in **4**$^+$: 8.73 ppm, meta *py* in **7**$^+$: 6.95 ppm) were then fitted with an exchange equation for two-site exchange with unequal populations and unequal relaxation rates.

All concentrations in solution were determined with respect to ethanol (10 mM) as internal standard.

The signal enhancement factors were calculated by dividing the signal integrals of the hyperpolarized sample by those of a thermally equilibrated reference spectrum. The reference spectrum was recorded for the same sample with identical experimental parameters three minutes after the SABRE experiment, to ensure full relaxation at high magnetic field. The signal enhancement factors obtained can be compared to previously reported values by taken into account the difference in magnetic field and *p*-$H_2$ enrichment. Signal-to-noise ratios were estimated by comparing the intensity of signals with the RMSD of a region of the spectrum without signals.

The formation of complex **3**$^+$ was monitored via the b-IMes proton signals (Fig. 12A). An exchange between complex **2**$^+$ and **3**$^+$ was confirmed in a 2D NOESY experiment via cross peaks between c- and d-IMes protons in both complexes (Fig. 12B&C). Formation of dissolved HD gas through interaction between deuterated methanol and dihydride or dihydrogen at the metal center was observed, as previously described by Gloggler et al. Chem. Chem. Phys. 2011, 13, 13759. HD concentrations increased concomitantly with complex **3**$^+$ concentrations. In addition, an increasing deuteration of the ortho position of *py* is observed for *py*-to-**1** ratios of 3.4:1 and lower. Comparable results were obtained for the metal centers **6** and Crabtree's Catalyst, together with several substrates.

Concentrations of free *py,* complex **2**$^+$ and complex **3**$^+$ were determined for samples containing 2 mM **1** together with 4 bar *p*-$H_2$ and increasing total py concentrations (8 to 33.4 mM, Fig. 13). The c-IMes signals of complex **2**$^+$ and complex **3**$^+$ were fitted for two-site exchange with unequal populations and unequal relaxation rates, resulting in a

dissociation constant of 1.7 (concentrations expressed in mM) and a $k_{off}$ rate of 27.7 $s^{-1}$. Note that this rate constant is different from the exchange rate between free and bound *py* in complex **2**$^+$.

$$\underset{\mathbf{2}[\mathrm{Cl}]}{[\mathrm{Ir(IMes)(H)_2(py)_3}]\mathrm{Cl}} + \mathrm{MeOH} \underset{}{\overset{K_{eq}=1.7,\; k_{off}=27.7\,s^{-1}}{\rightleftarrows}} \underset{\mathbf{3}[\mathrm{Cl}]}{[\mathrm{Ir(IMes)(H)_2(py)_2MeOH}]\mathrm{Cl}} + \mathrm{py}$$

The formation of complexes **4**$^+$ and **5**$^+$, with concomitant loss of complex **3**$^+$ upon addition of *mtz* co-substrate, is shown in Figs. 14a-b by means of the signals of ortho *py*. The reported spectral intensities are corrected for deuteration on ortho *py* by the following factors (for samples at increasing *mtz*-to-**1** ratio): 1.8, 1.4, 1.3, 1.2 and 1.1 (Fig. 14A). No deuteration was observed for samples at *mtz*-to-**1** ratios of 1.2 and higher (Fig. 14B), where complex **3**$^+$ was not present. Generally, the formation of co-substrate complexes occurs according to the equilibria below:

$$\underset{\mathbf{2}[\mathrm{Cl}]}{[\mathrm{Ir(IMes)(H)_2(sub)_3}]\mathrm{Cl}} + \text{co-sub} \rightleftarrows \underset{\mathbf{5}[\mathrm{Cl}]}{[\mathrm{Ir(IMes)(H)_2(sub)_2(co\text{-}sub)}]\mathrm{Cl}} + \mathrm{sub}$$

$$\underset{\mathbf{5}[\mathrm{Cl}]}{[\mathrm{Ir(IMes)(H)_2(sub)_2(co\text{-}sub)}]\mathrm{Cl}} + \text{co-sub} \rightleftarrows \underset{\mathbf{4}[\mathrm{Cl}]}{[\mathrm{Ir(IMes)(H)_2(sub)(co\text{-}sub)_2}]\mathrm{Cl}} + \mathrm{sub}$$

$$\underset{\mathbf{4}[\mathrm{Cl}]}{[\mathrm{Ir(IMes)(H)_2(sub)(co\text{-}sub)_2}]\mathrm{Cl}} + \text{co-sub} \rightleftarrows \underset{\mathbf{8}[\mathrm{Cl}]}{[\mathrm{Ir(IMes)(H)_2(co\text{-}sub)_3}]\mathrm{Cl}} + \mathrm{sub}$$

(the same equilibria apply for complex precursor **6**)

Concentrations of free *py,* free *mtz* and complexes **4**$^+$, **5**$^+$ and **8**$^+$ (**8**[Cl] = [Ir(IMes$(H)_2$(co-substrate$)_3$]Cl) were determined for samples containing 2 mM **1** and 4 mM *py* together with 4 bar *p*-$H_2$ and increasing total *mtz* concentrations (2.4 to 7.4 mM). The c-IMes signals of complexes **4**$^+$, **5**$^+$ and **8**$^+$ were fitted, resulting in an $K_{eq}$ of 0.09 for the latter of these three equilibria, also see below:

$$\underset{\mathbf{4}[\mathrm{Cl}]}{[\mathrm{Ir(IMes)(H)_2(py)(mtz)_2}]\mathrm{Cl}} + \mathrm{mtz} \overset{K_{eq}=0.09}{\rightleftarrows} \underset{\mathbf{8}[\mathrm{Cl}]}{[\mathrm{Ir(IMes)(H)_2(mtz)_3}]\mathrm{Cl}} + \mathrm{py}$$

Detection trace amounts of nicotine (*ni*), pyrazole (*pz*), and isoxazole (*ix*) are given in Figs. 15A-15F.

A coffee extract SABRE spectrum shows the enhanced signals of various pyrazine derivatives, including pyrazine (*pn*), 2-methylpyrazine (*mpn*) and 2,6-dimethylpyrazine (*dmpn*) (Fig. 16). Concentrations of these pyrazines are in the order of a few tens of micromolar and are also detected in a conventional 64-scan NMR spectrum. Smaller SABRE signals from unknown compounds, some presumably in the sub-micromolar concentration regime, are not detected in the 64-scan spectrum (inset Fig. 16).

Standard addition experiments using complex precursor [Ir(COD)(IPr)Cl] (1.2 mM) and co-substrate 1,2,3-methyltriazole (18 mM) for the quantification of pyrazine (*pn*), 2-methylpyrazine (*mpn*), and 2,6-dimethylpyrazine in similar coffee extracts are shown in Fig. 17 to 22. Three different counter ions have been tested for their influence on *py* signal enhancements with [Ir(SIMes)$(H)_2$(*py*$)_3$]$^+$: [Cl]$^-$, $[BF_4]^-$, and $[BAr^F{}_4]^-$ (Table 9):

**Table 9.** Data obtained on a 200 MHz Bruker Avance spectrometer using approximately 92.5 % *p*-$H_2$ (from a Bruker *p*-$H_2$ generator (BPHG90)), while sample polarization and transport was controlled by means of a prototype Bruker polarizer (BPHP) at different polarization transfer fields (PTF). The Cl-counter ion gave the best results in the measurements.

| polarization transfer field | SImes[$BAr^F_4$] | SIMes[$BF_4$] | SIMes[Cl] |
|---|---|---|---|
| 10 | 89,36782 | 49,4382 | 214,3229 |
| 0 | 170,977 | 96,17978 | 262,7604 |
| -10 | 285,9195 | 192,1348 | 394,5313 |
| -20 | 436,2069 | 275,2809 | 544,7917 |
| -30 | 582,1839 | 415,7303 | 585,1563 |
| -40 | 703,1609 | 514,382 | 708,0729 |
| -50 | 818,6782 | 595,9551 | 766,6667 |
| -60 | 904,3103 | 653,2584 | 868,4896 |
| -70 | 926,1494 | 750,7865 | 911,9792 |
| -80 | 1002,299 | 766,9663 | 975,2604 |
| -90 | 1039,943 | 788,3146 | 1053,646 |
| -100 | 997,4138 | 838,427 | 1061,198 |
| -110 | 973,2759 | 843,5955 | 1102,604 |
| -120 | 902,8736 | 859,3258 | 1081,51 |
| -130 | 864,0805 | 782,4719 | 1098,958 |
| -140 | 792,5287 | 795,9551 | 978,6458 |
| -150 | 727,2989 | 755,2809 | 980,2083 |
| -160 | 661,7816 | 715,2809 | 906,25 |
| -170 | 603,1609 | 647,8652 | 816,4063 |
| -180 | 556,0345 | 622,6966 | 742,1875 |
| -190 | 501,1494 | | |
| -200 | 472,4138 | | |
| -210 | 448,5632 | | |
| -220 | 398,2759 | | |
| -230 | 372,7011 | | |

Above, seven different co-substrates have been depicted: 1-methyl-1,2,3-triazole, 1-ethyl-1,2,3-triazole, dideuterium-1-methyl-1,2,3-triazole, dibromo-1-methyl-1,2,3-triazole, 1-methyl-1,2,3-benzotriazole, 1-((1,3-dioxolan-2-yl)methyl)-4,5-dideuterium-1,2,3-triazole, and 4,5-dideuterium-1-(2-(2-methoxyethoxy)ethyl)-1,2,3-triazole. These co-substrates were successfully tested with trace amounts of analytes. Due to the deuterium (a first synthesis already resulted in -75% and 87% deuteration of positions 4 and 5 on the triazole ring) on 1-((1,3-dioxolan-2-yl)methyl)-4,5-dideuterium-1,2,3-triazole this co-substrate will not show any aromatic signals (>5.2 ppm), allowing the detection of signals that would otherwise be undetectable due to overlap with the large (hyperpolarized) co-substrate signals (*e.g. mtz* signals in Fig. 16). Especially, 1,2,3-triazole-like co-substrates that are deuterated on the 4 and 5 position to prevent enhanced proton NMR signals of the co-substrate in the aromatic region, that would overlap with the signals of the substrate, may be selected. Especially, the (non deuterated) co-substrates 1,5-dimethyltetrazole and 5-methyl-1H-tetrazole may be selected, especially because they do not show (hyperpolarized) aromatic proton signals, precluding the need to incorporate a deuterium in the molecule.

In some of the NMR measurements, after addition of *para*-$H_2$ to the probe, the sample was manually shaken in the magnetic field, at about 65 Gauss (6.5 mT), parallel to the magnetic field lines.

*Hyperpolarization inside the NMR apparatus*

Experiments have been performed focusing on hyperpolarizing components of urine. Solid phase extraction (SPE) and High Field Hyperpolarization are described below.

In a further embodiment of the invention components of urine can be hyperpolarized, detected and quantified in a manner similar to complex mixtures and coffee extracts. However, urine is a noticeably more complex system, consisting of more than 3000 low molecular weight metabolites [Urinary metabolite database: Bouatra S, Aziat F, Mandal R, Guo AC, Wilson MR, et al. (2013) The Human Urine Metabolome. PLoS ONE 8(9): e73076.], organic and inorganic salts, proteins, etc. The effect of these components on the performance of SABRE catalysts is unknown and is likely to be detrimental. Moreover, urine is an aqueous solution, and none of the successful SABRE catalysts known in the art are sufficiently soluble in water or provide sufficient enhancements in aqueous environments.

This requires the development of a sample preparation method that will a) enrich the sample in components of interest (most likely low MW metabolites), b) remove potentially interfering proteins, c) remove salts, and d) exchange solvent from water to a SABRE compatible medium like methanol or chloroform. In the present embodiment these goals are achieved by a simple solid phase extraction (SPE) protocol comprising the following steps: 1. Urine collection from patients according to common techniques known in the art; 2. Urine was divided into 12 ml aliquots, frozen and stored at -20 °C; 3. Prior to analysis, urine is thawed over a room temperature water bath; 4. The pH of the urine sample is adjusted to 7.5 by a careful addition of 1 M aqueous NaOH solution; 5. Urine is centrifuged at room temperature at 3270 RCF for 20 min to precipitate the most abundant proteins that would block the SPE cartridge or be otherwise detrimental to the sample preparation; 6. When necessary, urine may be gravimetrically spiked with necessary analytes or internal standards at this stage; 7. The SPE cartridge (Waters Oasis HLB, 6 cc, 200 mg) is conditioned with 3 ml of methanol; 8. The SPE cartridge is equilibrated with 3 ml of MilliQ water; 9. 5 ml of urine, treated according to steps 1-6, is pipetted into the SPE cartridge; 10. The urine sample is eluted through the cartridge by positive air pressure from above the cartridge, applied by a digitally controlled syringe pump, with a sample flow rate of 1 ml/min. Flow is maintained until all liquid has passed through the SPE cartridge; 11. The SPE cartridge is washed with 3 ml of MilliQ water at a flow rate of 1 ml/min, applied by the method of step 10; 12. The SPE cartridge is dried by maintaining a 2 l/min flow of nitrogen through the cartridge for 30 min; 13. The sample is extracted from the dried SPE cartridge by passing 1.1 mL of deuterated methanol ($CD_3OD$) through the cartridge at 1 ml/min. This will yield approx. 0.7 mL of sample that can be used in NMR experiments without further treatment or manipulation; 14. The successive combination of steps 1-13 enriches the urine extract in compounds that are good SABRE substrates. These compounds include, but are not limited to, nicotinamide and nicotinamide derivatives.

Urine extracts prepared by the SPE method above can also be subjected to the high field hyperpolarization method described herein. Especially when applying high field hyperpolarization, freeze-pump thaw degassing of extracts is not necessary for high field hyperpolarization. When a urine sample is mixed with iMes-MTz catalyst mixture in a 3-1 ratio, 2D NMR spectra displaying the correlation of hydride signals to aromatic signals can be measured. Compound identification and quantification can be achieved by the spiking methods described therein. As an example, high field hyperpolarization of urine components was applied for the detection and quantification of Nikethamide and N-ethylnicotinamide. Since the respective hydride signals of the IMes-MTz complexes of all these 3 compounds overlap, there is no benefit to using 2D NMR spectroscopy. Instead the same pulse sequence was applied in 1D manner, cutting the experimental time down to 4 min 15 s. To simplify the spectrum and to excite only the components of interest, 175 Hz wide Eburp2 excitation pulse was used in the hydride region (Fig. 32) and a 1D spectrum was detected in the aromatic region (Fig. 33). This allows detecting and quantifying Nicotinamide, Nikethamide and N-ethylnicotinamide simultaneously with each of the compounds giving one peak that does not overlap with other compounds of interest or the endogenic background.

This method can be used not only for the detection of the drug and its metabolite, but also for quantification according to the methods described herein. When urine is spiked to 1 μM of Nikethamide and 1 μM of N-ethylnicotinamide and subjected to the SPE procedure, in one embodiment quantification was achieved by the standard addition method, allowing for simultaneous detection and quantification of both the drug and its metabolite in the sample, establishing their experimental values to be 1.0 and 1.3 μM, respectively, in the initial spiked urine samples. This approach assumes that the SPE recovery of both compounds is either known or can be experimentally established, in order to be able to relate the NMR determined NMR sample concentration to the analyte concentration in the initial urine.

In a different embodiment calibration was achieved by spiking a series of identical urine samples to increasing concentrations of Nikethamide and N-ethylnicotinamide (in a series of 0.5, 2.0, 5.0, 10.0 and 25.0 μM of both analytes in urine) before subjecting the urines to SPE. When the resulting urine extracts were subjected to high field hyperpolarization NMR analysis in a 1D experiment, a clear linear concentration to signal integral relation emerged, having a linear fit with an $R^2$ equal to 0.9894 and 0.9915 respectively for Nikethamide and N-ethylnicotinamide. This may in some applications be the preferred way of signal calibration since SPE recoveries of analytes do not have to be separately determined. Being able to detect and quantify Nikethamide at 0.5 μM (below 100 ng/mL) in urine suggests that this

method satisfies the WADA requirements for the analysis of stimulants in human urine.

In Fig. 24 schematically an embodiment of a dedicated MR apparatus 1 is given. The MR apparatus comprises an MR system 1 with a magnet 100, a control unit 300 and an analyses unit 400 these units may be provided separately or incorporated in one unit. It further comprises a sample preparations unit 700 in which the analyte 710, the co-substrate 720 and the catalyst 730 may be provided based on manual input via the control unit 300 or based on, *e.g.,* data in a remote database 500. The sample as prepared in the sample preparation unit 700 is provided with *p*-$H_2$ from the *para*-$H_2$ dosage unit 600 in the mixing chamber 200. A *para*-$H_2$ generator unit 650 may be in fluid connection with the *p*-$H_2$ dosage unit 600 or it may be present remotely. Moreover, *p*-$H_2$ may also be provided to the *para*-$H_2$-dosage unit using storage alternatives, like gas cylinders. In the mixing chamber 200, the sample prepared in the sample preparation unit 700 is saturated with *p*-$H_2$ while at the same time or sequentially the metal complex is activated by the magnetic field inside the mixing chamber, excited by the magnetic coil 210 and, if present, by the stray field of the MR system with magnet 100. The magnetic field parameters inside the mixing chamber, like direction and strength of the magnetic field are predetermined and may be controlled by the control unit 300. In the mixing chamber, mixing may be induced, *e.g.,* by bubbling the *p*-$H_2$ trough the sample, by mechanical agitation, by vibration, etc..

Transport of the prepared sample to the mixing unit 200, transport of *p*-$H_2$ to the mixing unit 200, and transport of the activated samples from the mixing unit 200 to the MR system 100 can be controlled by a probe transport system 800 and may be accomplished by means of transport lines 150, such as transport tubes, such as e.g. capillary, like pictured in Figs. 23a-23b. The *p*-$H_2$ unit and the sample preparation unit are connected to the transport lines 150, such as tubes, respectively by the *p*-$H_2$ connection tube 601 and the sample connection tube 701. Since also other transport systems are feasible, *e.g.,* small transport belts systems, the tubes or lines 150, 601, 701 are only given by example and may be replaced by other transport means in other embodiments. As indicated above, .e.g. tube 601 may also end within the mixing chamber 200. Note that one or more of the herein indicated units may also be provided as integrated units or single units having more than one functionality.

## Claims

1. A method for the detection with Signal Amplification By Reversible Exchange (SABRE) magnetic resonance of an analyte at an unknown concentration $C_{sub}$ in a complex sample comprising a solvent, wherein the complex sample comprises a sample selected from the group consisting of a biological sample extracted from a human, a biological sample extracted from an animal, a fresh food product, a processed food product, a fresh feed material, and a processed feed material, the method comprising: (a) providing a series of mixtures M1, M2, ..., Mn, wherein each mixture comprises a predefined part of the complex sample comprising the analyte, a SABRE catalyst at a concentration $C_m$, and a co-substrate at a concentration $C_{co\text{-}sub}$, wherein $C_{sub} << C_m < C_{co\text{-}sub}$, and wherein two or more of the mixtures are provided with a known concentration of added analyte for standard addition determination of the unknown concentration $C_{sub}$ of said analyte; and (b) applying *p*-$H_2$ (*para*-$H_2$) to the mixtures inside an MR apparatus at a magnetic field flux density in the range of 1-50 T, and measuring in said MR apparatus with nuclear magnetic resonance the magnetic resonance response of the mixtures at a magnetic flux density in the range of 1-50 T, and determining from the magnetic resonance response of the series of mixtures the unknown concentration $C_{sub}$ of the analyte.

2. The method according to claim 1, wherein *para*-$H_2$ is applied to the mixture in a magnetic field comprising a magnetic field flux density selected in the range of 1-30 T, and measuring with nuclear magnetic resonance with a magnetic field flux density selected in the range of 1-30 T the magnetic resonance response of the mixtures.

3. The method according to any of the preceding claims, wherein said *p*-$H_2$ is applied in a *p*-$H_2$ application stage, the method further comprising repeating the stage of applying *p*-$H_2$ to the mixtures and measuring with 2 dimensional nuclear magnetic resonance the magnetic resonance response of the mixtures, and determining the unknown concentration $C_{sub}$ of the analyte from the 2 dimensional magnetic resonance response of the series of mixtures.

4. The method according to claims 3, the method further comprising simultaneously determining the unknown concentration $C_{sub}$ of a plurality of analytes.

5. The method according to any of the preceding claims, wherein the affinity of the solvent for binding with the SABRE catalyst << the affinity of the co-substrate for binding with the SABRE catalyst ≤ the affinity of the analyte for binding with the SABRE catalyst.

6. The method according to claim any of the preceding claims, wherein $C_m / C_{sub} \geq 10$, and wherein $C_{co\text{-}sub} / C_m \geq 3$.

7. The method according to any one of the preceding claims, wherein n is at least 5 and wherein one of the mixtures does not include added analyte.

8. The method according to any one of the preceding claims, comprising providing a first mixture M1, applying hyperpolarizing *p*-$H_2$ (*para*-$H_2$) to the mixture and measuring with nuclear magnetic resonance the magnetic resonance response of the mixture, adding analyte to the first mixture M1 to generate a next mixture and applying *p*-$H_2$ to the mixture and measuring with nuclear magnetic resonance the magnetic resonance response of the mixture, and repeating one or more times the stages of adding analyte to the previously measured mixture and applying *p*-$H_2$ to the mixture and measuring with nuclear magnetic resonance the magnetic resonance response of the mixture, followed by determining from the magnetic resonance response of the series of mixtures the unknown concentration of the analyte.

9. The method according to any one of the preceding claims, wherein the co-substrate comprises one or more co-substrates selected form the group consisting of 1-methyl-1,2,3-triazole, 1-ethyl-1,2,3-triazole, dideuterium-1-methyl-1,2,3-triazole, dibromo-1-methyl-1,2,3-triazole, 1-methyl-1,2,3-benzotriazole, 1-((1,3-dioxolan-2-yl)methyl)-4,5-dideuterium-1,2,3-triazole, 1H-1,2,3-triazole, 4,5-dideuterium-1-(2-(2-methoxyethoxy)ethyl)-1,2,3-triazole, 5-methyl-1H-tetrazole, 1,5-dimethyltetrazole, 1-(4-methoxybenzyl)-4,5-deuterium-1,2,3-triazole, 1,5-dimethyl-1,2,3-triazole, 1,4-dimethyl-1,2,3-triazole, and 4,5-deuterium-1-((perfluorzophenyl)methyl)-1,2,3-triazole.

10. The method according to any one of the preceding claims, wherein the co-substrate comprises 1-methyl-1,2,3-triazole.

11. The method according to any one of the preceding claims, wherein the complex sample comprises a biological sample selected from the group consisting of human tissue, blood, urine, and saliva.

12. A method for the detection with SABRE magnetic resonance of an analyte at an unknown concentration $C_{sub}$ in a complex sample, wherein the complex sample comprises a sample selected from the group consisting of a biological sample extracted from a human, a biological sample extracted from an animal, a fresh food product, a processed food product, a fresh feed material, and a processed feed material, the method comprising: (a) providing a mixture comprising a predefined part of the complex sample comprising the analyte, a SABRE catalyst at a concentration $C_m$, and a co-substrate at a concentration $C_{co\text{-}sub}$, wherein $C_{sub} < <C_m < C_{co\text{-}sub}$; (b) applying *p*-$H_2$ (*para* $H_2$) to the mixture and measuring with nuclear magnetic resonance the magnetic resonance response of the mixture; wherein *para*-$H_2$ is applied to the mixture inside an MR at a magnetic field flux density in the range of 1-50 T, and wherein measuring in said MR apparatus with nuclear magnetic resonance with a magnetic field flux density in the range of 1-50 T the magnetic resonance response of the mixtures; and determining from the magnetic resonance response and a calibration curve for the analyte the unknown concentration of the analyte.

13. The method according to claim 12, wherein *para*-$H_2$ is applied to the mixture in a magnetic field comprising a magnetic field flux density selected in the range of 1-30 T, and measuring with nuclear magnetic resonance with a magnetic field flux density selected in the range of 1-30 T the magnetic resonance response of the mixtures.

14. The method according to any of the claims 12-13, further using specific conditions selected from (i) using the same catalyst as used for the calibration curve, (ii) using the same co-substrate as used for the calibration curve, and (iii) applying *para*-$H_2$ similarly as applied for the calibration curve.

**Patentansprüche**

1. Verfahren zur Erfassung eines Analyten bei einer unbekannten Konzentration $C_{sub}$ in einer komplexen Probe, die ein Lösemittel umfasst, mit Signalverstärkung durch umkehrbaren Austausch (SABRE, Signal Amplification By Reversible Exchange) Magnetresonanz, wobei die komplexe Probe eine Probe umfasst, ausgewählt aus der Gruppe, bestehend aus einer biologischen Probe, die einem Menschen entnommen ist, einer biologischen Probe, die einem Tier entnommen ist, einem frischen Speiseprodukt, einem verarbeiteten Speiseprodukt, einem frischen Futtermaterial und einem verarbeiteten Futtermaterial, das Verfahren umfassend: (a) Bereitstellen einer Serie von Gemischen M1, M2,..., Mn, wobei jedes Gemisch einen vordefinierten Teil der komplexen Probe, die den Analyten umfasst, einen SABRE-Katalysator bei einer Konzentration $C_m$ und ein Cosubstrat bei einer Konzentration $C_{co\text{-}sub}$ umfasst, wobei $C_{sub}<<C_m<C_{co\text{-}sub}$, und wobei zwei oder mehr der Gemische mit einer bekannten Konzentration an zugefügtem Analyten zur Standardadditionsermittlung der bekannten Konzentration $C_{sub}$ des Analyten bereitgestellt sind;

und (b) Anwenden von *p*-Hz (*para*-$H_2$) auf die Gemische innerhalb einer MR-Vorrichtung bei einer Magnetfeldflussdichte im Bereich von 1-50 T und Messen in der MR-Vorrichtung mit Kernmagnetresonanz die Magnetresonanzantwort der Gemische bei einer Magnetfeldflussdichte im Bereich von 1-50 T, und Ermitteln der unbekannten Konzentration $C_{sub}$ des Analyten aus der Magnetresonanzantwort der Serie von Gemischen.

**2.** Verfahren nach Anspruch 1, wobei *para*-$H_2$ auf das Gemisch in einem Magnetfeld angewendet wird, das eine Magnetfeldflussdichte umfasst, die im Bereich von 1-30 T ausgewählt ist, und Messen der Magnetresonanzantwort der Gemische mit Kernmagnetresonanz mit einer Magnetfeldflussdichte, die im Bereich von 1-30 T ausgewählt ist.

**3.** Verfahren nach einem der vorstehenden Ansprüche, wobei das *p*-$H_2$ in einer *p*-$H_2$-Anwendungsstufe angewendet wird, das Verfahren weiter umfassend Wiederholen der Stufe vom Anwenden von *p*-$H_2$ auf die Gemische und Messen mit zweidimensionaler Kernmagnetresonanz der Magnetresonanzantwort der Gemische und Ermitteln der unbekannten Konzentration $C_{sub}$ des Analyten aus der zweidimensionalen Magnetresonanzantwort der Serie von Gemischen.

**4.** Verfahren nach Anspruch 3, das Verfahren weiter umfassend gleichzeitiges Ermitteln der unbekannten Konzentration $C_{sub}$ einer Vielzahl von Analyten.

**5.** Verfahren nach einem der vorstehenden Ansprüche, wobei die Affinität des Lösemittels zum Binden mit dem SABRE-Katalysator << der Affinität des Cosubstrats zum Binden mit dem SABRE-Katalysator ≤ der Affinität des Analyten zum Binden mit dem SABRE-Katalysator ist.

**6.** Verfahren nach einem der vorstehenden Ansprüche, wobei $C_m/C_{sub} \geq 10$ und wobei $C_{co\text{-}sub}/C_m \geq 3$ ist.

**7.** Verfahren nach einem der vorstehenden Ansprüche, wobei n mindestens 5 ist und wobei eines der Gemische keinen zugefügten Analyten enthält.

**8.** Verfahren nach einem der vorstehenden Ansprüche, umfassend Bereitstellen eines ersten Gemisches M1, Anwenden von hyperpolarisierendem *p*-$H_2$ (*para*-$H_2$) auf das Gemisch und Messen der Magnetresonanzantwort des Gemisches mit Kernmagnetresonanz, Hinzufügen von Analyten zum ersten Gemisch M1, um ein nächstes Gemisch zu erzeugen, und Anwenden von *p*-$H_2$ auf das Gemisch und Messen der Magnetresonanzantwort des Gemisches mit Kernmagnetresonanz, und Wiederholen ein oder mehrere Male der Stufen von Hinzufügen von Analyten zum zuvor gemessenen Gemisch und Anwenden von *p*-$H_2$ auf das Gemisch und Messen der Magnetresonanzantwort des Gemisches mit Kernmagnetresonanz, gefolgt von Ermitteln der unbekannten Konzentration des Analyten aus der Magnetresonanzantwort der Serie von Gemischen.

**9.** Verfahren nach einem der vorstehenden Ansprüche, wobei das Cosubstrat ein oder mehrere Cosubstrate umfasst, ausgewählt aus der Gruppe, bestehend aus 1-Methyl-1,2,3-triazol, 1-Ethyl-1,2,3-triazol, Dideuterium-1-methyl-1,2,3-triazol, Dibrom-1-methyl-1,2,3-triazol, 1-Methyl-1,2,3-benzotriazol, 1-((1,3-dioxolan-2-yl)methyl)-4,5-dideuterium-1,2,3-triazol, 1H-1,2,3-Triazol, 4,5-Dideuterium-1-(2-(2-methoxyethoxy)ethyl)-1,2,3-triazol, 5-Methyl-1H-tetrazol, 1,5-Dimethyletrazol, 1-(4-Methoxybenzyl)-4,5-deuterium-1,2,3-triazol, 1,5-Dimethyl-1,2,3-triazol, 1,4-Dimethyl-1,2,3-triazol und 4,5-Deuterium-1-((perfluorzophenyl)methyl)-1,2,3-triazol.

**10.** Verfahren nach einem der vorstehenden Ansprüche, wobei das Cosubstrat 1-Methyl-1,2,3-triazol umfasst.

**11.** Verfahren nach einem der vorstehenden Ansprüche, wobei die komplexe Probe eine biologische Probe umfasst, ausgewählt aus der Gruppe, bestehend aus menschlichem Gewebe, Blut, Urin und Speichel.

**12.** Verfahren für die Erfassung mit SABRE-Magnetresonanz eines Analyten bei einer unbekannten Konzentration $C_{sub}$ in einer komplexen Probe, wobei die komplexe Probe eine Probe umfasst, ausgewählt aus der Gruppe, bestehend aus einer biologischen Probe, die einem Menschen entnommen ist, einer biologischen Probe, die einem Tier entnommen ist, einem frischen Speiseprodukt, einem verarbeiteten Speiseprodukt, einem frischen Futtermaterial und einem verarbeiteten Futtermaterial, das Verfahren umfassend: (a) Bereitstellen eines Gemisches, umfassend einen vordefinierten Teil der komplexen Probe, umfassend den Analyten, einen SABRE-Katalysator bei einer Konzentration $C_m$ und ein Cosubstrat bei einer Konzentration $C_{co\text{-}sub}$, wobei $C_{sub} \ll C_m < C_{co\text{-}sub}$; (b) Anwenden von *p*-$H_2$ (*para* $H_2$) auf das Gemisch und Messen der Magnetresonanzantwort des Gemisches mit Kernmagnetresonanz; wobei *para*-$H_2$ auf das Gemisch innerhalb einer MR bei einer Magnetfeldflussdichte im Bereich von 1-50T angewendet wird und wobei in der MR-Vorrichtung mit Kernmagnetresonanz mit einer Magnetfeldflussdichte im Bereich von

1-50 T die Magnetresonanzantwort der Gemische gemessen wird; und die unbekannte Konzentration des Analyten aus der Magnetresonanzantwort und einer Kalibrierungskurve für den Analyten ermittelt wird.

**13.** Verfahren nach Anspruch 12, wobei *para*-$H_2$ auf das Gemisch in einem Magnetfeld angewendet wird, umfassend eine Magnetfeldflussdichte, die im Bereich von 1-30 T ausgewählt ist, und Messen der Magnetresonanzantwort der Gemische mit Kernmagnetresonanz mit einer Magnetfeldflussdichte, ausgewählt im Bereich von 1-30 T.

**14.** Verfahren nach einem der Ansprüche 12-13, weiter Verwenden spezifischer Bedingungen, ausgewählt aus (i) Verwenden desselben Katalysators, wie er für die Kalibrierungskurve verwendet wird, (ii) Verwenden desselben Cosubstrats, wie es für die Kalibrierungskurve verwendet wird, und (iii) Anwenden von *para*-$H_2$, ähnlich wie es für die Kalibrierungskurve angewendet wird.

## Revendications

**1.** Procédé pour la détection avec la résonance magnétique à amplification de signal par échange réversible (SABRE) d'un analyte à une concentration inconnue $C_{sub}$ dans un échantillon complexe comprenant un solvant, dans lequel l'échantillon complexe comprend un échantillon sélectionné à partir du groupe constitué par un échantillon biologique extrait à partir d'un humain, un échantillon biologique extrait à partir d'un animal, un produit alimentaire frais, un produit alimentaire transformé, une matière d'alimentation fraîche, et une matière d'alimentation traitée, le procédé comprenant : (a) la fourniture d'une série de mélanges M1, M2, ..., Mn, dans lequel chaque mélange comprend une partie prédéfinie de l'échantillon complexe comprenant l'analyte, un catalyseur SABRE à une concentration $C_m$, et un co-substrat à une concentration $C_{co\text{-}sub}$, dans lequel $C_{sub} << C_m < C_{co\text{-}sub}$, et dans lequel deux ou plus de deux des mélanges sont fournis avec une concentration connue en analyte ajouté à des fins de détermination par ajout d'étalon de la concentration inconnue $C_{sub}$ dudit analyte ; et (b) l'application de *p*-$H_2$ (*para*-$H_2$) aux mélanges à l'intérieur d'un appareil RM à une densité de flux de champ magnétique dans la plage allant de 1 à 50 T, et la mesure dans ledit appareil RM avec une résonance magnétique nucléaire de la réponse de résonance magnétique des mélanges à une densité de flux magnétique dans la plage de 1 à 50 T, et la détermination à partir de la réponse de résonance magnétique de la série de mélanges de la concentration inconnue $C_{sub}$ de l'analyte.

**2.** Procédé selon la revendication 1, dans lequel *para*-$H_2$ est appliqué au mélange dans un champ magnétique comprenant une densité de flux de champ magnétique sélectionnée dans la plage allant de 1 à 30 T, et la mesure avec une résonance magnétique nucléaire avec une densité de flux de champ magnétique sélectionnée dans la plage allant de 1 à 30 T de la réponse de résonance magnétique des mélanges.

**3.** Procédé selon l'une quelconque des revendications précédentes, dans lequel ledit *p*-$H_2$ est appliqué dans une étape d'application de *p*-$H_2$, le procédé comprenant en outre la répétition de l'étape d'application de *p*-$H_2$ aux mélanges et la mesure avec une résonance magnétique nucléaire bidimensionnelle de la réponse de résonance magnétique des mélanges, et la détermination de la concentration inconnue $C_{sub}$ de l'analyte à partir de la réponse de résonance magnétique bidimensionnelle de la série de mélanges.

**4.** Procédé selon la revendication 3, le procédé comprenant en outre la détermination simultanée de la concentration inconnue $C_{sub}$ d'une pluralité d'analytes.

**5.** Procédé selon l'une quelconque des revendications précédentes, dans lequel l'affinité du solvant pour une liaison au catalyseur SABRE << l'affinité du co-substrat pour une liaison au catalyseur SABRE ≤ l'affinité de l'analyte pour une liaison au catalyseur SABRE.

**6.** Procédé selon l'une quelconque des revendications précédentes, dans lequel $C_m/C_{sub} \geq 10$, et dans lequel $C_{co\text{-}sub}/C_m \geq 3$.

**7.** Procédé selon l'une quelconque des revendications précédentes, dans lequel n est au moins 5 et dans lequel l'un des mélanges n'inclut pas d'analyte ajouté.

**8.** Procédé selon l'une quelconque des revendications précédentes, comprenant la fourniture d'un premier mélange M1, l'application d'une hyperpolarisation *p*-$H_2$ (*para*-$H_2$) au mélange et la mesure avec une résonance magnétique nucléaire de la réponse de résonance magnétique du mélange, l'ajout d'un analyte au premier mélange M1 pour générer un mélange suivant et l'application de *p*-$H_2$ au mélange et la mesure avec une résonance magnétique

nucléaire de la réponse de résonance magnétique du mélange, et la répétition une ou plusieurs fois des étapes d'ajout d'analyte au mélange précédemment mesuré et d'application de $p$-$H_2$ au mélange et de mesure avec une résonance magnétique nucléaire de la réponse de résonance magnétique du mélange, suivi de la détermination à partir de la réponse de résonance magnétique de la série de mélange de la concentration inconnue de l'analyte.

**9.** Procédé selon l'une quelconque des revendications précédentes, dans lequel le co-substrat comprend un ou plusieurs co-substrats sélectionnés à partir du groupe constitué par le 1-méthyl-1,2,3-triazole, le 1-éthyl-1,2,3-triazole, le dideutérium-1-méthyl-1,2,3-triazole, le dibromo-1-méthyl-1,2,3-triazole, le 1-méthyl-1,2,3-benzotriazole, le 1-((1,3-dioxolan-2-yl)méthyl)-4,5-dideutérium-1,2,3-triazole, le 1H-1,2,3-triazole, le 4,5-dideutérium-1-(2-(2-méthoxyéthoxy)éthyl)-1,2,3-triazole, le 5-méthyl-1H-tétrazole, le 1,5-diméthyltétrazole, le 1-(4-méthoxybenzyl)-4,5-deutérium-1,2,3-triazole, le 1,5-diméthyl-1,2,3-triazole, le 1,4-diméthyl-1,2,3-triazole, et le 4,5-deutérium-1-((perfluorophényl)méthyl)-1,2,3-triazole.

**10.** Procédé selon l'une quelconque des revendications précédentes, dans lequel le co-substrat comprend le 1-méthyl-1,2,3-triazole.

**11.** Procédé selon l'une quelconque des revendications précédentes, dans lequel l'échantillon complexe comprend un échantillon biologique sélectionné à partir du groupe constitué par un tissu humain, le sang, l'urine, et la salive.

**12.** Procédé pour la détection avec la résonance magnétique SABRE d'un analyte à une concentration inconnue $C_{sub}$ dans un échantillon complexe, dans lequel l'échantillon complexe comprend un échantillon sélectionné à partir du groupe constitué par un échantillon biologique extrait à partir d'un humain, un échantillon biologique extrait à partir d'un animal, un produit alimentaire frais, un produit alimentaire transformé, une matière d'alimentation fraîche, et une matière d'alimentation traitée, le procédé comprenant : (a) la fourniture d'un mélange comprenant une partie prédéfinie de l'échantillon complexe comprenant l'analyte, un catalyseur SABRE à une concentration $C_m$, et un co-substrat à une concentration $C_{co\text{-}sub}$, dans lequel $C_{sub} << C_m < C_{co\text{-}sub}$ ; (b) l'application de $p$-$H_2$ (*para*-$H_2$) au mélange et la mesure avec une résonance magnétique nucléaire de la réponse de résonance magnétique du mélange ; dans lequel *para*-$H_2$ est appliqué au mélange intérieur d'une RM à une densité de flux de champ magnétique dans la plage allant de 1 à 50 T, et dans lequel la mesure dans ledit appareil RM avec une résonance magnétique nucléaire avec une densité de flux de champ magnétique dans la plage allant de 1 à 50 T de la réponse de résonance magnétique des mélanges ; et la détermination à partir de la réponse de résonance magnétique et d'une courbe d'étalonnage pour l'analyte de la concentration inconnue de l'analyte.

**13.** Procédé selon la revendication 12, dans lequel *para*-$H_2$ est appliqué au mélange dans un champ magnétique comprenant une densité de flux de champ magnétique sélectionnée dans la plage allant de 1 à 30 T, et la mesure avec une résonance magnétique nucléaire avec une densité de flux de champ magnétique sélectionnée dans la plage allant de 1 à 30 T de la réponse de résonance magnétique des mélanges.

**14.** Procédé selon l'une quelconque des revendications 12 à 13, utilisant en outre des conditions spécifiques sélectionnées parmi (i) l'utilisation du même catalyseur que celui utilisé pour la courbe d'étalonnage, (ii) l'utilisation du même co-substrat que celui utilisé pour la courbe d'étalonnage, et (iii) l'application d'un *para*-$H_2$ similaire à celui appliqué pour la courbe d'étalonnage.

Fig. 1

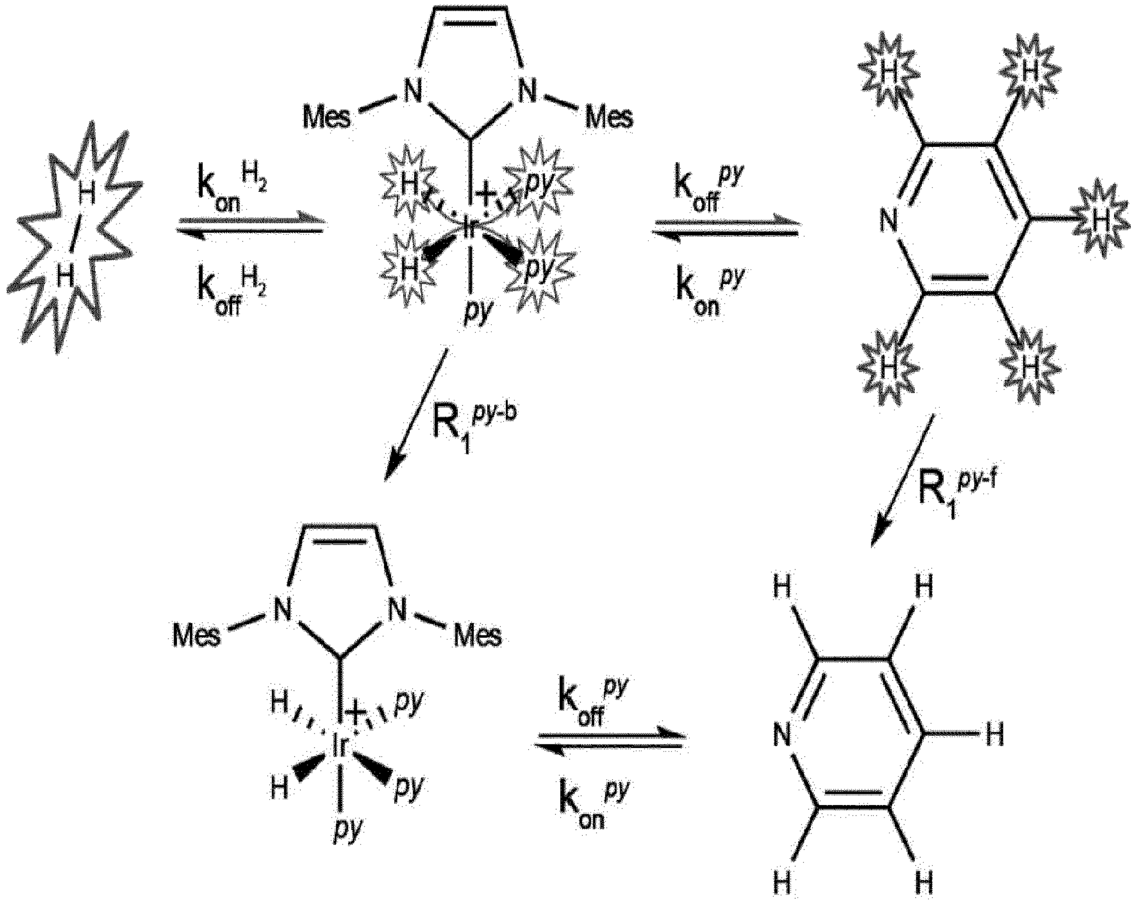


Fig. 2

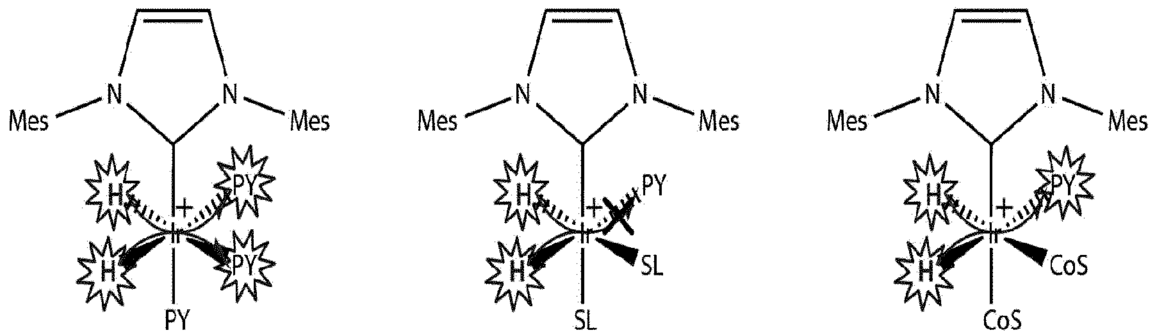

Fig. 3a

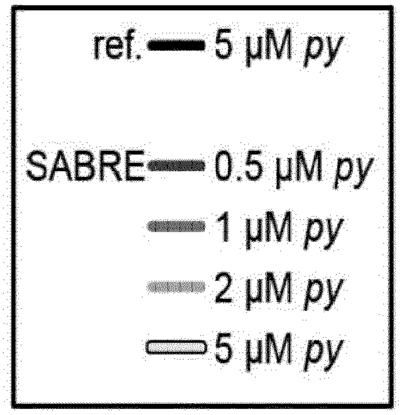
ref. 5 μM py
SABRE 0.5 μM py
1 μM py
2 μM py
5 μM py

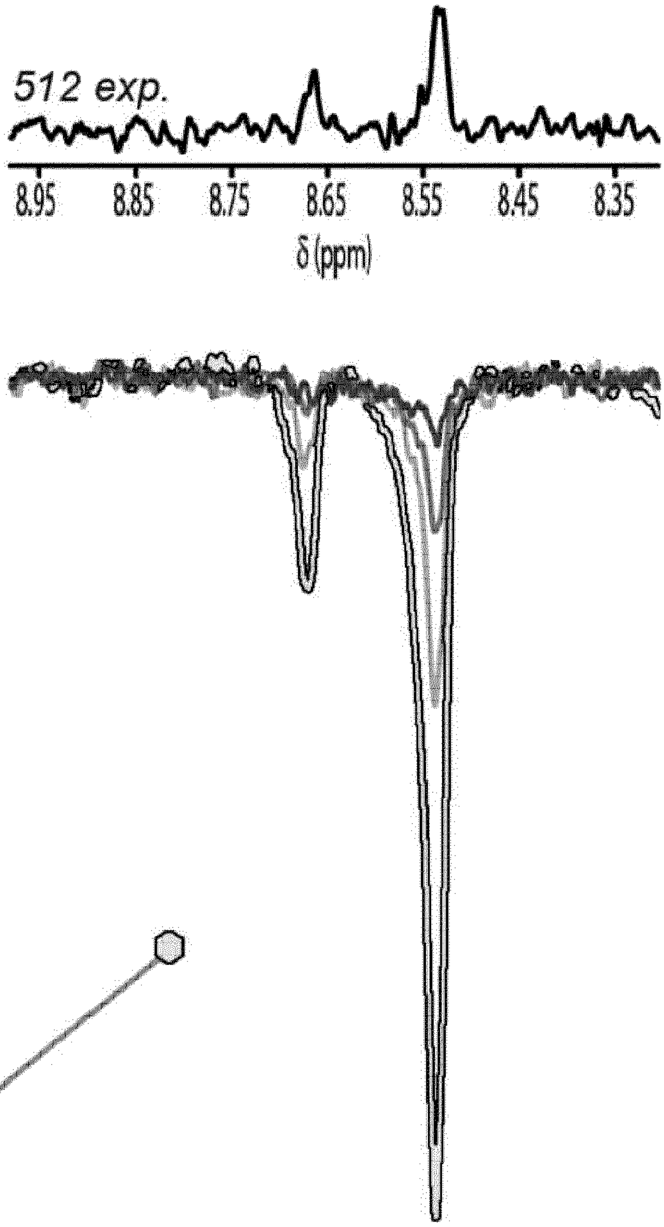
512 exp.
8.95
8.85
8.75
8.65
8.55
8.45
8.35
δ (ppm)

Fig. 3b

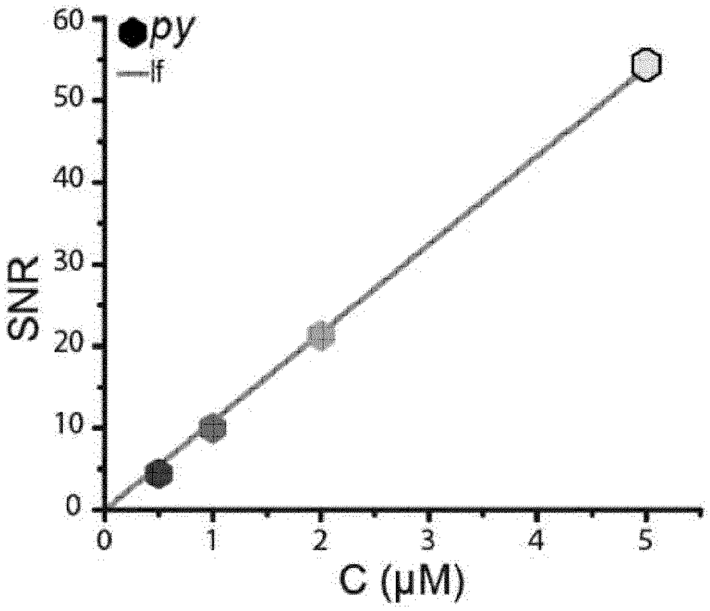
py
lf
SNR
60
50
40
30
20
10
0
0
1
2
3
4
5
C (μM)

Fig. 4

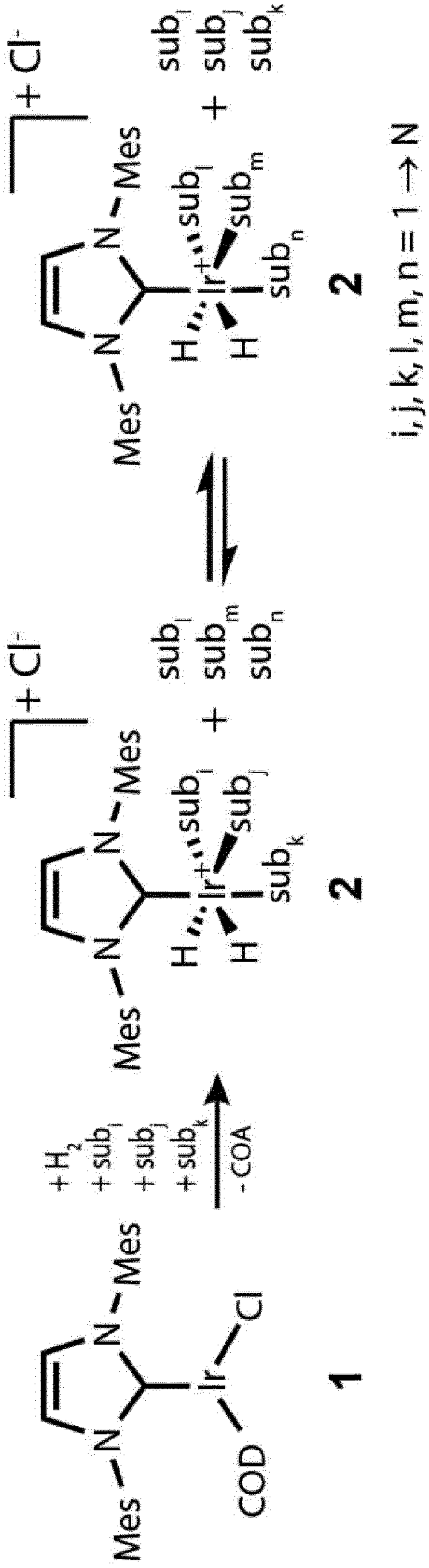


1

2

2

Fig. 5

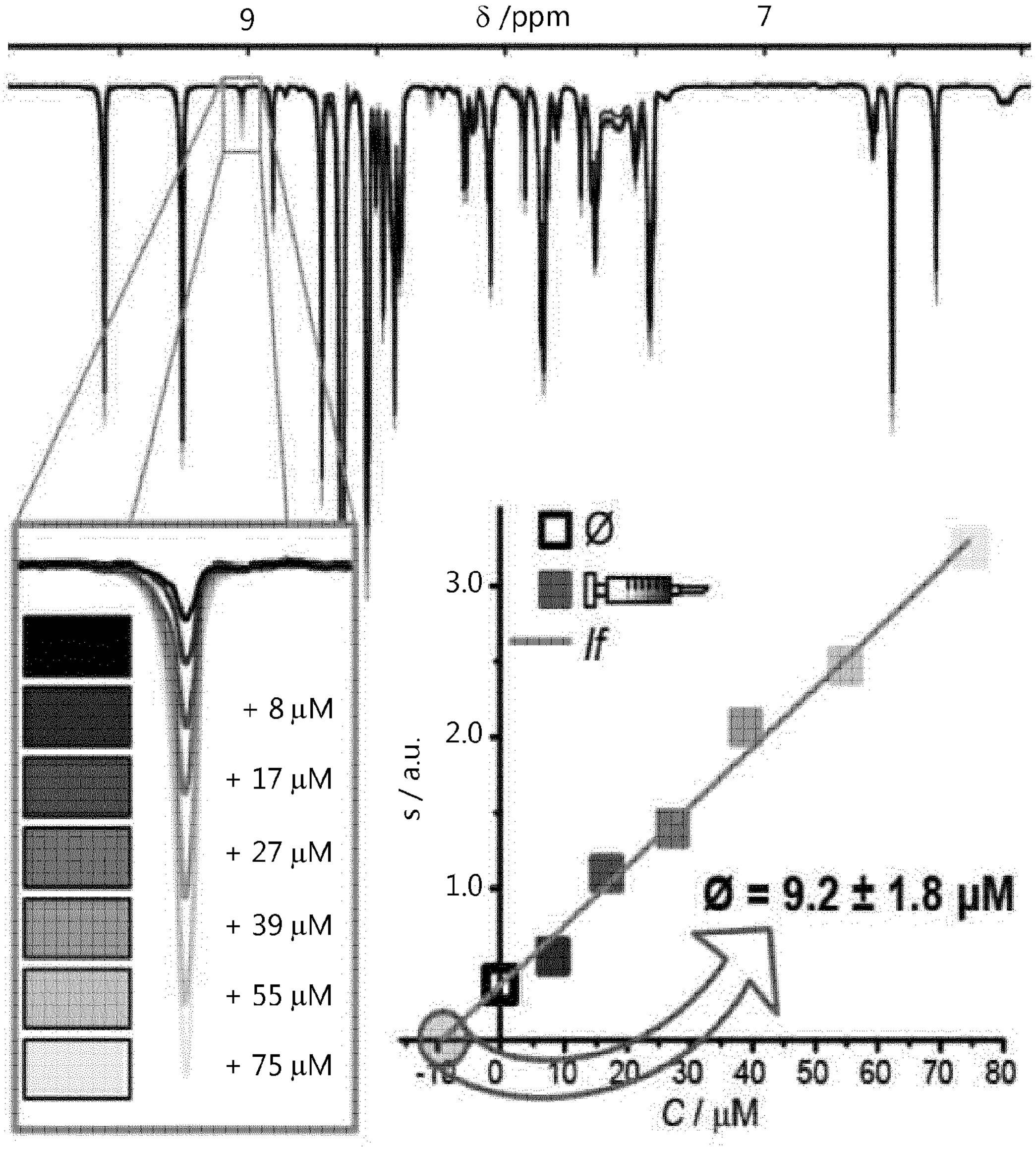
9
δ /ppm
7
+ 8 μM
+ 17 μM
+ 27 μM
+ 39 μM
+ 55 μM
+ 75 μM
Ø
lf
3.0
2.0
1.0
s / a.u.
Ø = 9.2 ± 1.8 μM
-10
0
10
20
30
40
50
60
70
80
C / μM

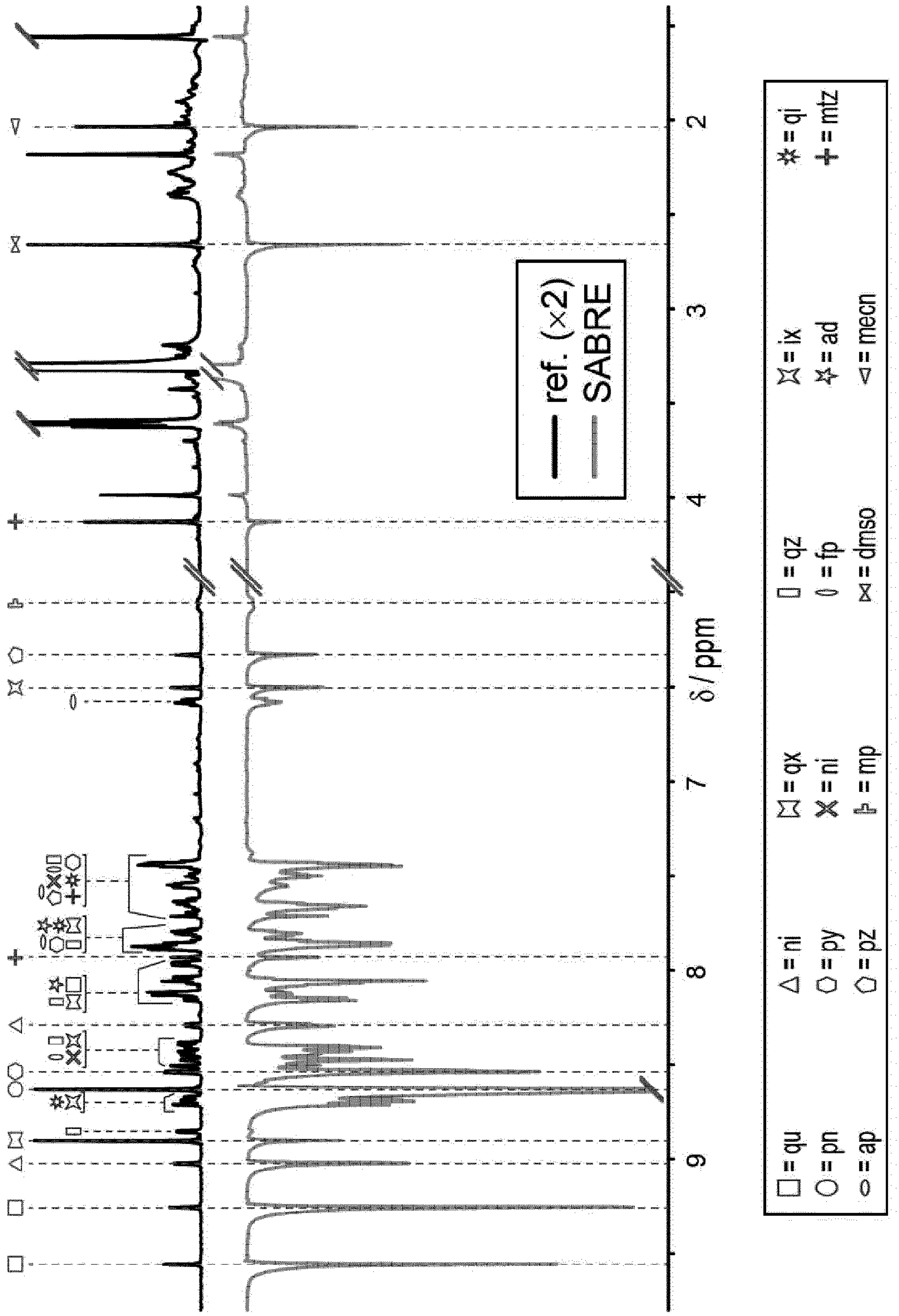
ref. (×2)
SABRE
δ / ppm
9
8
7
4
3
2
□ = qu
○ = pn
◇ = ap
△ = ni
⬡ = py
⬠ = pz
⋈ = qx
✕ = ni
= mp
▯ = qz
⬯ = fp
= dmso
= ix
= ad
◁ = mecn
✲ = qi
✚ = mtz

Fig. 6

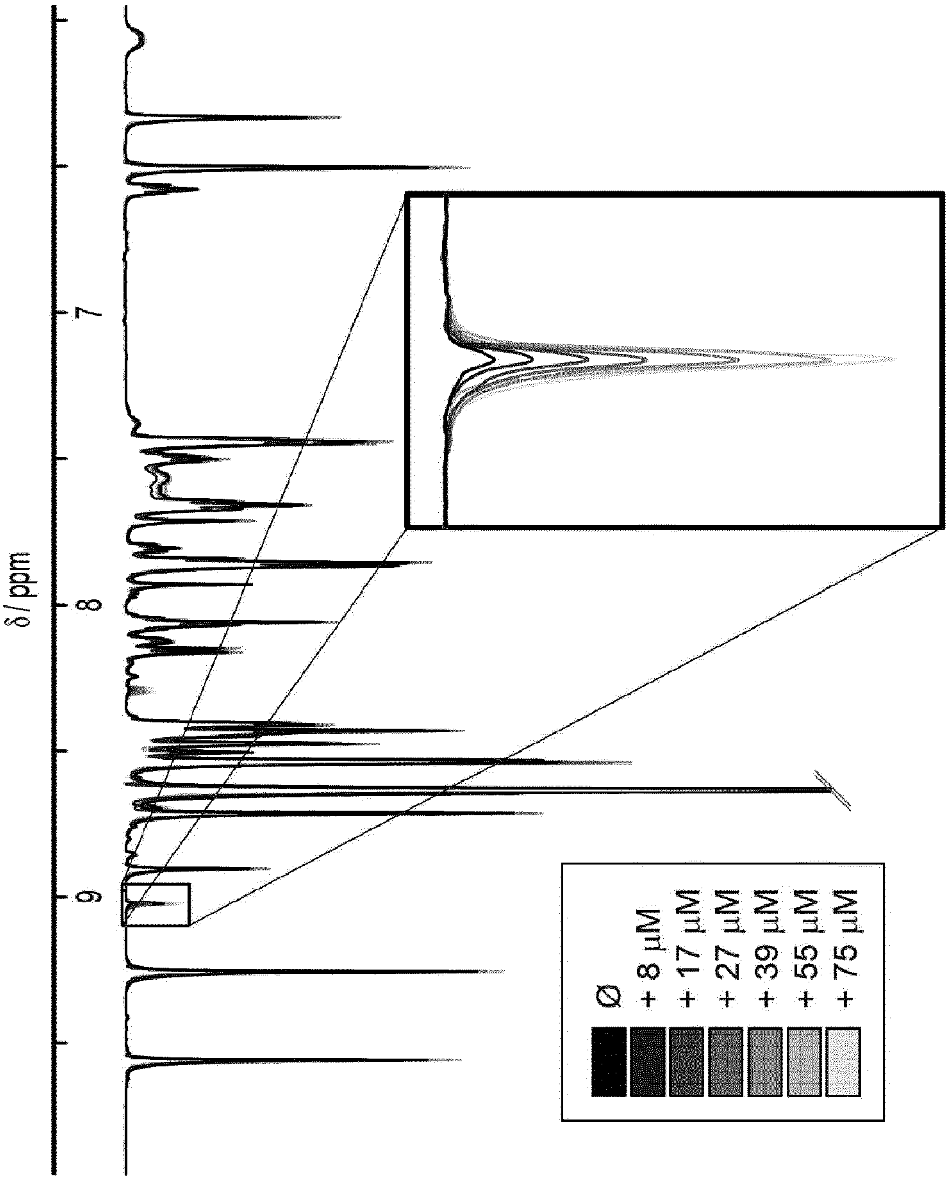


Fig. 7

Fig. 8a

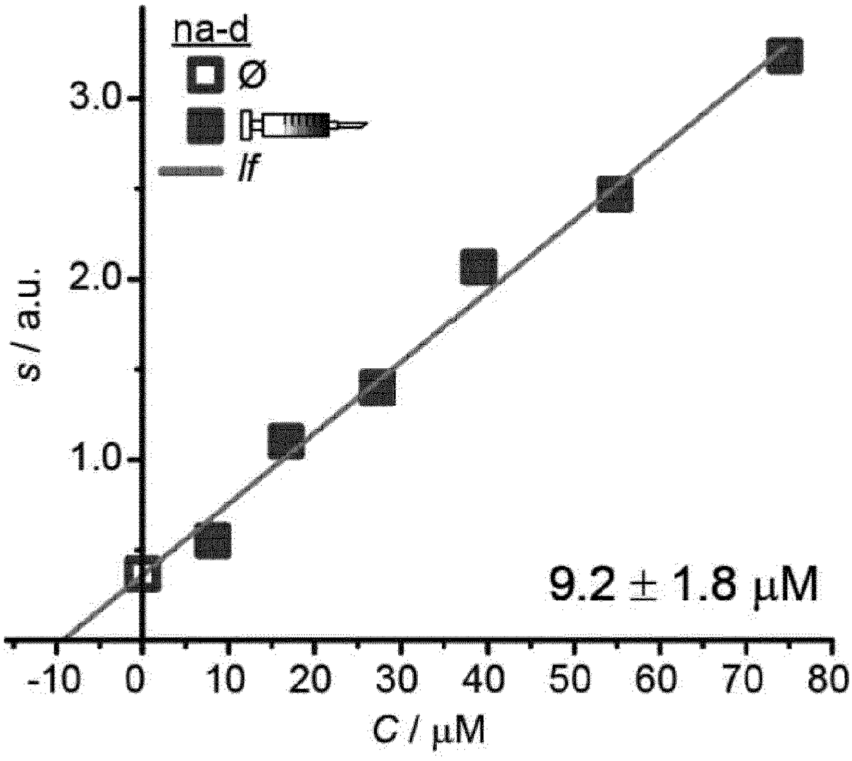
na-d
Ø
lf
3.0
2.0
1.0
s / a.u.
9.2 ± 1.8 μM
-10
0
10
20
30
40
50
60
70
80
C / μM

Fig. 8b

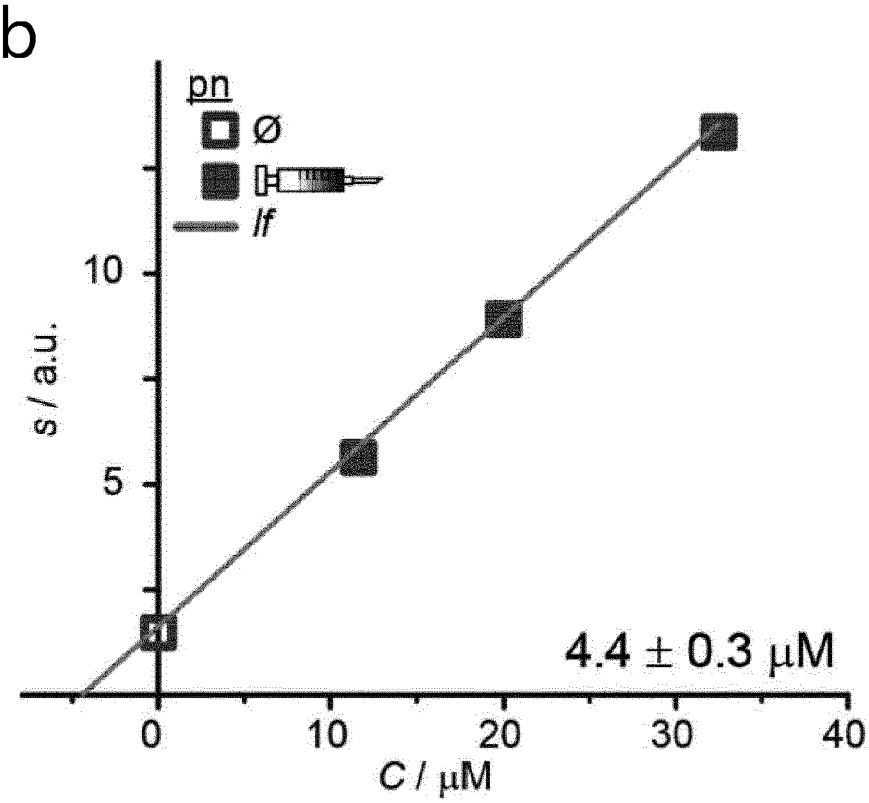
pn
Ø
lf
10
5
s / a.u.
4.4 ± 0.3 μM
0
10
20
30
40
C / μM

Fig. 8c

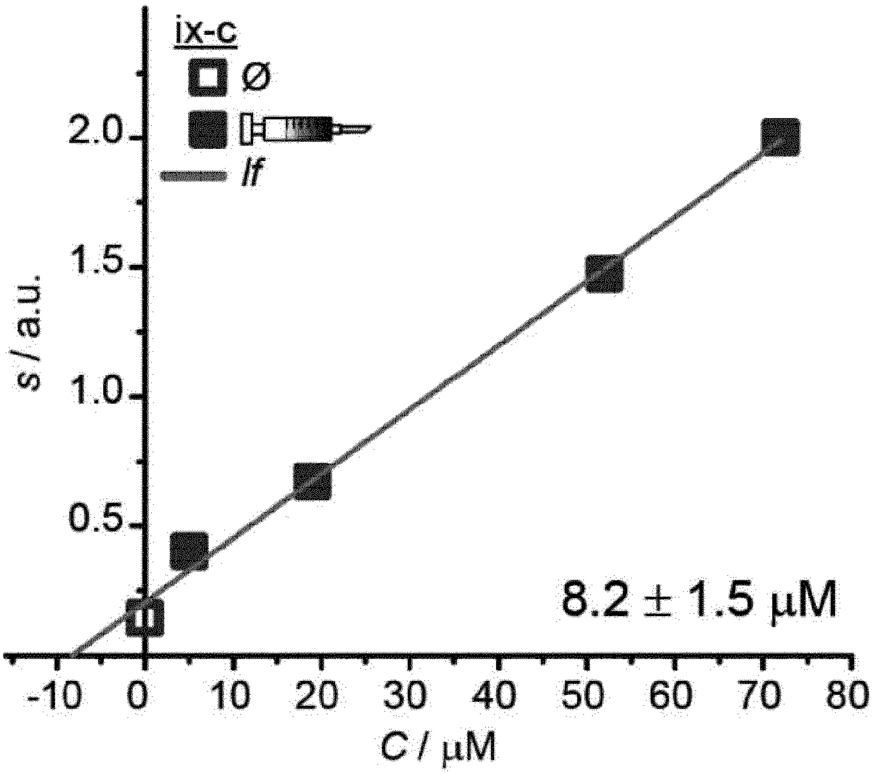
ix-c
Ø
lf
2.0
1.5
1.0
0.5
s / a.u.
8.2 ± 1.5 µM
-10
0
10
20
30
40
50
60
70
80
C / µM

Fig. 8d

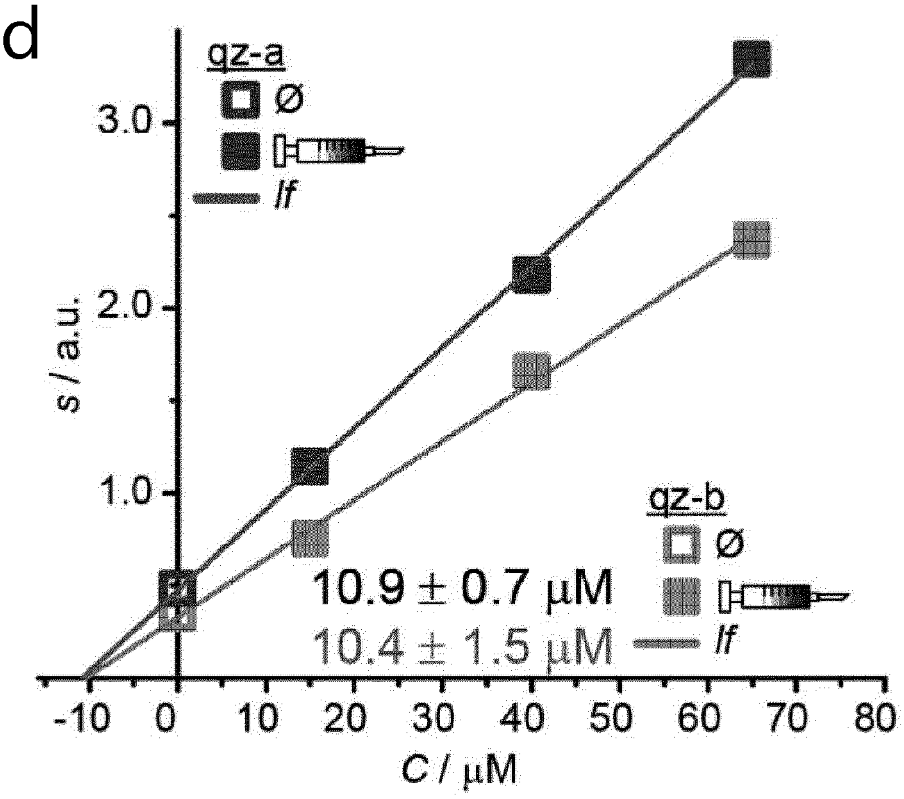
qz-a
Ø
lf
3.0
2.0
1.0
s / a.u.
qz-b
Ø
lf
10.9 ± 0.7 µM
10.4 ± 1.5 µM
-10
0
10
20
30
40
50
60
70
80
C / µM

Fig. 9

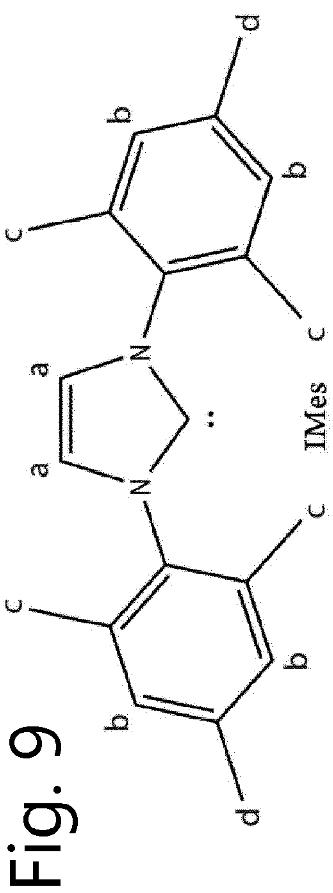

IMes

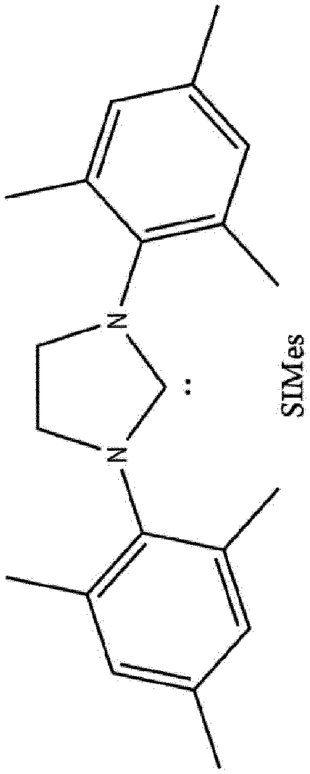

SIMes

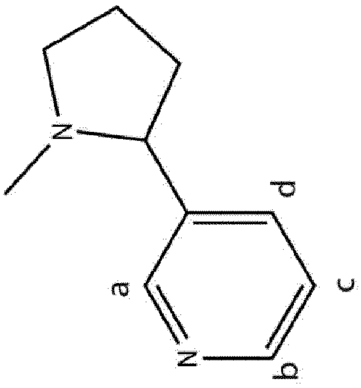

*ni*

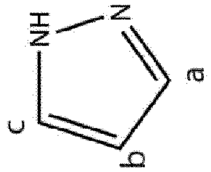

*pz*

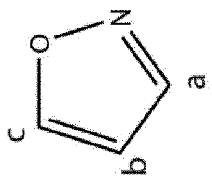

*ix*

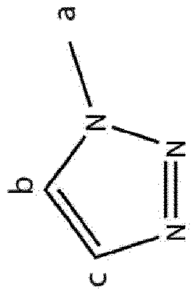

*mtz*

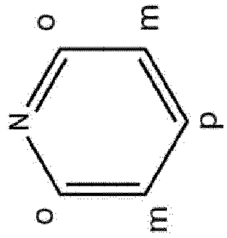

*py*

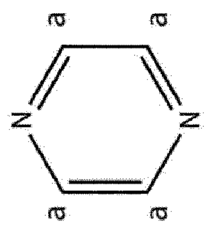

*pn*

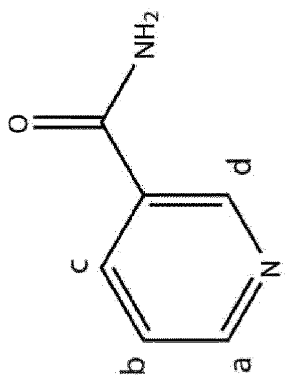

*na*

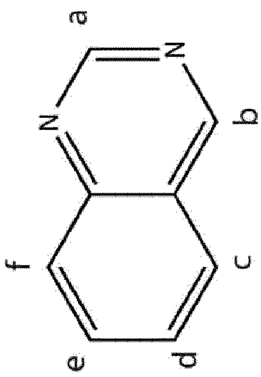

*qz*

Fig. 10

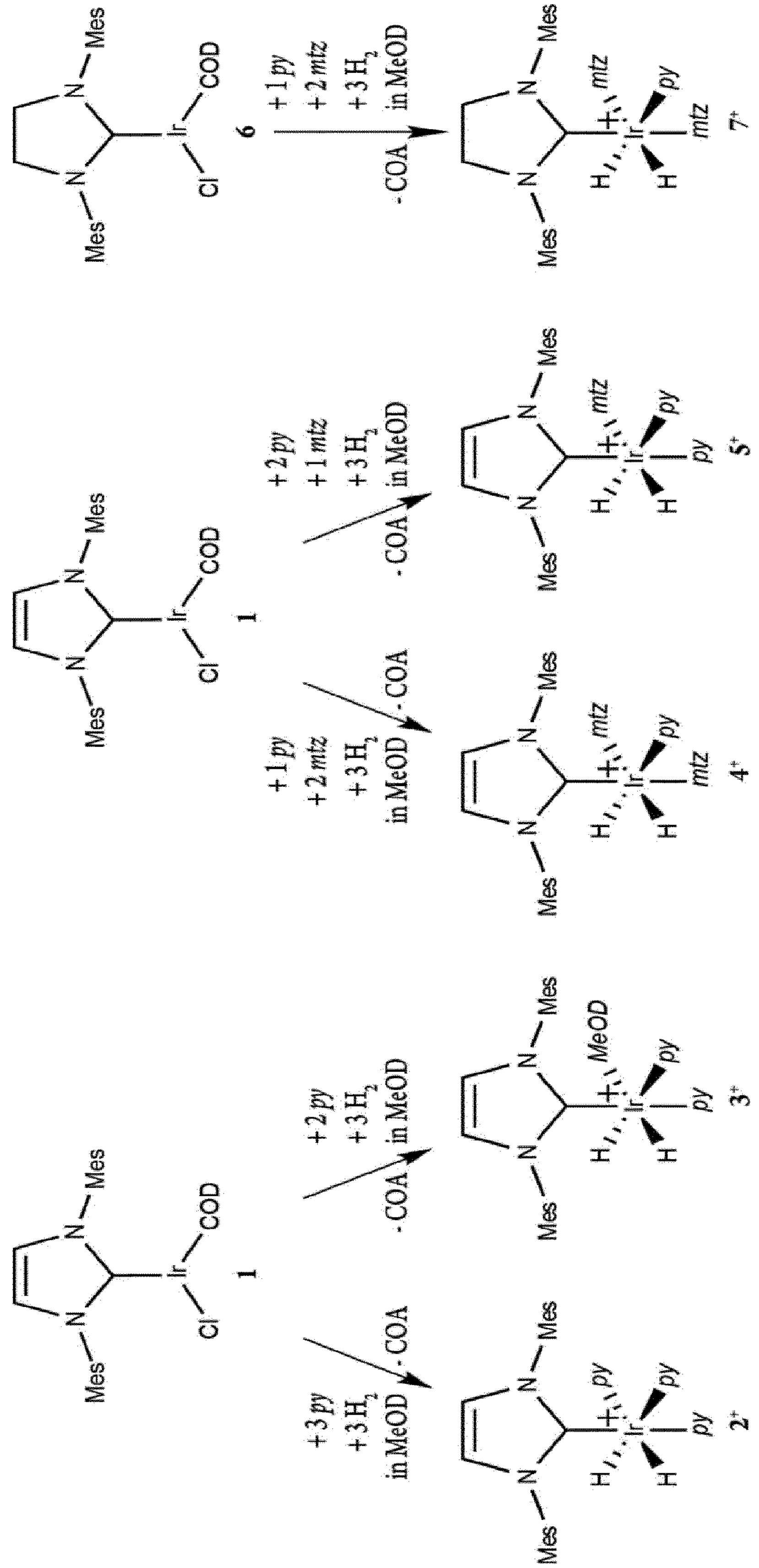
1
+ 3 py
+ 3 H2
in MeOD
- COA
2+
+ 2 py
+ 3 H2
in MeOD
-COA
3+
1
+ 1 py
+ 2 mtz
+ 3 H2
in MeOD
- COA
4+
+ 2 py
+ 1 mtz
+ 3 H2
in MeOD
-COA
5+
6
+ 1 py
+ 2 mtz
+ 3 H2
in MeOD
-COA
7+

Fig. 11

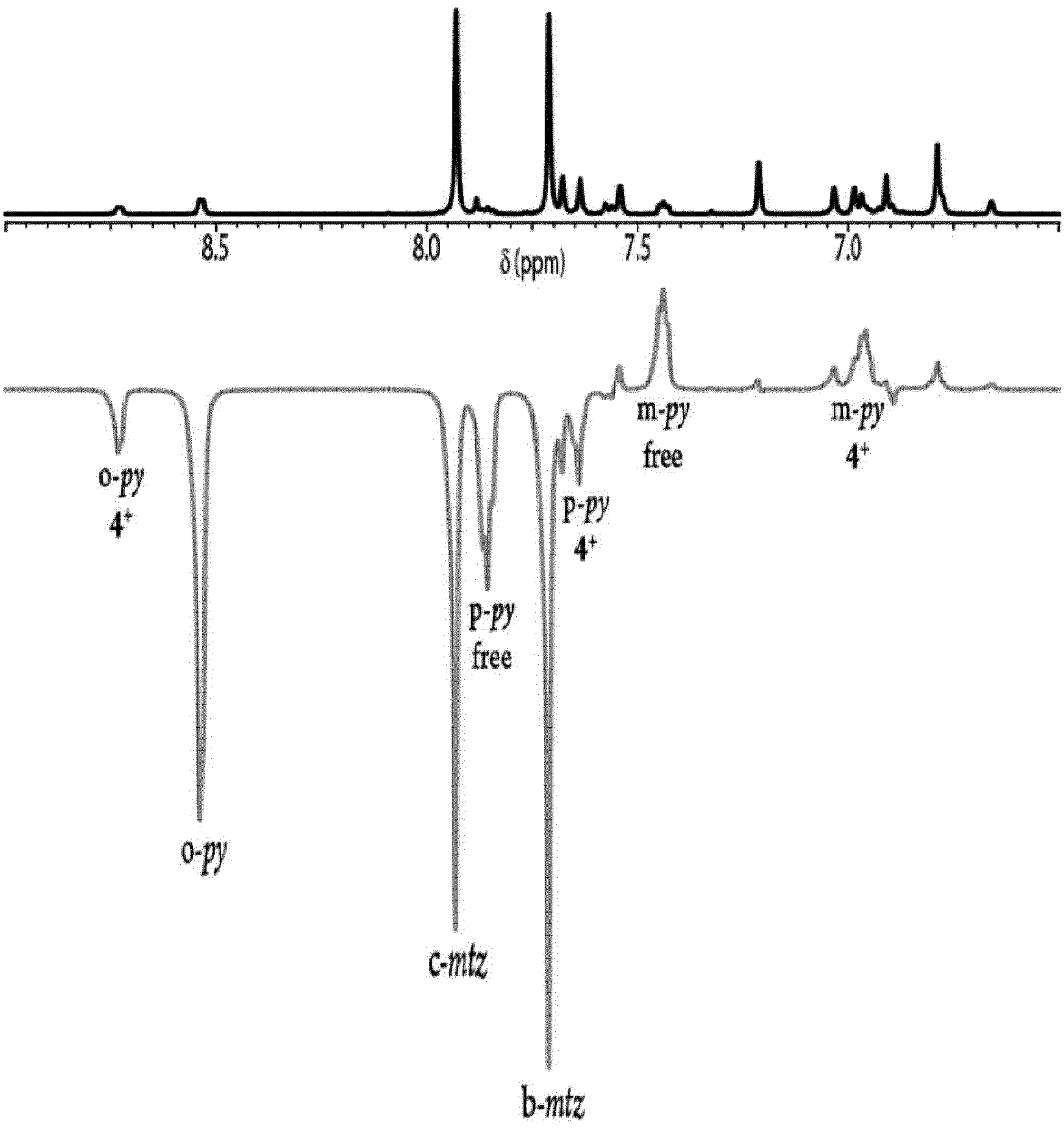

Fig. 12a

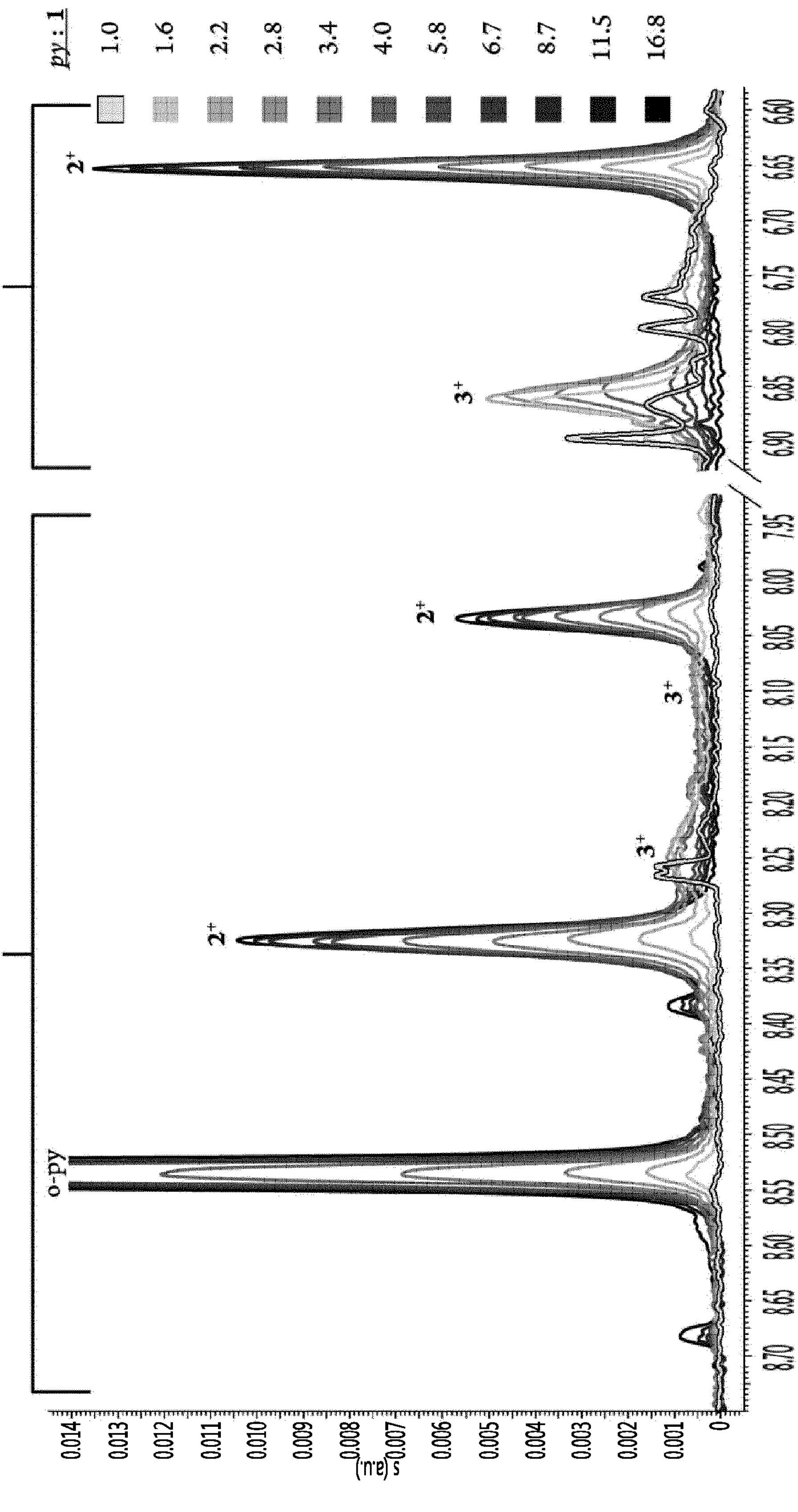
o-py
b-IMes
o-py
2+
3+
2+
3+
3+
2+
py : 1
1.0
1.6
2.2
2.8
3.4
4.0
5.8
6.7
8.7
11.5
16.8
s (a.u.)
δ (ppm)

Fig. 12b

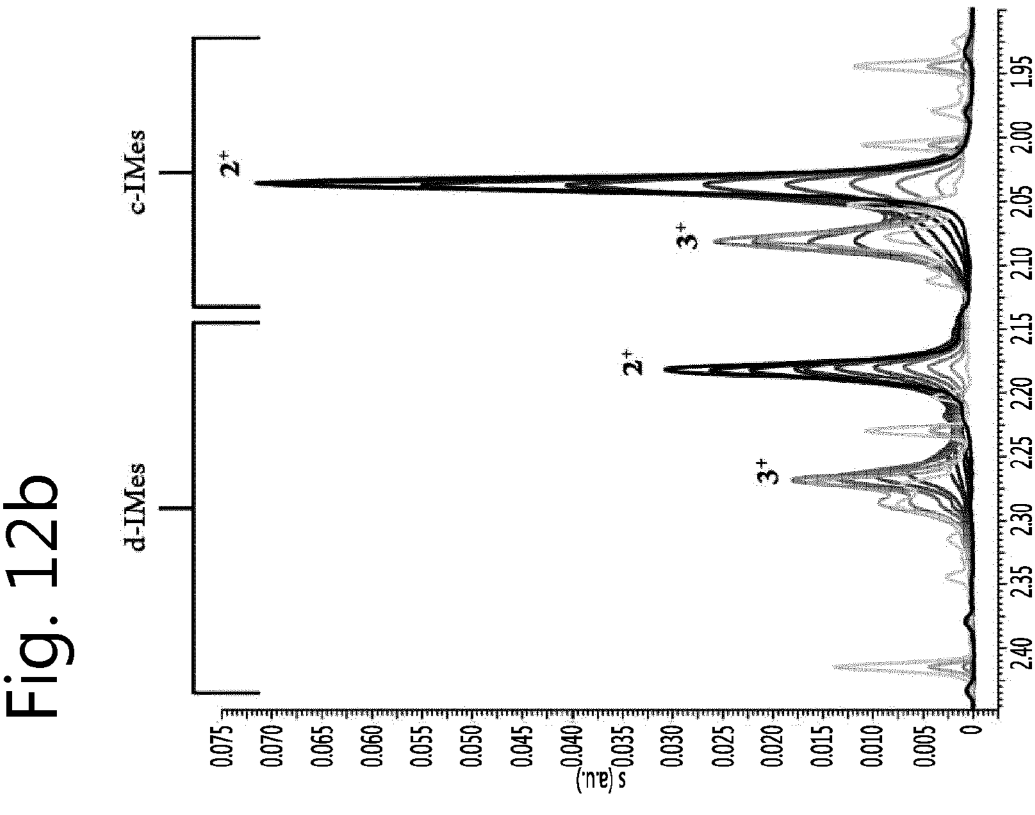


Fig. 12c

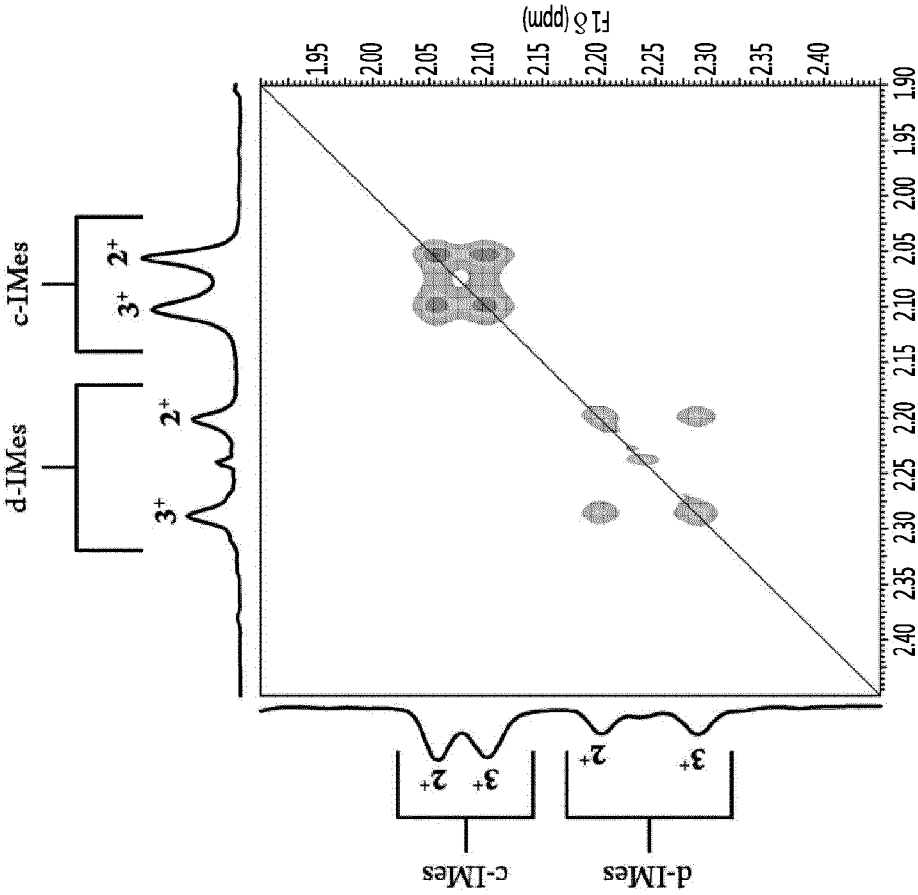

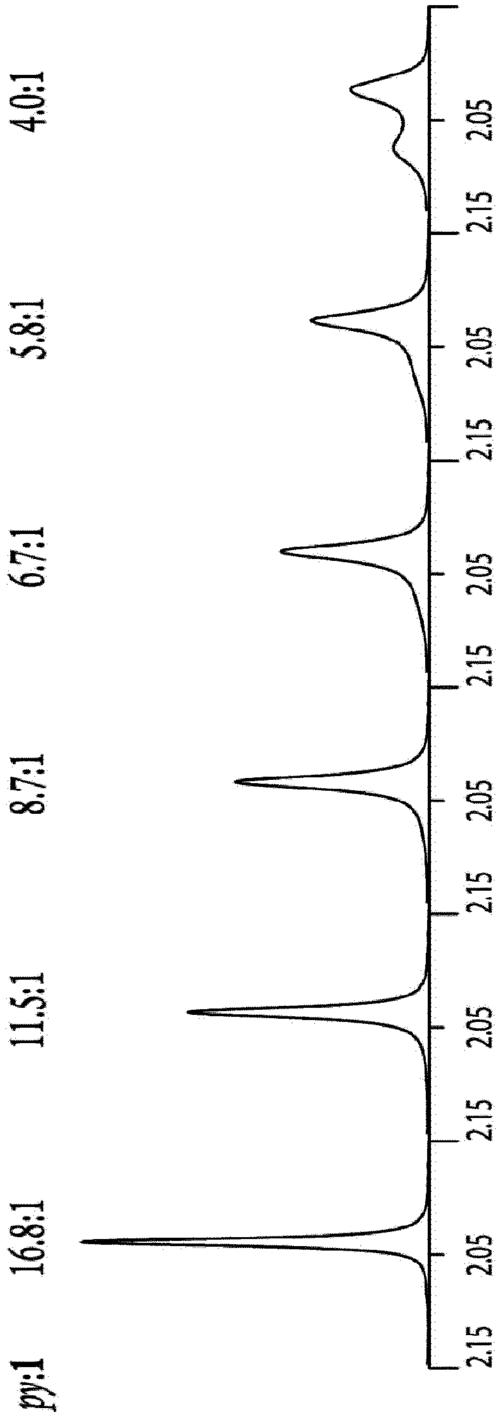


Fig. 13a

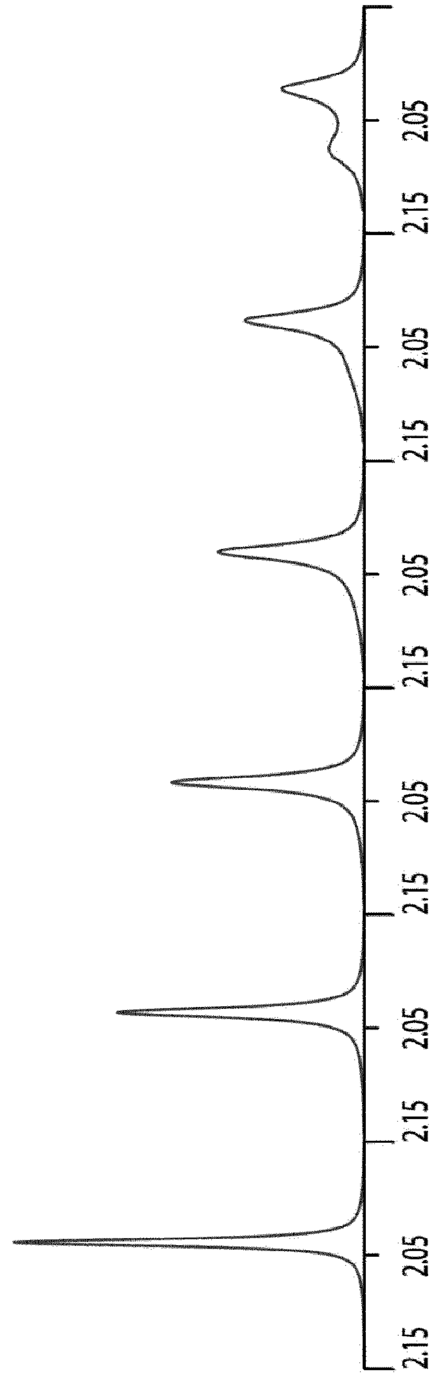


Fig. 13b

Fig. 14a

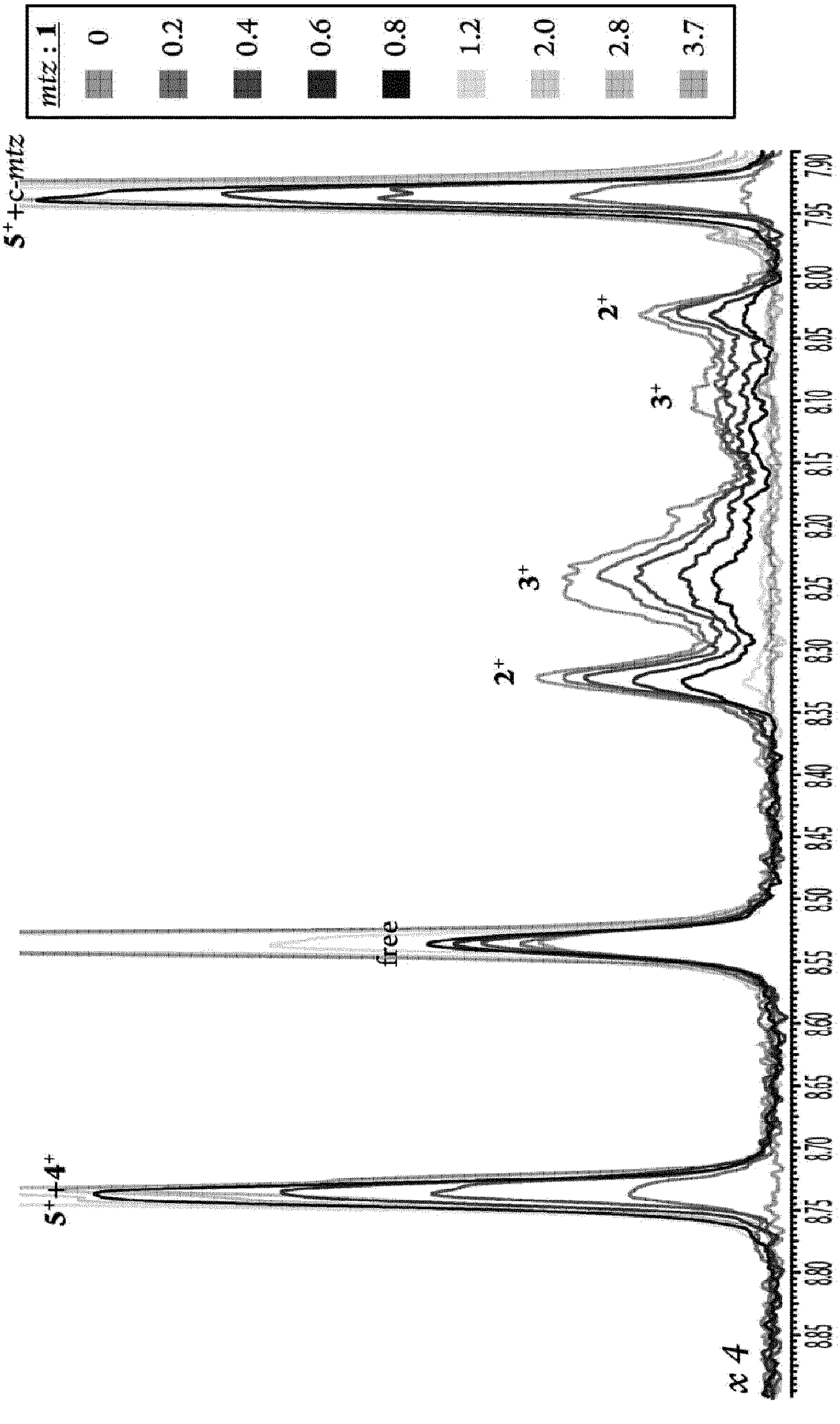
mtz : 1
0
0.2
0.4
0.6
0.8
1.2
2.0
2.8
3.7
5+ + 4+
free
2+
3+
3+
2+
5+ + c-mtz
x 4
8.85 8.80 8.75 8.70 8.65 8.60 8.55 8.50 8.45 8.40 8.35 8.30 8.25 8.20 8.15 8.10 8.05 8.00 7.95 7.90
δ(ppm)

Fig. 14b

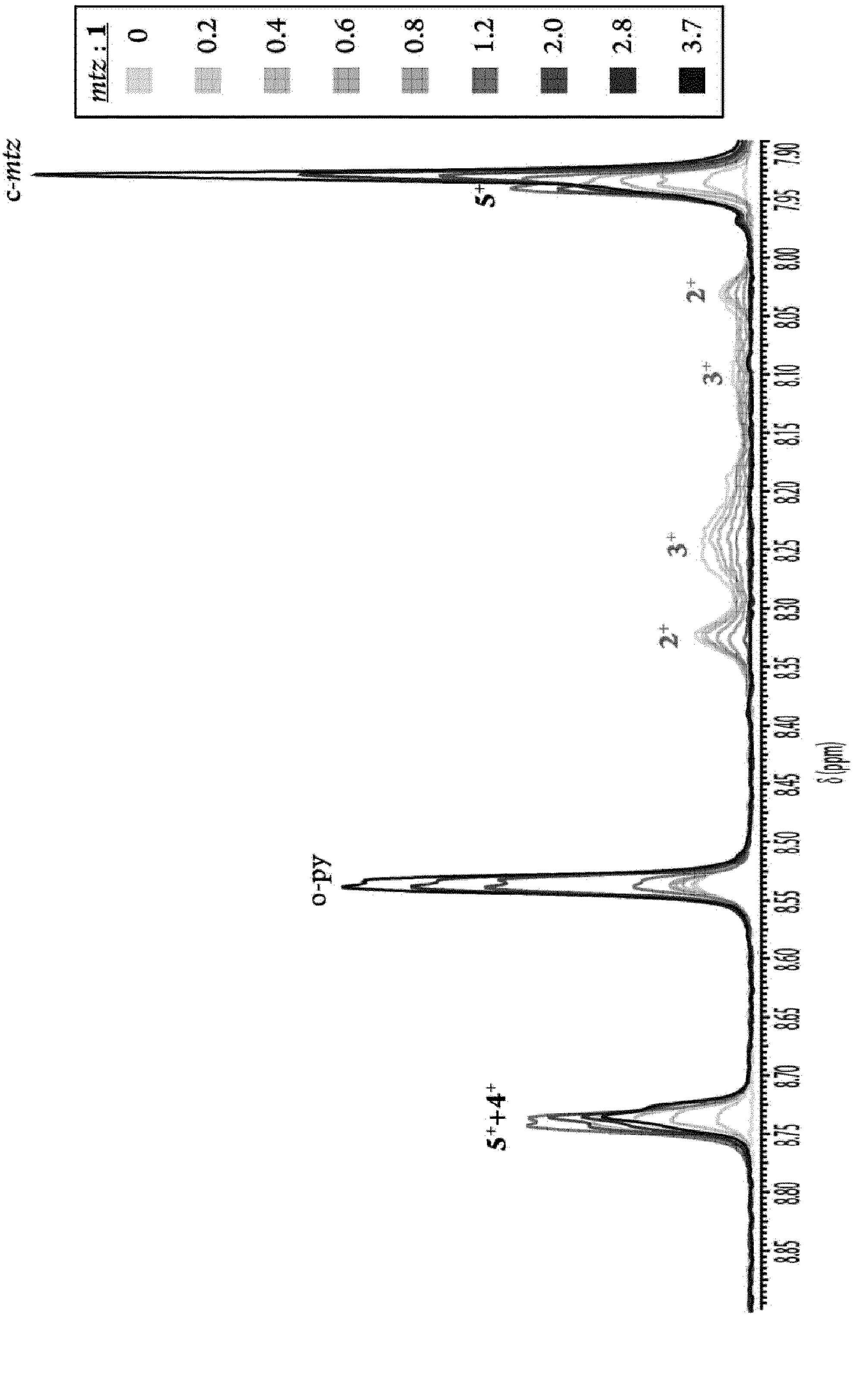
c-mtz
5+
2+
3+
3+
2+
o-py
5++4+
mtz : 1
0
0.2
0.4
0.6
0.8
1.2
2.0
2.8
3.7
7.90
7.95
8.00
8.05
8.10
8.15
8.20
8.25
8.30
8.35
8.40
8.45
8.50
8.55
8.60
8.65
8.70
8.75
8.80
8.85
δ (ppm)

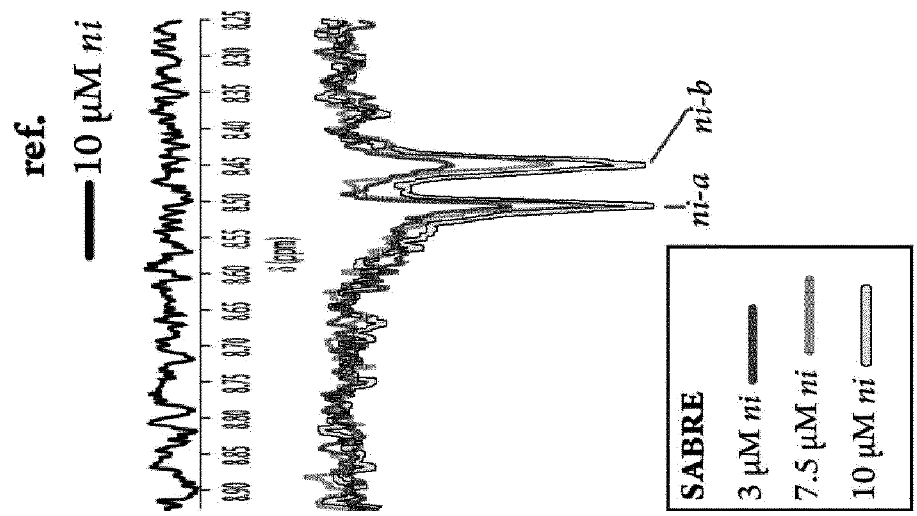


Fig. 15a

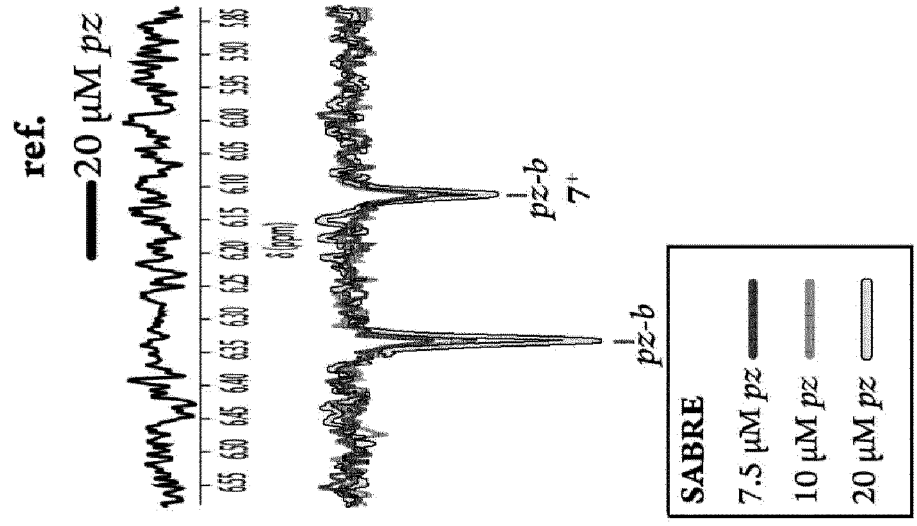


Fig. 15b

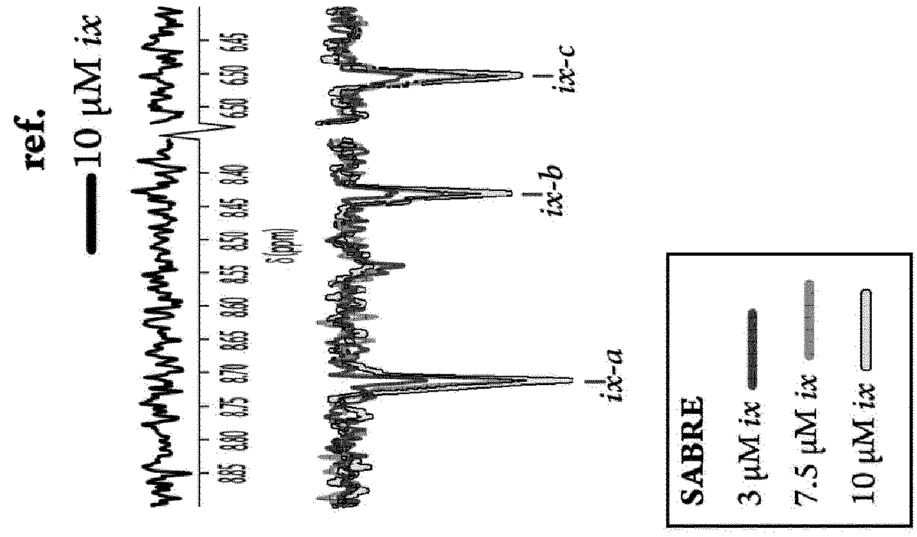


Fig. 15c

Fig. 15d

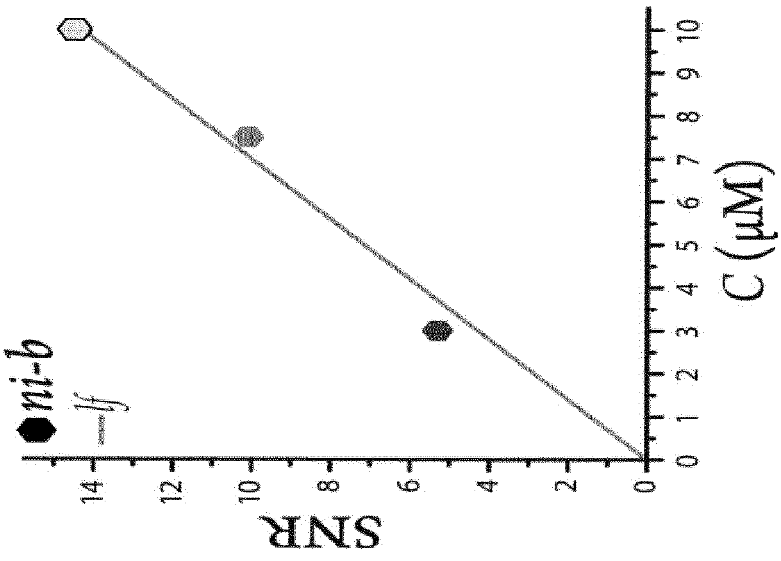


Fig. 15e

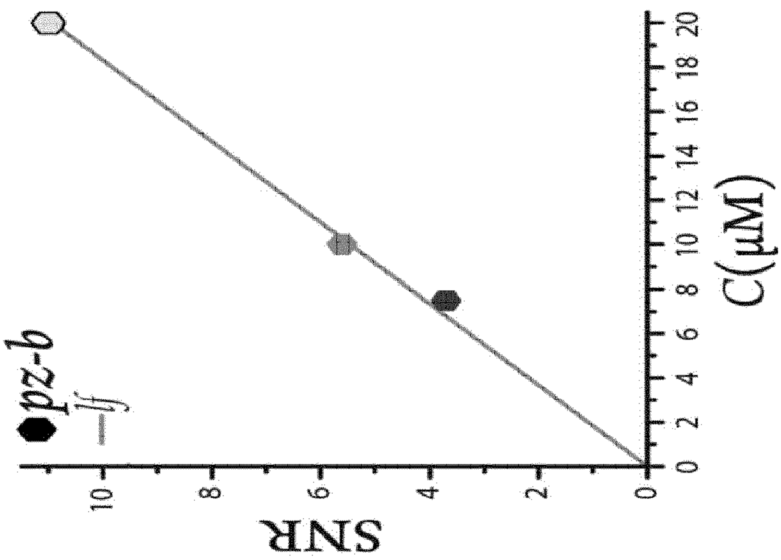


Fig. 15f

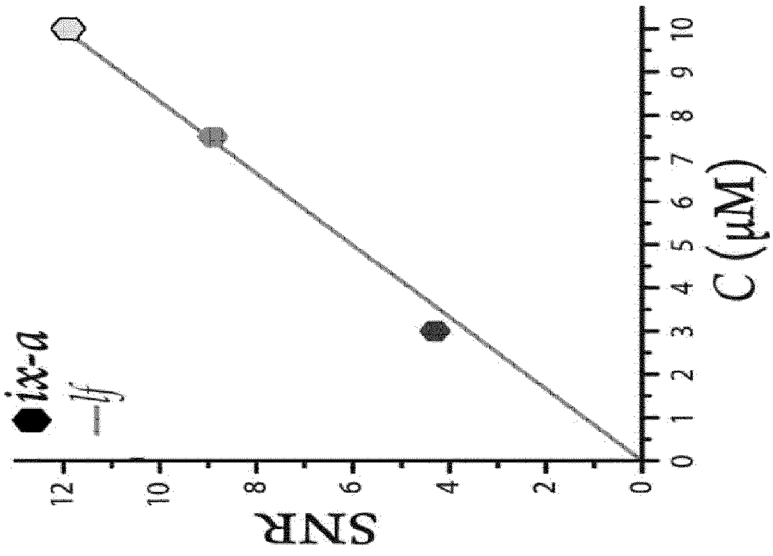

Fig. 16

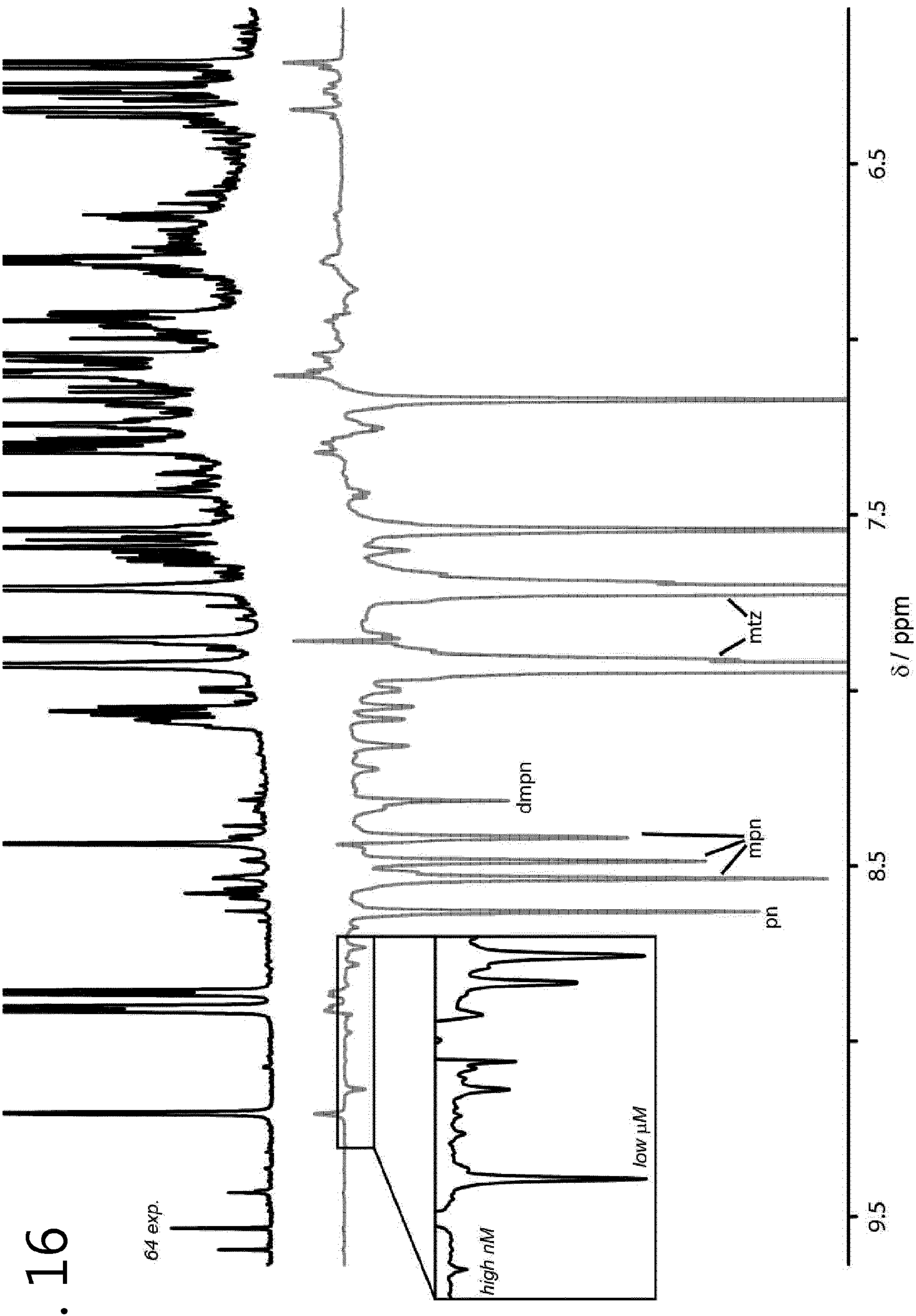

Fig. 17

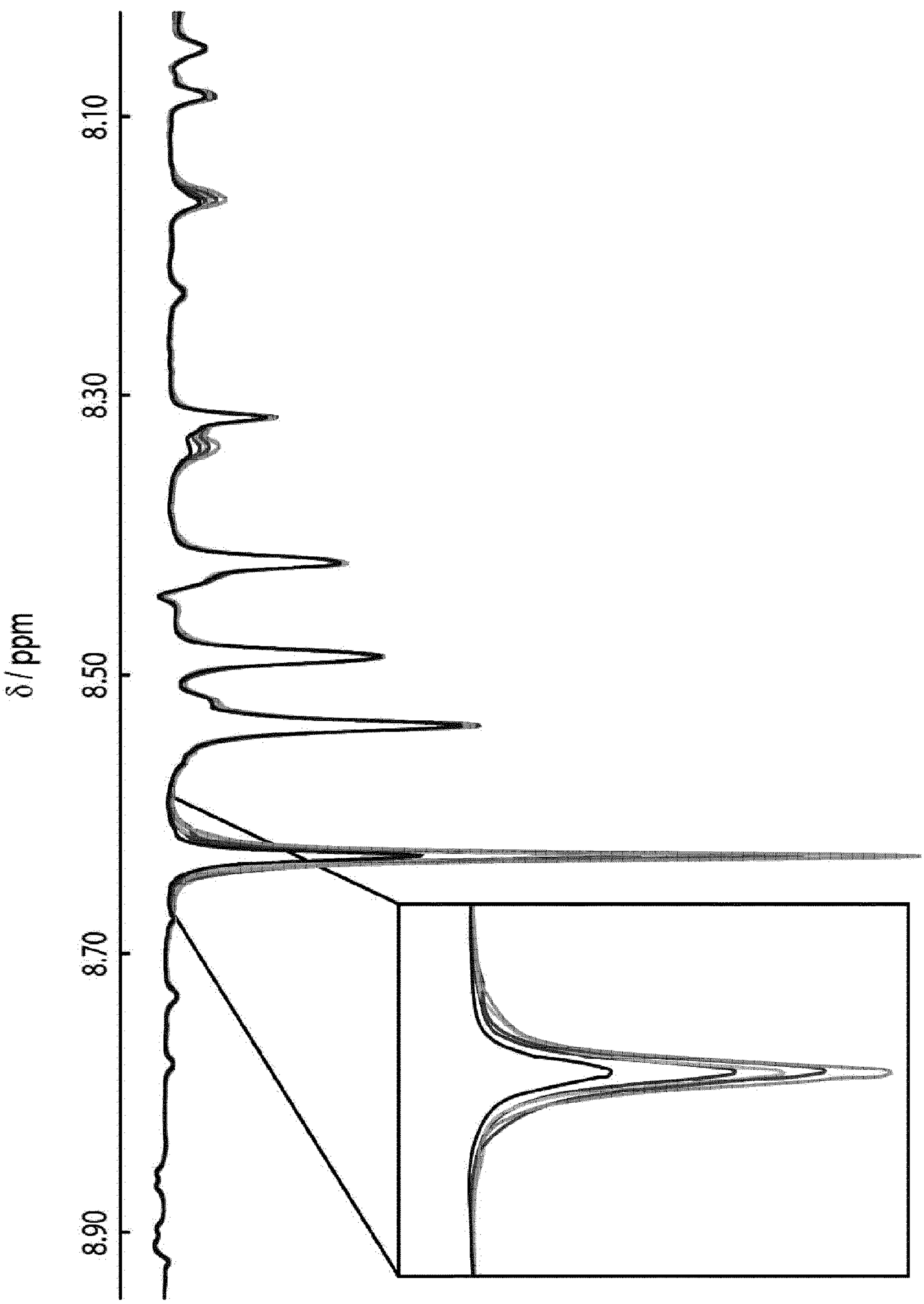

Fig. 18

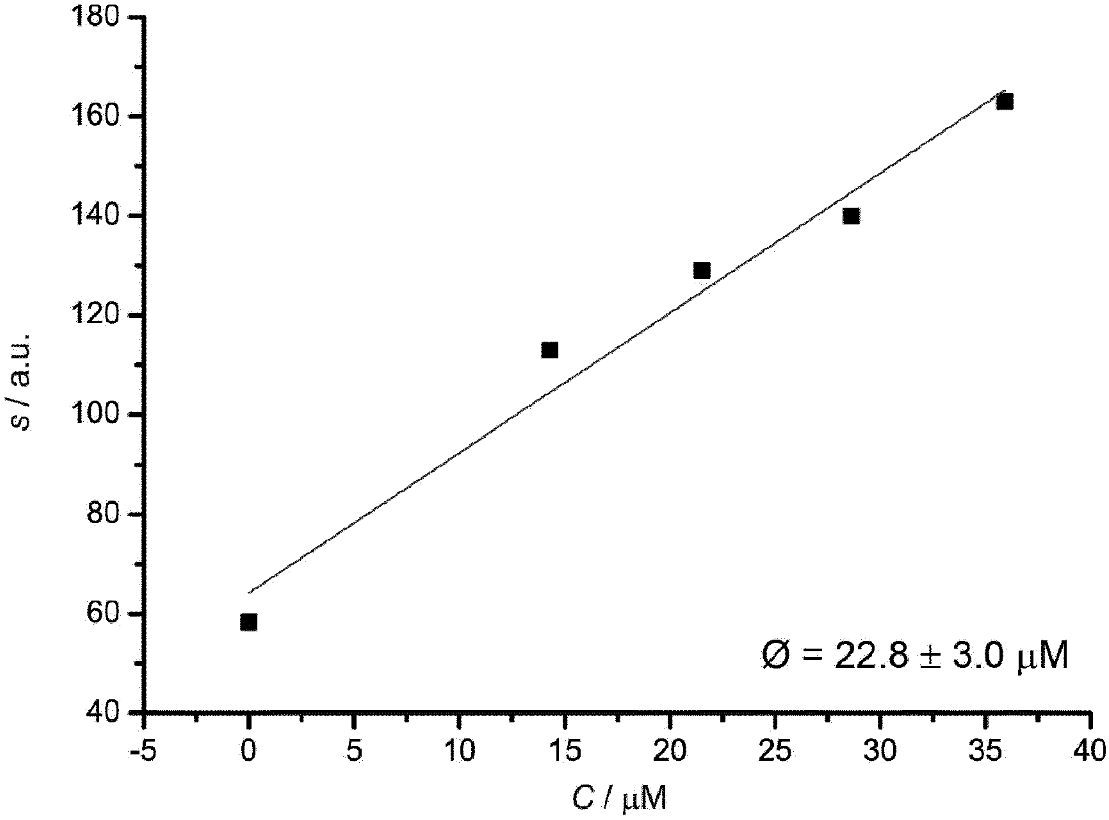
180
160
140
120
100
80
60
40
s / a.u.
-5
0
5
10
15
20
25
30
35
40
C / μM
Ø = 22.8 ± 3.0 μM

Fig. 19

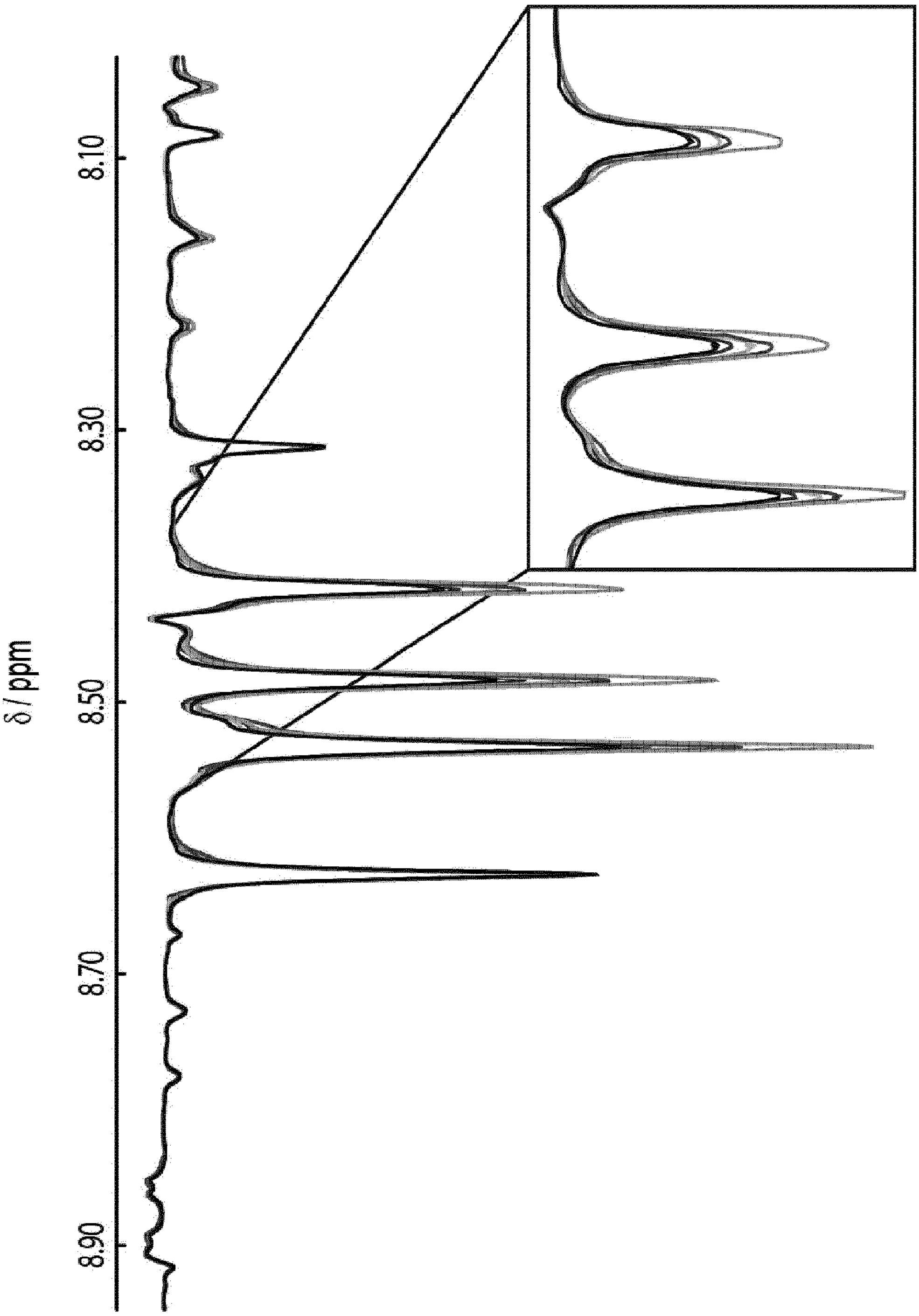

Fig. 20

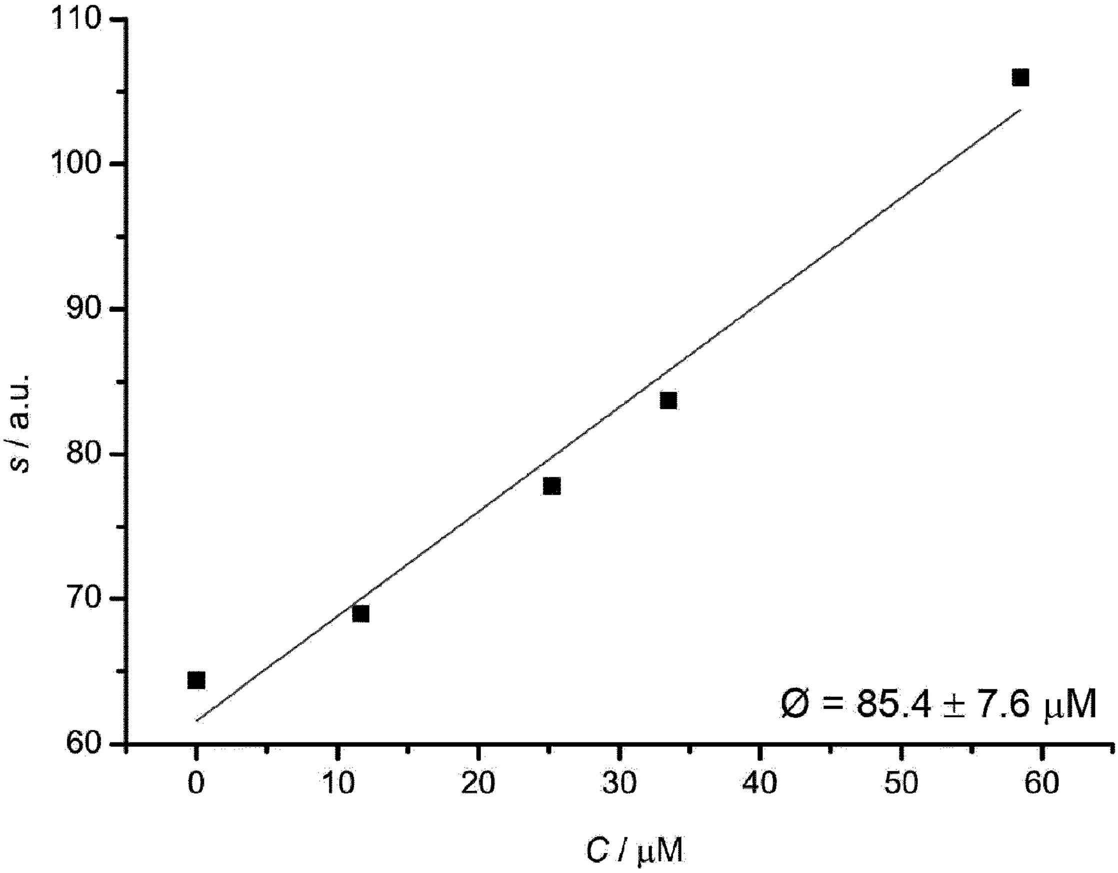

Fig. 21

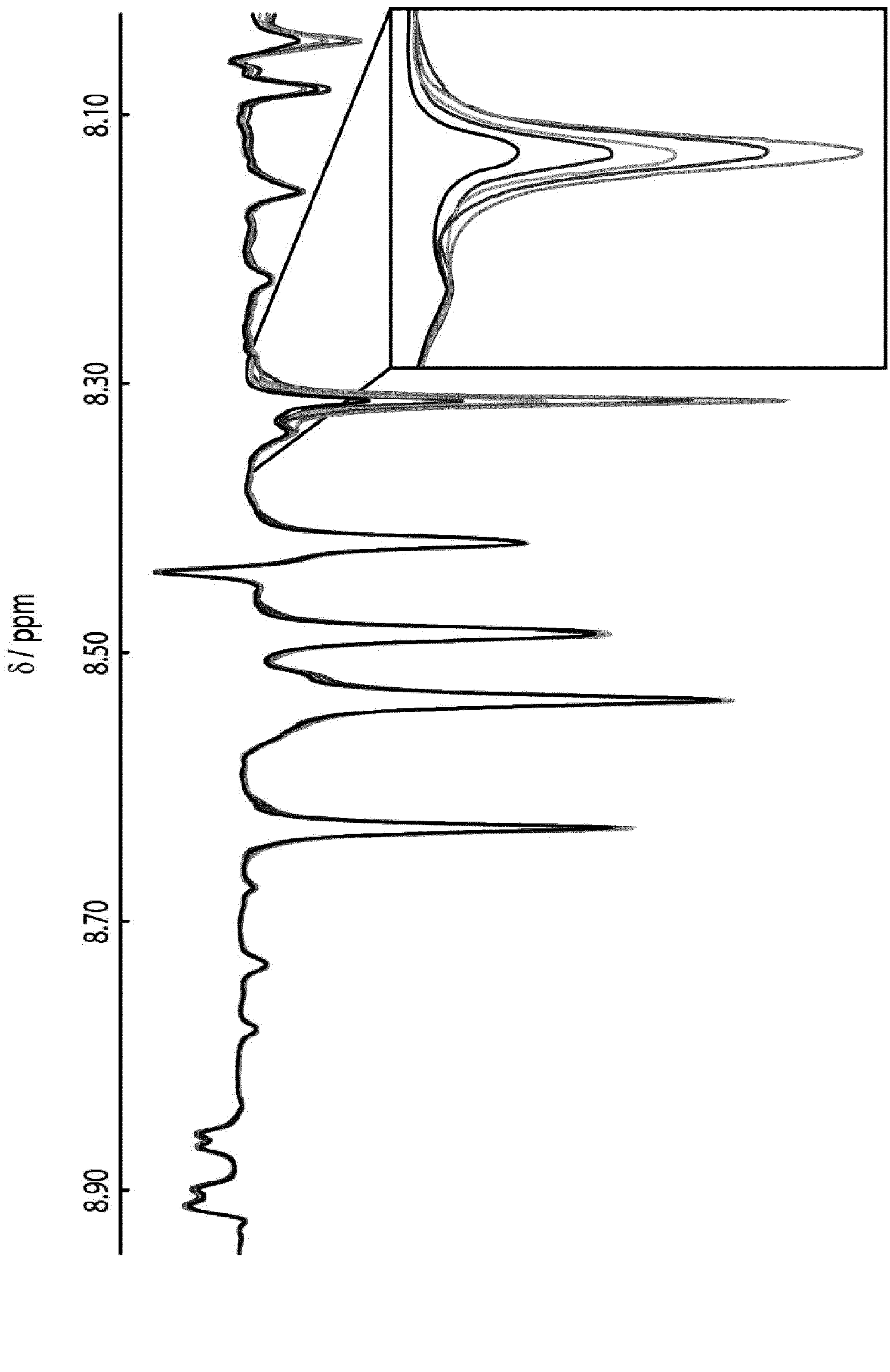

Fig. 22

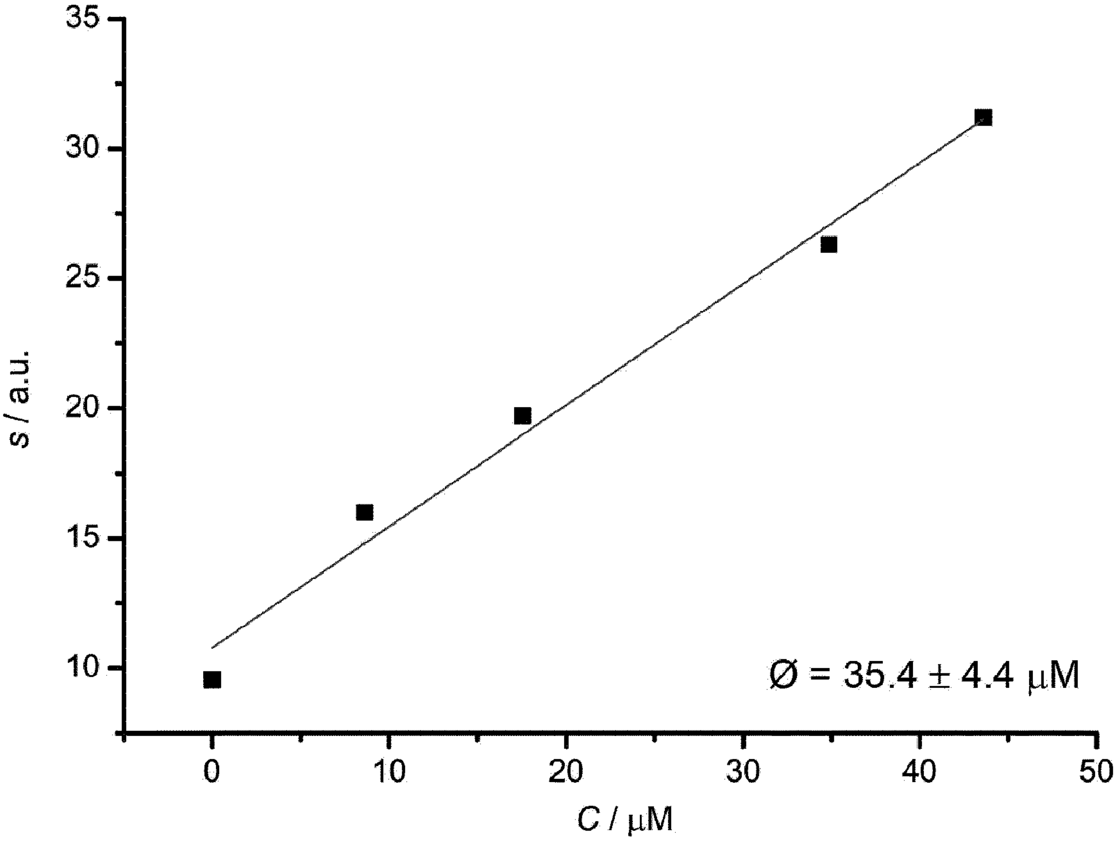

Fig. 23a

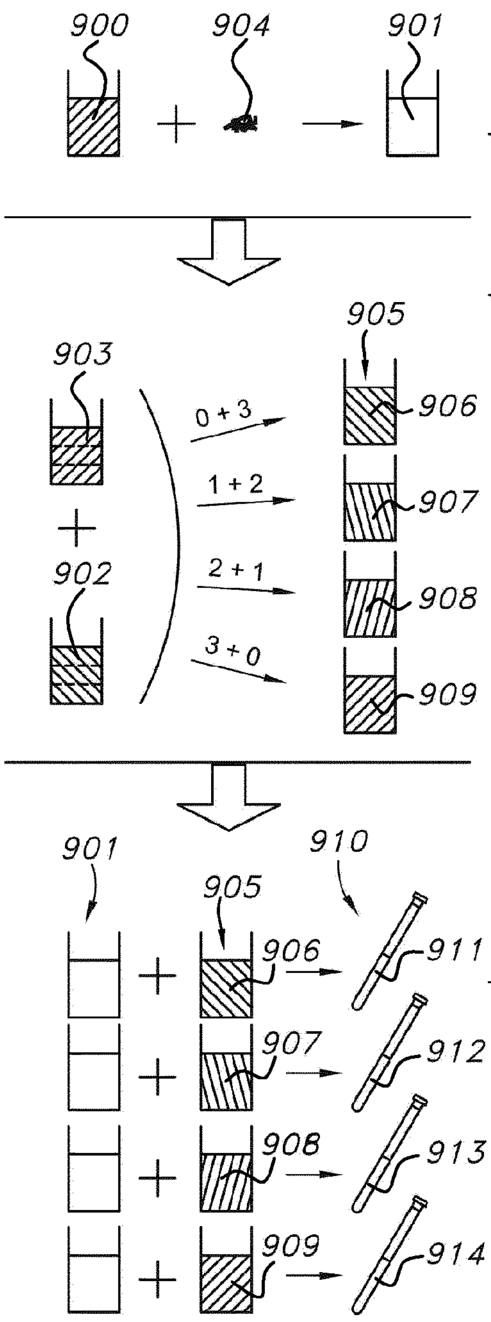


Fig. 23b

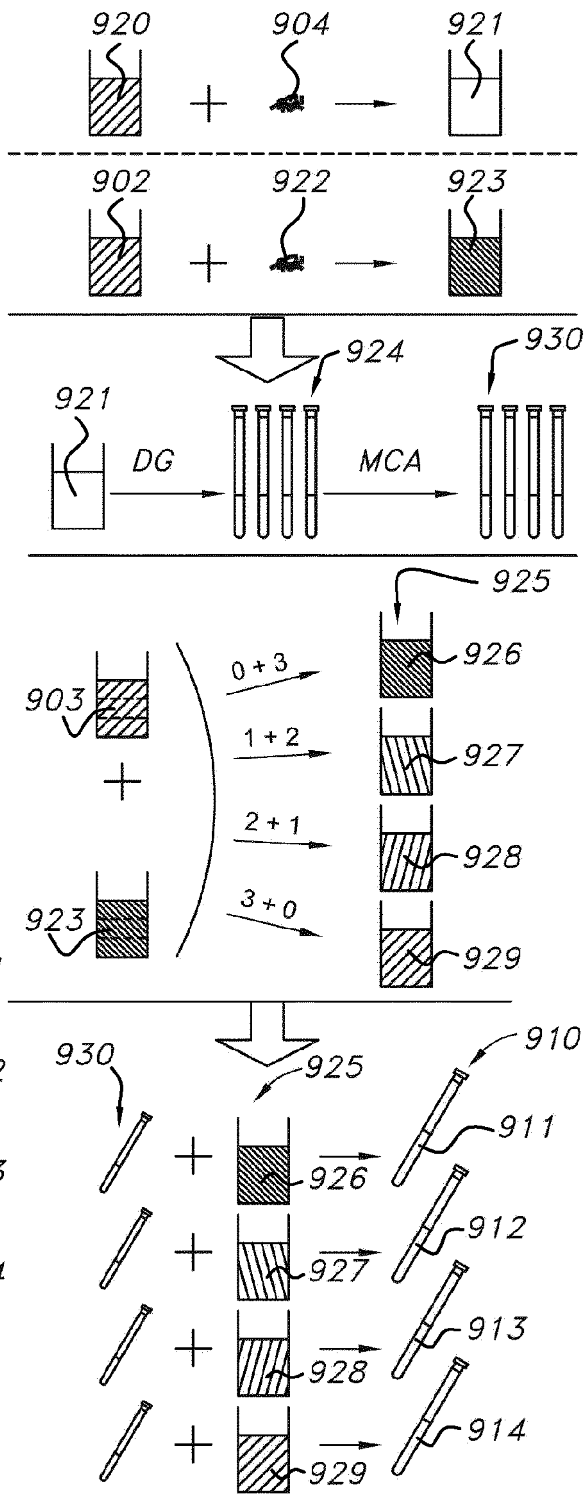

Fig. 23c

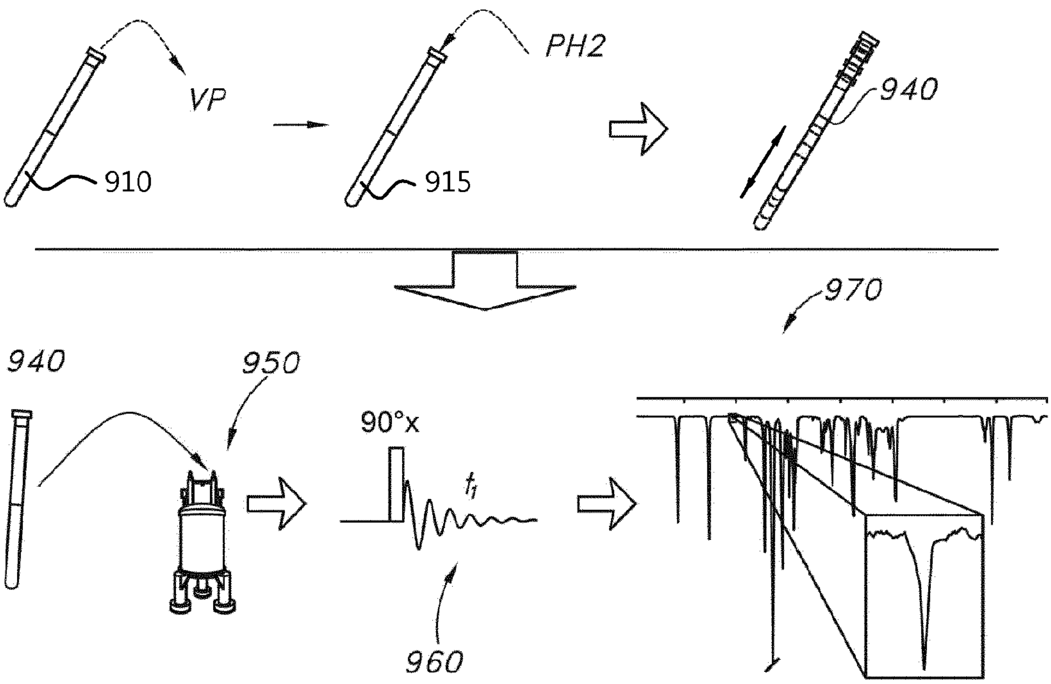

Fig. 24

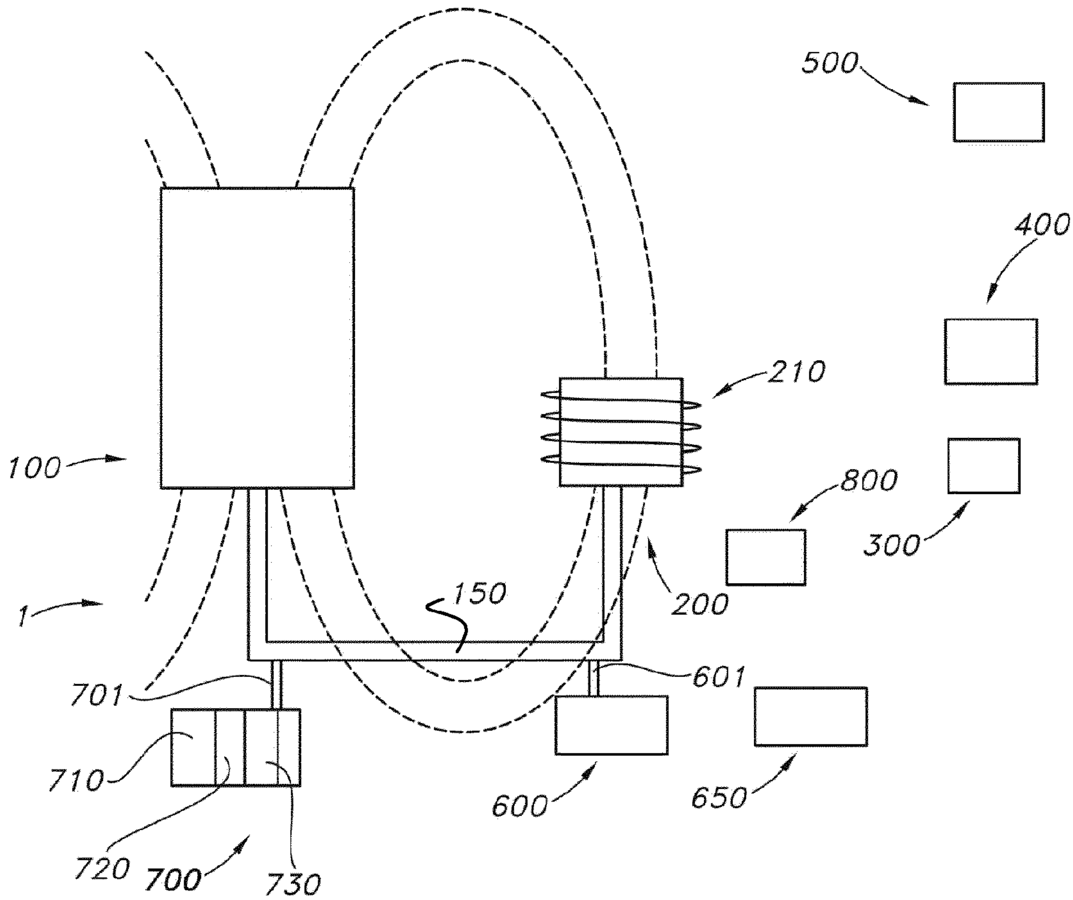

Fig. 25a

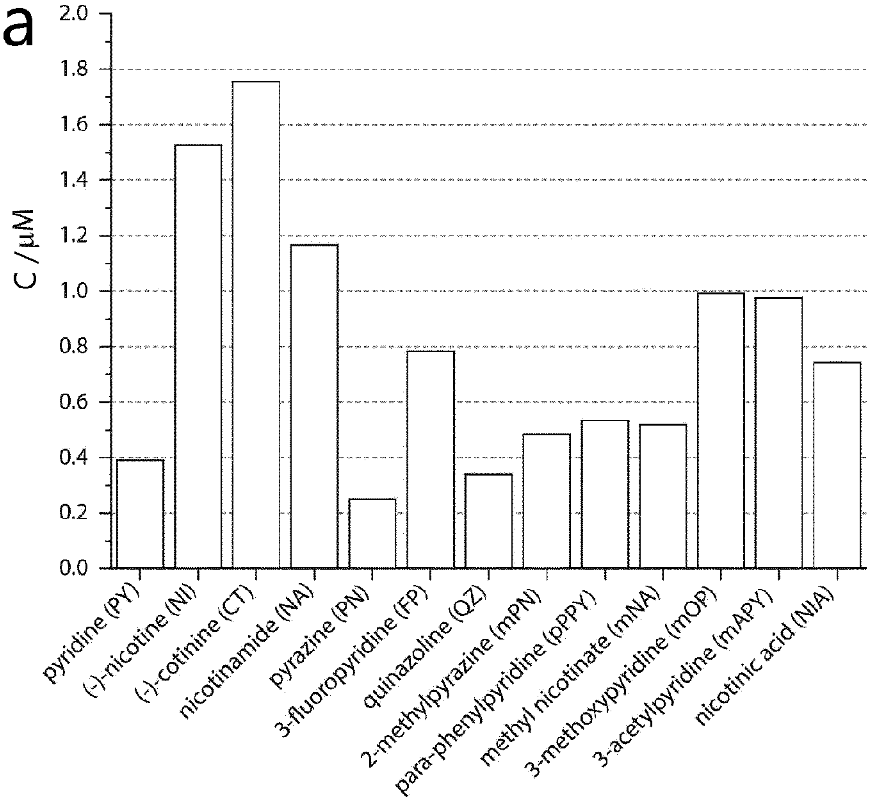


Fig. 25b

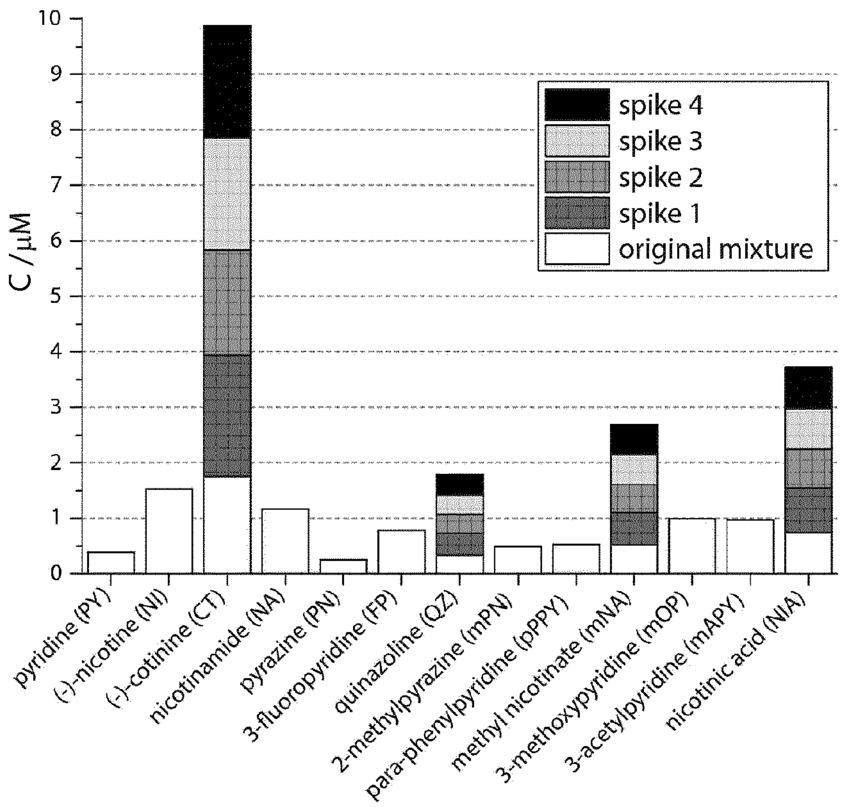

Fig. 26a

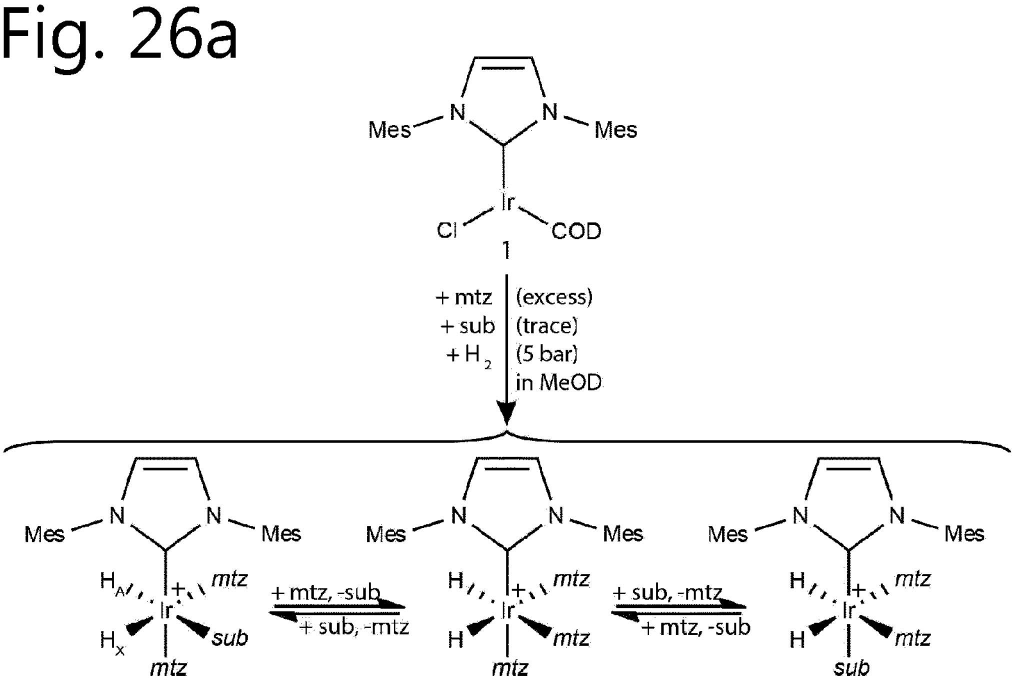


1

$4^+$ $9^+$ $8^+$

Fig. 26b

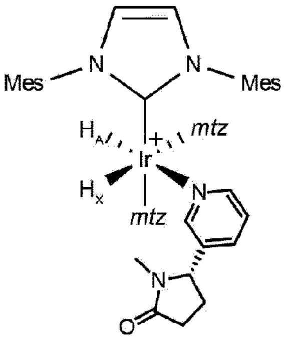

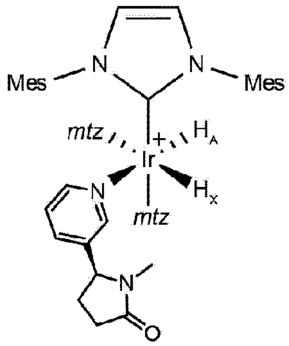

Fig. 27a

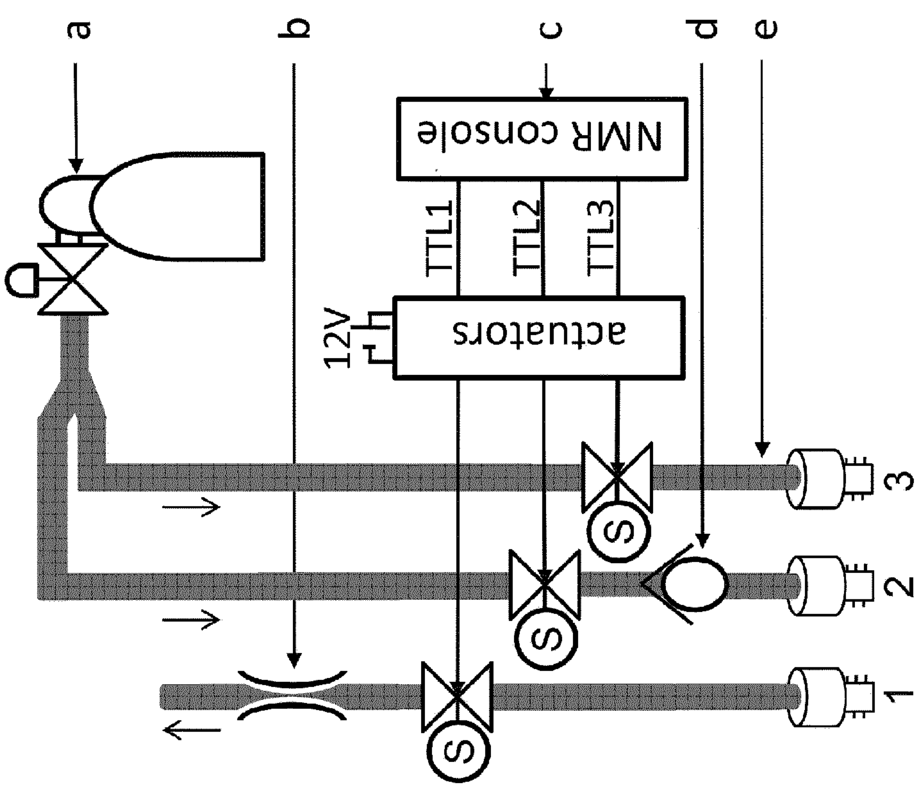


Fig. 27b

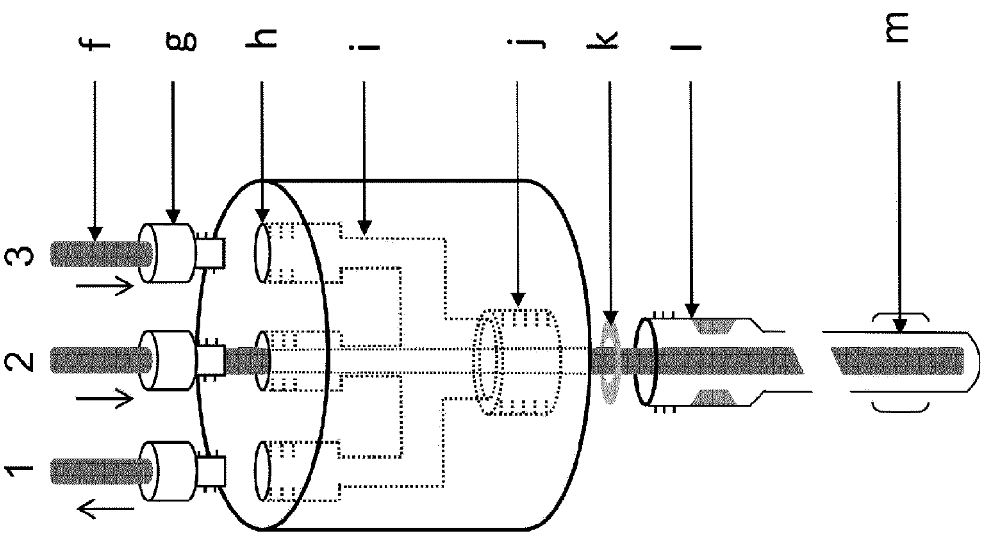

Fig. 28

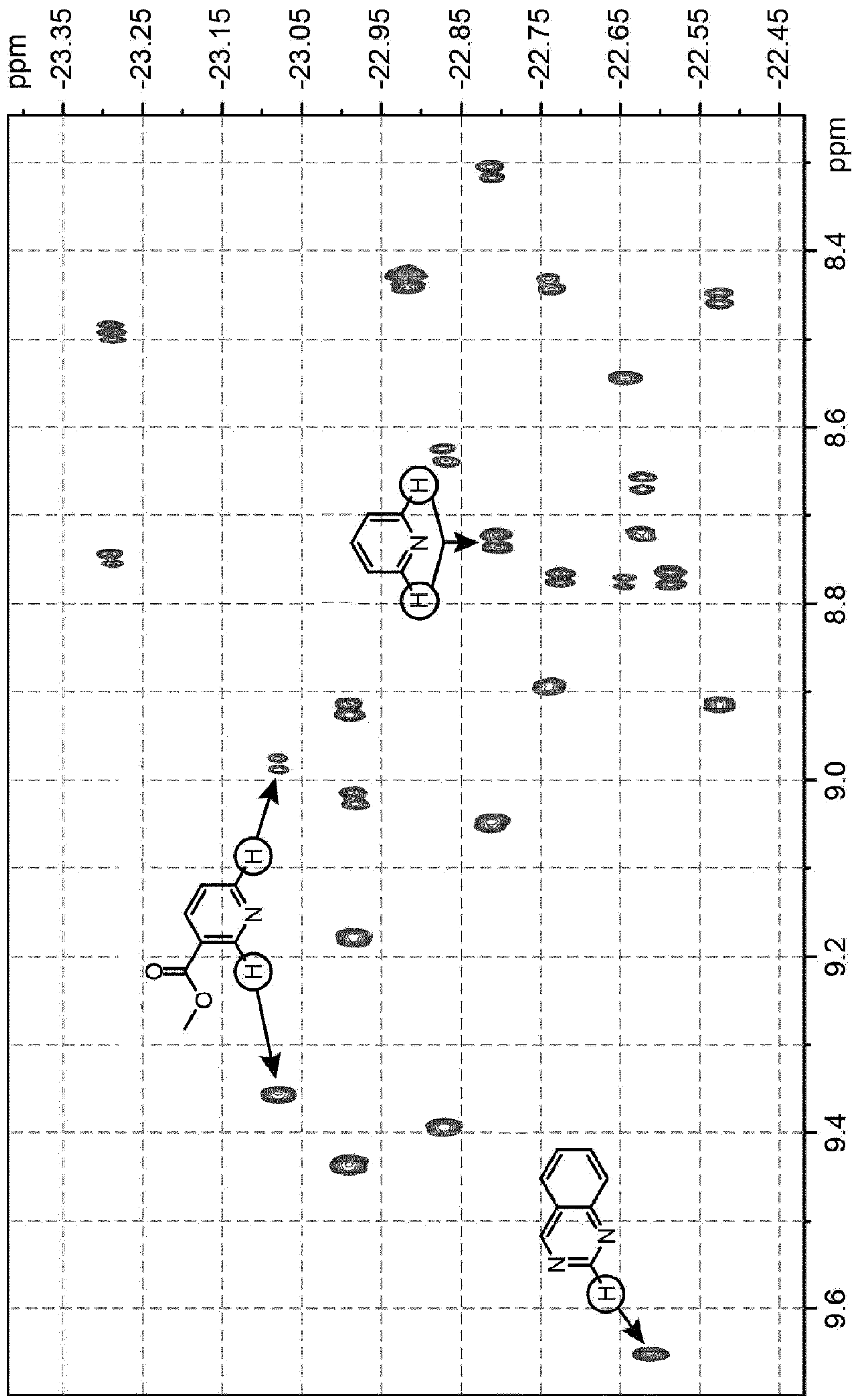
ppm
-23.35
-23.25
-23.15
-23.05
-22.95
-22.85
-22.75
-22.65
-22.55
-22.45
ppm
8.4
8.6
8.8
9.0
9.2
9.4
9.6

Fig. 29

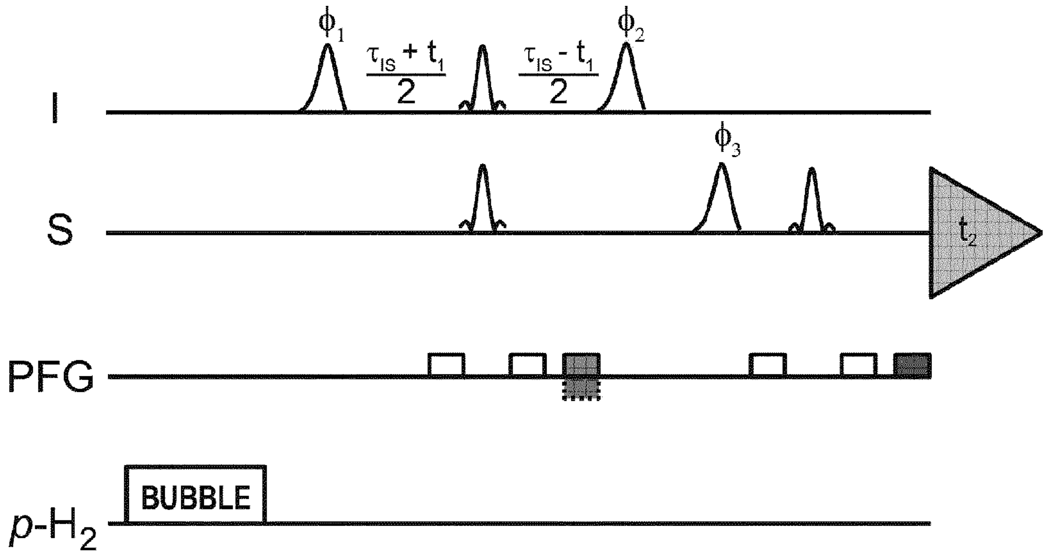


Fig. 30a

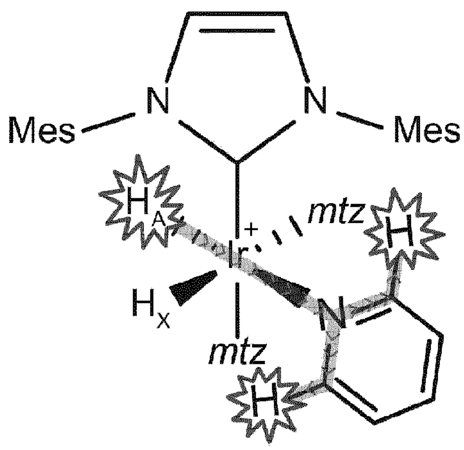

Fig. 30b

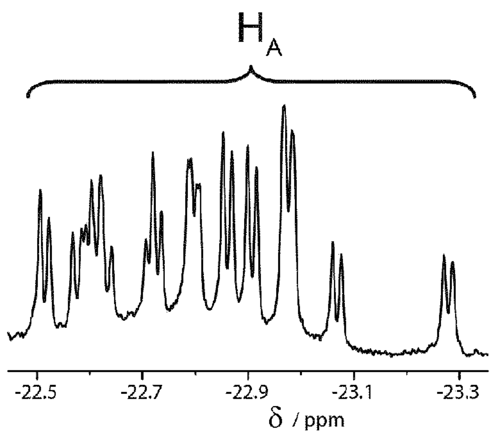

Fig. 31a

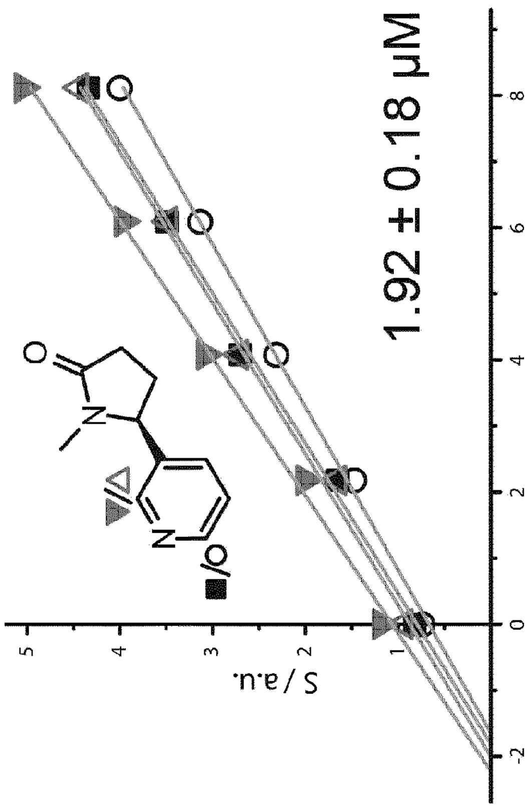


Fig. 31b

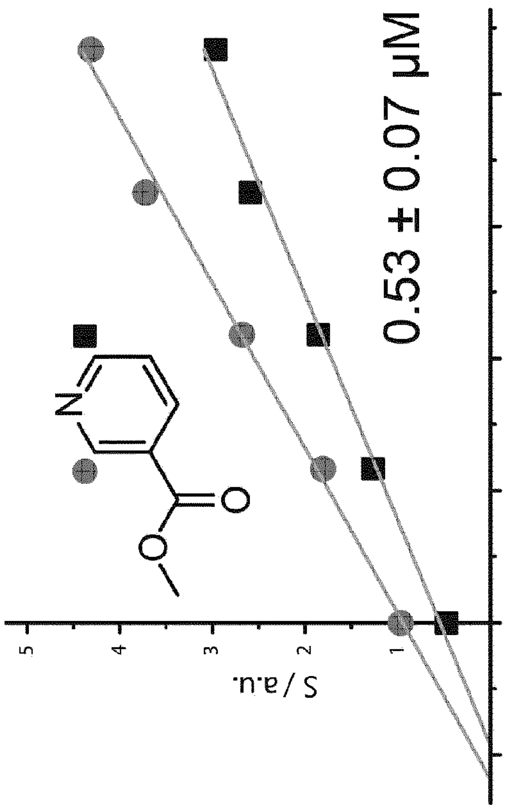

Fig. 31c

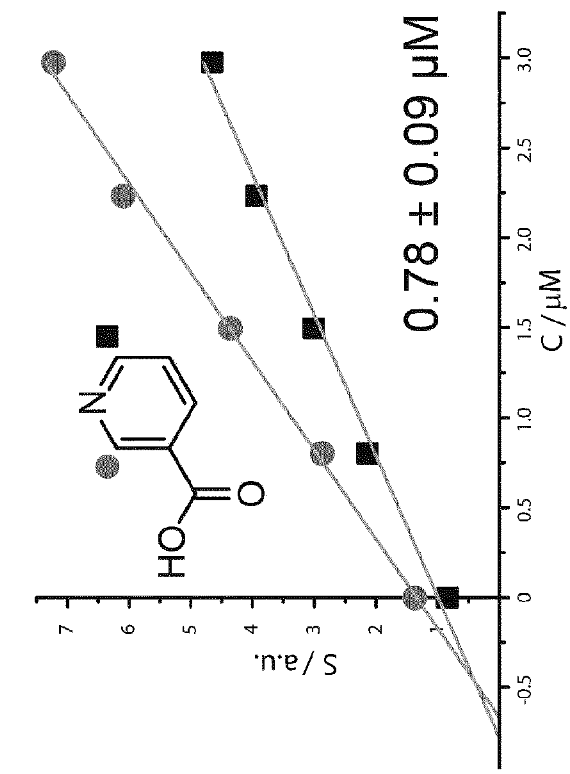


Fig. 31d

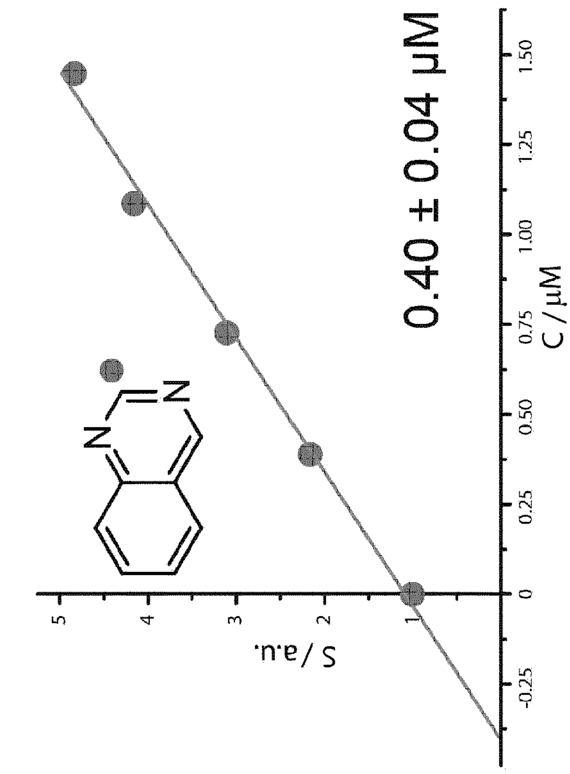

Fig. 32

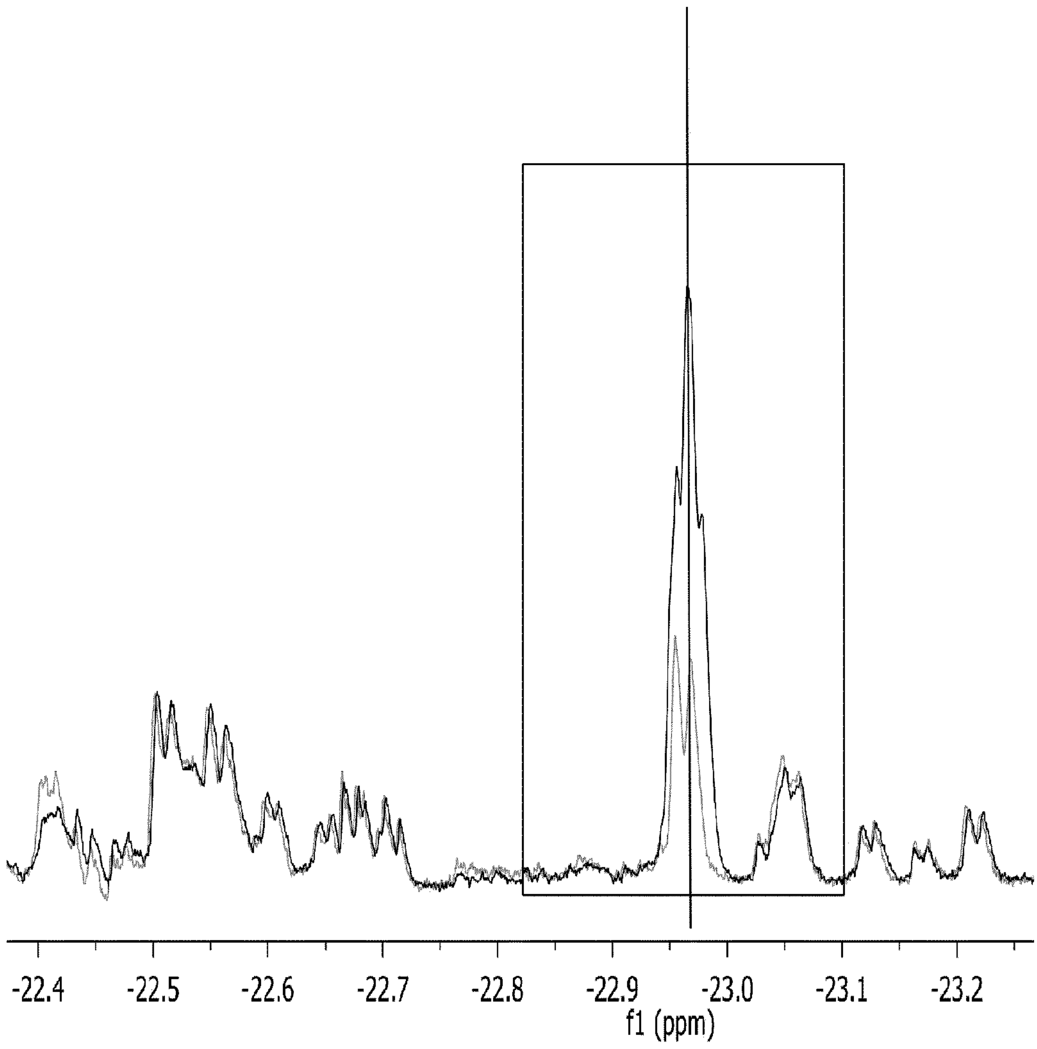

Fig. 33

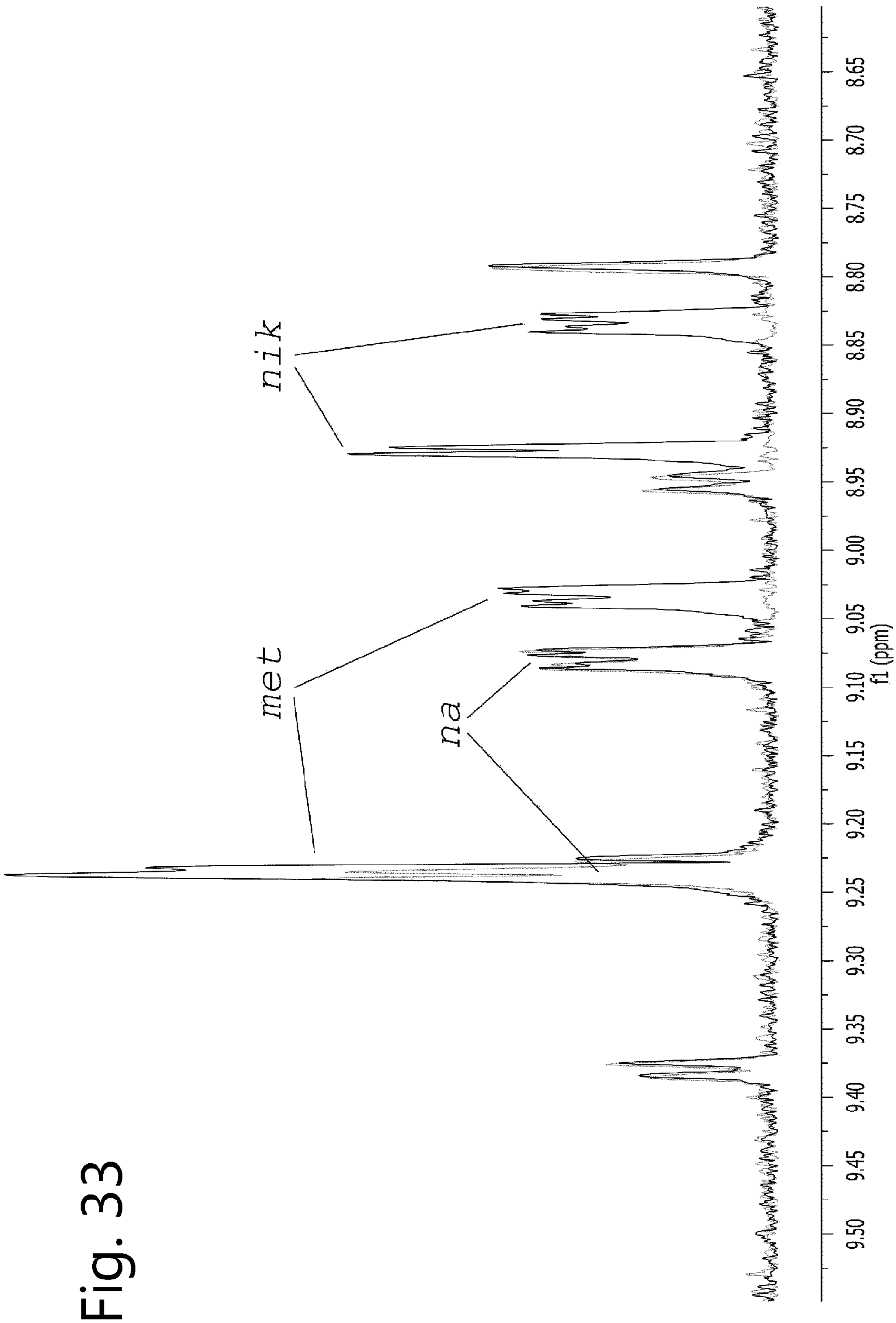
nik
met
na
9.50
9.45
9.40
9.35
9.30
9.25
9.20
9.15
9.10
9.05
9.00
8.95
8.90
8.85
8.80
8.75
8.70
8.65
f1 (ppm)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20130267036 A1
- WO 2008098104 A1, Seefelf, M. A.


### Non-patent literature cited in the description


- **RALPH W. ADAMS et al.** *Science,* 27 March 2009, vol. 323, 1708-1711
- **ESHUIS.** Towards Nanomolar Detection by NMR Through SABRE Hyperpolarization. *JACS,* 2014, vol. 36, 2695-2698
- **MEWIS et al.** Probing signal amplification by reversible exchange using an NMR flow system. *MRC,* 2014, vol. 52, 358-369
- **BHARTI ; ROY.** *Trends in Analytical Chemistry,* 2012, vol. 35, 5-26
- **WEVERS.** *In Clinical Chemistry,* vol. 45 (4), 539-548
- **KELLY III, R. A. et al.** *Organometallics,* 2007, vol. 27, 202
- **GLOGGLER et al.** *Chem. Chem. Phys.,* 2011, vol. 13, 13759
- **BOUATRA S ; AZIAT F ; MANDAL R ; GUO AC ; WILSON MR et al.** The Human Urine Metabolome. *PLoS ONE,* 2013, vol. 8 (9), e73076